(19) Europäisches Patentamt
European Patent Office
Office européen des brevets

(11) **EP 4 310 819 A1**

(12) **EUROPEAN PATENT APPLICATION**
published in accordance with Art. 153(4) EPC

(43) Date of publication:
**24.01.2024  Bulletin 2024/04**

(21) Application number: **22771475.5**

(22) Date of filing: **16.03.2022**

(51) International Patent Classification (IPC):
*G09F 9/00* (2006.01)     *G09F 9/30* (2006.01)
*H01Q 1/22* (2006.01)     *H01Q 1/38* (2006.01)
*H05K 1/02* (2006.01)     *H05K 3/38* (2006.01)

(52) Cooperative Patent Classification (CPC):
**G09F 9/00; G09F 9/30; H01Q 1/22; H01Q 1/38;
H05K 1/02; H05K 3/38**

(86) International application number:
**PCT/JP2022/011956**

(87) International publication number:
**WO 2022/196730 (22.09.2022 Gazette 2022/38)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **16.03.2021  JP 2021042603
31.03.2021  JP 2021060682
31.03.2021  JP 2021060701
15.03.2022  JP 2022040757**

(71) Applicant: **Dai Nippon Printing Co., Ltd.
Tokyo 162-8001 (JP)**

(72) Inventors:
• **KINOSHITA, Kazuki
Tokyo 162-8001 (JP)**

• **HOSODA, Shotaro
Tokyo 162-8001 (JP)**
• **IIOKA, Hidetoshi
Tokyo 162-8001 (JP)**
• **IIMURA, Keita
Tokyo 162-8001 (JP)**
• **KAWAGUCHI, Shuji
Tokyo 162-8001 (JP)**
• **SAKAKI, Masashi
Tokyo 162-8001 (JP)**
• **TAKE, Seiji
Tokyo 162-8001 (JP)**

(74) Representative: **Müller-Boré & Partner
Patentanwälte PartG mbB
Friedenheimer Brücke 21
80639 München (DE)**

(54) **WIRING BOARD, METHOD FOR MANUFACTURING WIRING BOARD, LAMINATE FOR IMAGE DISPLAY DEVICE, AND IMAGE DISPLAY DEVICE**

(57)     A wiring board includes a substrate that has transparency, a primer layer provided on the substrate, and a mesh wiring layer that is disposed on the primer layer and that includes a plurality of first-direction wiring lines and a plurality of second-direction wiring lines that interconnect the plurality of first-direction wiring lines. The primer layer includes a polymer material. At intersections of the first-direction wiring lines and the second-direction wiring lines, at least one corner portion of four corner portions formed between the first-direction wiring lines and the second-direction wiring lines is rounded in plan view.

EP 4 310 819 A1

FIG. 5A

## Description

Technical Field

An embodiment according to the present disclosure relates to a wiring board, a method for manufacturing wiring board, a laminate for an image display device, and the image display device.

Background Art

Increased performance, reduction in size, reduction in thickness, and reduction in weight is currently advancing for mobile terminal equipment, such as smartphones, tablets, and so forth. Such mobile terminal equipment uses a plurality of communication bands, and accordingly require a plurality of antennas in accordance with the communication bands. For example, mobile terminal equipment is equipped with a plurality of antennas, such as an antenna for telephone, an antenna for WiFi (Wireless Fidelity), an antenna for 3G (Generation), an antenna for 4G (Generation), an antenna for LTE (Long Term Evolution), an antenna for Bluetooth (registered trademark), an antenna for NFC (Near Field Communication), and so forth. However, due to reduction in size of mobile terminal equipment, space for installing antennas is limited, and the degree in freedom for antenna design is becoming narrower. Also, antennas are built into limited space, and accordingly radio wave sensitivity is not necessarily satisfactory.

Film antennas that can be installed in display regions of mobile terminal equipment have been developed. In a transparent antenna in which an antenna pattern is formed on a transparent base material, the antenna pattern of these film antennas is formed of a conductor portion serving as a formation portion of a non-transparent conductor layer, and a conductor mesh layer that is mesh-like, with a great number of openings serving as a non-formation portion.

Citation List

Patent Literature

Patent Literature 1: Japanese Unexamined Patent Application Publication No. 2011-66610

Patent Literature 2: Japanese Patent No. 5636735

Patent Literature 3: Japanese Patent No. 5695947

Now, a conductive mesh layer is formed on a transparent base material in conventional film antennas, for example, and there is a possibility that adhesion between the transparent base material and the conductive mesh layer will deteriorate. Accordingly, there is demand for improved adhesion between the transparent base material and the conductive mesh layer.

Also, in mobile terminal equipment or the like equipped with a film antenna, there is a possibility of interference between a cycle of the conductive mesh layer and a cycle of the pixels, and moire (streaks of light and dark) occurs. When such moire occurs, visual recognition of images may deteriorate in the mobile terminal equipment or the like.

An object of the present embodiment is to provide a wiring board and a method for manufacturing the wiring board, in which adhesion between the substrate and wiring lines can be improved.

Also, an object of the present embodiment is to provide a laminate for an image display device and the image display device, in which presence of a wiring board that is present in the image display device is more difficult to visually recognize.

Further, an object of the present embodiment is to provide an image display device and a method for a manufacturing wiring board in which moire can be suppressed from being generated.

Summary of Invention

A wiring board according to an aspect of the present disclosure includes a substrate that has transparency, a primer layer provided on the substrate, and a mesh wiring layer that is disposed on the primer layer and that includes a plurality of first-direction wiring lines and a plurality of second-direction wiring lines that interconnect the plurality of first-direction wiring lines. The primer layer includes a polymer material, and at intersections of the first-direction wiring lines and the second-direction wiring lines, at least one corner portion of four corner portions formed between the first-direction wiring lines and the second-direction wiring lines is rounded in plan view.

In the wiring board according to an aspect of the present disclosure, an angle formed between a center line of each of the first-direction wiring lines and a center line of each of the second-direction wiring lines that form the corner portion that is rounded in plan view may be an acute angle in plan view.

In the wiring board according to an aspect of the present disclosure, a thickness of the primer layer may be 0.05 $\mu$m or more and 0.5 $\mu$m or less.

In the wiring board according to an aspect of the present disclosure, the primer layer may include an acrylic-based resin or a polyester-based resin.

In the wiring board according to an aspect of the present disclosure, the polymer material may be cross-linked.

The wiring board according to an aspect of the present disclosure may further include a dummy wiring layer that is disposed around the mesh wiring layer and that includes a plurality of dummy wiring lines that are electrically independent from the first-direction wiring lines.

In the wiring board according to an aspect of the present disclosure, the wiring board may have radio wave transmission/reception functions.

In the wiring board according to an aspect of the present disclosure, the wiring board may have millimeter wave transmission/reception functions, and the mesh wiring layer may be configured as an array antenna.

A method for manufacturing a wiring board according to an aspect of the present disclosure includes a step of preparing a substrate that has transparency, a step of forming a primer layer on the substrate, and a step of forming, on the primer layer, a mesh wiring layer that includes a plurality of first-direction wiring lines and a plurality of second-direction wiring lines that interconnect the plurality of first-direction wiring lines. The primer layer includes a polymer material, and at least one corner portion of four corner portions formed between the first-direction wiring lines and the second-direction wiring lines is rounded in plan view.

In the method for manufacturing the wiring board according to an aspect of the present disclosure, a dummy wiring layer that is disposed around the mesh wiring layer and that includes a plurality of dummy wiring lines that are electrically independent from the first-direction wiring lines, may be formed on the primer layer in the step of forming the mesh wiring layer.

An image display device laminate according to an aspect of the present disclosure includes a wiring board that includes a substrate that has transparency and a mesh wiring layer that is disposed on the substrate, a first transparent adhesive layer that has an area that is broader than the substrate, and a second transparent adhesive layer that has an area that is broader than the substrate. A partial region of the substrate is disposed in a partial region between the first transparent adhesive layer and the second transparent adhesive layer, a difference in refractive index between the substrate and the first transparent adhesive layer is 0.1 or less, a difference in refractive index between the second transparent adhesive layer and the substrate is 0.1 or less, and a difference in refractive index between the first transparent adhesive layer and the second transparent adhesive layer is 0.1 or less.

In the image display device laminate according to an aspect of the present disclosure, at least one of a thickness of the first transparent adhesive layer and a thickness of the second transparent adhesive layer may be 2 times a thickness of the substrate or more.

In the image display device laminate according to an aspect of the present disclosure, the thickness of the first transparent adhesive layer and the thickness of the second transparent adhesive layer may be the same as each other, and the thickness of the first transparent adhesive layer and the thickness of the second transparent adhesive layer may be 1.5 times the thickness of the substrate or more.

In the image display device laminate according to an aspect of the present disclosure, a material of the first transparent adhesive layer and a material of the second transparent adhesive layer may be the same as each other.

In the image display device laminate according to an aspect of the present disclosure, the material of the first transparent adhesive layer and the material of the second transparent adhesive layer may each be an acrylic-based resin.

In the image display device laminate according to an aspect of the present disclosure, the thickness of the substrate may be 50 $\mu$m or less.

In the image display device laminate according to an aspect of the present disclosure, a dummy wiring layer that is electrically independent from the mesh wiring layer may be provided around the mesh wiring layer.

In the image display device laminate according to an aspect of the present disclosure, a plurality of dummy wiring layers that are electrically independent from the mesh wiring layer may be provided around the mesh wiring layer, and the plurality of dummy wiring layers may have different aperture ratios from each other.

An image display device laminate according to an aspect of the present disclosure includes a wiring board that includes a substrate that has transparency, a mesh wiring layer that is disposed on the substrate, and a protective layer that covers the mesh wiring layer, a first dielectric layer, and a second dielectric layer. A partial region of the wiring board is disposed in a partial region between the first dielectric layer and the second dielectric layer. With a transmittance of visible light rays of the image display device laminate in a region in which the wiring board, the first dielectric layer, and the second dielectric layer are present as a first transmittance, and with a transmittance of visible light rays of the image display device laminate in a region in which the first dielectric layer and the second dielectric layer are present and the wiring board is not present as a second transmittance, the first transmittance is 83% or more and 90% or less, and a difference between the first transmittance and the second transmittance is 1.5% or less.

An image display device laminate according to an aspect of the present disclosure includes a wiring board that includes a substrate that has transparency, a mesh wiring layer that is disposed on the substrate, and a protective layer that covers the mesh wiring layer, a first dielectric layer, and a second dielectric layer. A partial region of the wiring board is disposed in a partial region between the first dielectric layer and the second dielectric layer. With a haze value of the image display device laminate in a region in which the wiring board, the first dielectric layer, and the second dielectric layer are present as a first haze value, and with a haze value of the image display device laminate in a region in which the first dielectric layer and the second dielectric layer are present and the wiring board is not present as a second haze value, the first haze value is 0.5% or more and 2% or less, and a difference between the first haze value and the second haze value is 0.5% or less.

An image display device laminate according to an aspect of the present disclosure includes a wiring board that includes a substrate that has transparency, a mesh wiring layer that is disposed on the substrate, and a protective layer that covers the mesh wiring layer, a first dielectric layer, and a second dielectric layer. A partial region of the wiring board is disposed in a partial region between the first dielectric layer and the second dielectric layer. With a diffuse light reflectance of the image display device laminate measured in conformance with JIS Z 8722 in a region in which the wiring board, the first dielectric layer, and the second dielectric layer are present as a first diffuse light reflectance, and with a diffuse light reflectance of the image display device laminate measured in conformance with JIS Z 8722 in a region in which the first dielectric layer and the second dielectric layer are present and the wiring board is not present as a second diffuse light reflectance, the first diffuse light reflectance is 0.05% or more and 1% or less, and a difference between the first diffuse light reflectance and the second diffuse light reflectance is 1.5% or less.

In the image display device laminate according to an aspect of the present disclosure, a dielectric loss tangent of the substrate may be 0.002 or less.

In the image display device laminate according to an aspect of the present disclosure, following performing work of bending the image display device laminate 180° following a perimeter of a cylinder that is 1 mm in diameter and then straightening out, for 100 times, an amount of increase in resistance value of the mesh wiring layer may be 20% or less.

In the image display device laminate according to an aspect of the present disclosure, the mesh wiring layer may function as a millimeter wave antenna.

In the image display device laminate according to an aspect of the present disclosure, the mesh wiring layer may be configured as an array antenna.

An image display device according to an aspect of the present disclosure includes the image display device laminate according to an aspect of the present disclosure, and a display device that is laminated on the image display device laminate.

In the image display device according to an aspect of the present disclosure, the mesh wiring layer may include a plurality of wiring lines, and the mesh wiring layer may be made up of a predetermined unit pattern that is repetitively arrayed in a first direction and in a second direction that is different from the first direction, the display device may have a plurality of pixels that are repetitively arrayed in the first direction and in the second direction, a pitch of the unit pattern in the first direction may be (N - 0.05) times (where N is a natural number) a pitch of the pixels in the first direction or less, or may be (N + 0.05) times the pitch of the pixels in the first direction or more, and a pitch of the unit pattern in the second direction may be (M - 0.05) times (where M is a natural number) a pitch of the pixels in the second direction or less, or may be (M + 0.05) times the pitch of the pixels in the second direction or more.

An image display device according to an aspect of the present disclosure includes a wiring board that includes a substrate that has transparency and a mesh wiring layer that is disposed on the substrate and includes a plurality of wiring lines, and a display device that is laminated on the wiring board. The mesh wiring layer is made up of a predetermined unit pattern that is repetitively arrayed in a first direction and in a second direction that is different from the first direction, the display device has a plurality of pixels that are repetitively arrayed in the first direction and in the second direction, a pitch of the unit pattern in the first direction is (N - 0.05) times (where N is a natural number) a pitch of the pixels in the first direction or less, or is (N + 0.05) times the pitch of the pixels in the first direction or more, and a pitch of the unit pattern in the second direction is (M - 0.05) times (where M is a natural number) a pitch of the pixels in the second direction or less, or is (M + 0.05) times the pitch of the pixels in the second direction or more.

In the image display device according to an aspect of the present disclosure, the pitch of the unit pattern in the first direction may be (N - 0.2) times the pitch of the pixels in the first direction or more, or may be (N + 0.2) times the pitch of the pixels in the first direction or less.

In the image display device according to an aspect of the present disclosure, the pitch of the unit pattern in the second direction may be (M - 0.2) times the pitch of the pixels in the second direction or more, or may be (M + 0.2) times the pitch of the pixels in the second direction or less.

In the image display device according to an aspect of the present disclosure, N and M may each be a natural number of 1 or more and 6 or less.

In the image display device according to an aspect of the present disclosure, a line width of the wiring lines may be 5 μm or less.

In the image display device according to an aspect of the present disclosure, the line width of the wiring lines may be 2 μm or less.

In the image display device according to an aspect of the present disclosure, an aperture ratio of the mesh wiring layer may be 95% or more.

In the image display device according to an aspect of the present disclosure, a sheet resistance value of the mesh wiring layer may be 4 ohms per square or less, and a longest width of each of the wiring lines as viewed from a 120° viewing angle may be 3 μm or less.

In the image display device according to an aspect of the present disclosure, the unit pattern may include a first-direction wiring line and a second-direction wiring line that extend in different directions from each other, and an angle formed by the first-direction wiring line and the second-direction wiring line may be 30° or more and 150° or less.

In the image display device according to an aspect of the present disclosure, the wiring board may have millimeter wave transmission/reception functions, and the mesh wiring layer may be configured as an array antenna.

A method for manufacturing a wiring board according to an aspect of the present disclosure includes a step of deciding a pitch of pixels of a display device that is laminated on the wiring board, a step of preparing a substrate that has transparency, and a step of forming a mesh wiring layer on the substrate, on the basis of the pitch of the pixels. The mesh wiring layer is made up of a predetermined unit pattern that is repetitively arrayed in a first direction and in a second direction that is different from the first direction, a pitch of the unit pattern in the first direction is (N - 0.05) times (where N is a natural number) a pitch of the pixels in the first direction or less, or is (N + 0.05) times the pitch of the pixels in the first direction or more, and a pitch of the unit pattern in the second direction is (M - 0.05) times (where M is a natural number) a pitch of the pixels in the second direction or less, or is (M + 0.05) times the pitch of the pixels in the second direction or more.

According to an embodiment of the present disclosure, adhesion between the substrate and wiring lines can be improved.

Also, according to an embodiment of the present disclosure, presence of a wiring board that is present in an image display device can be made to be more difficult to visually recognize.

Further, according to an embodiment of the present disclosure, moire can be suppressed from being generated in an image display device.

Brief Description of Drawings

[Fig. 1] Fig. 1 is a plan view illustrating a wiring board according to a first embodiment.

[Fig. 2] Fig. 2 is an enlarged plan view (enlarged view of portion II in Fig. 1) illustrating the wiring board according to the first embodiment.

[Fig. 3] Fig. 3 is a cross-sectional view (cross-sectional view along line III-III in Fig. 2) illustrating the wiring board according to the first embodiment.

[Fig. 4] Fig. 4 is a cross-sectional view (cross-sectional view along line IV-IV in Fig. 2) illustrating the wiring board according to the first embodiment.

[Fig. 5A] Fig. 5A is an enlarged plan view illustrating the wiring board according to the first embodiment.

[Fig. 5B] Fig. 5B is an enlarged plan view illustrating the wiring board according to the first embodiment.

[Fig. 6A] Fig. 6A is a cross-sectional view illustrating a method for manufacturing the wiring board according to the first embodiment.

[Fig. 6B] Fig. 6B is a cross-sectional view illustrating the method for manufacturing the wiring board according to the first embodiment.

[Fig. 6C] Fig. 6C is a cross-sectional view illustrating the method for manufacturing the wiring board according to the first embodiment.

[Fig. 6D] Fig. 6D is a cross-sectional view illustrating the method for manufacturing the wiring board according to the first embodiment.

[Fig. 6E] Fig. 6E is a cross-sectional view illustrating the method for manufacturing the wiring board according to the first embodiment.

[Fig. 6F] Fig. 6F is a cross-sectional view illustrating the method for manufacturing the wiring board according to the first embodiment.

[Fig. 7] Fig. 7 is a plan view illustrating an image display device according to the first embodiment.

[Fig. 8] Fig. 8 is a plan view illustrating a wiring board according to a modification of the first embodiment.

[Fig. 9] Fig. 9 is a plan view illustrating an image display device according to a first implementation mode of a second embodiment.

[Fig. 10] Fig. 10 is a cross-sectional view (cross-sectional view along line X-X in Fig. 9) illustrating the image display device according to the first implementation mode of the second embodiment.

[Fig. 11] Fig. 11 is a plan view illustrating a wiring board.

[Fig. 12] Fig. 12 is an enlarged plan view illustrating a mesh wiring layer of the wiring board.

[Fig. 13] Fig. 13 is a cross-sectional view (cross-sectional view along line XIII-XIII in Fig. 12) illustrating the wiring board.

[Fig. 14] Fig. 14 is a cross-sectional view (cross-sectional view along line XIV-XIV in Fig. 12) illustrating the wiring board.

[Fig. 15A] Fig. 15A is a cross-sectional view illustrating a method for manufacturing the wiring board according to the first implementation mode of the second embodiment.

[Fig. 15B] Fig. 15B is a cross-sectional view illustrating the method for manufacturing the wiring board according to the first implementation mode of the second embodiment.

[Fig. 15C] Fig. 15C is a cross-sectional view illustrating the method for manufacturing the wiring board according to the first implementation mode of the second embodiment.

[Fig. 15D] Fig. 15D is a cross-sectional view illustrating the method for manufacturing the wiring board according to the first implementation mode of the second embodiment.

[Fig. 15E] Fig. 15E is a cross-sectional view illustrating the method for manufacturing the wiring board according to the first implementation mode of the second embodiment.

[Fig. 15F] Fig. 15F is a cross-sectional view illustrating the method for manufacturing the wiring board according to the first implementation mode of the second embodiment.

[Fig. 16] Fig. 16 is a plan view illustrating a wiring board according to a first modification of the first implementation mode of the second embodiment.

[Fig. 17] Fig. 17 is an enlarged plan view illustrating the wiring board according to the first modification of the first implementation mode of the second embodiment.

[Fig. 18] Fig. 18 is a plan view illustrating a wiring board according to a second modification of the first implementation mode of the second embodiment.

[Fig. 19] Fig. 19 is an enlarged plan view illustrating the wiring board according to the second modification of the first implementation mode of the second embodiment.

[Fig. 20] Fig. 20 is an enlarged plan view illustrating a mesh wiring layer of a wiring board according to a third modification of the first implementation mode of the second embodiment.

[Fig. 21] Fig. 21 is a plan view illustrating a wiring board according to a fourth modification of the first implementation mode of the second embodiment.

[Fig. 22] Fig. 22 is a cross-sectional view illustrating an image display device according to a second implementation mode of the second embodiment.

[Fig. 23] Fig. 23 is a plan view illustrating an image display device according to a third embodiment.

[Fig. 24] Fig. 24 is a cross-sectional view (cross-sectional view along line XXIV-XXIV in Fig. 23) illustrating the image display device according to the third embodiment.

[Fig. 25] Fig. 25 is a diagram illustrating a cross-sectional configuration of the image display device according to the third embodiment.

[Fig. 26] Fig. 26 is a plan view illustrating pixels of a display device.

[Fig. 27] Fig. 27 is a plan view illustrating a wiring board.

[Fig. 28] Fig. 28 is an enlarged plan view illustrating a mesh wiring layer of the wiring board.

[Fig. 29] Fig. 29 is a cross-sectional view (cross-sectional view along line XXIX-XXIX in Fig. 28) illustrating the wiring board.

[Fig. 30] Fig. 30 is a cross-sectional view (cross-sectional view along line XXX-XXX in Fig. 28) illustrating the wiring board.

[Fig. 31] Fig. 31 is a perspective view illustrating the mesh wiring layer of the wiring board.

[Fig. 32] Fig. 32 is a cross-sectional view illustrating a first-direction wiring line and a second-direction wiring line of the wiring board.

[Fig. 33A] Fig. 33A is a cross-sectional view illustrating a method for manufacturing the wiring board according to the third embodiment.

[Fig. 33B] Fig. 33B is a cross-sectional view illustrating the method for manufacturing the wiring board according to the third embodiment.

[Fig. 33C] Fig. 33C is a cross-sectional view illustrating the method for manufacturing the wiring board according to the third embodiment.

[Fig. 33D] Fig. 33D is a cross-sectional view illustrating the method for manufacturing the wiring board according to the third embodiment.

[Fig. 33E] Fig. 33E is a cross-sectional view illustrating the method for manufacturing the wiring board according to the third embodiment.

[Fig. 33F] Fig. 33F is a cross-sectional view illustrating the method for manufacturing the wiring board according to the third embodiment.

[Fig. 33G] Fig. 33G is a cross-sectional view illustrating the method for manufacturing the wiring board according to the third embodiment.

[Fig. 34] Fig. 34 is a diagram illustrating a cross-sectional configuration of an image display device according to a modification of the third embodiment.

[Fig. 35] Fig. 35 is an enlarged plan view illustrating a mesh wiring layer of a wiring board according to a modification of the third embodiment.

[Fig. 36] Fig. 36 is a plan view illustrating a wiring board according to a modification of the third embodiment.

Description of Embodiments

(First Embodiment)

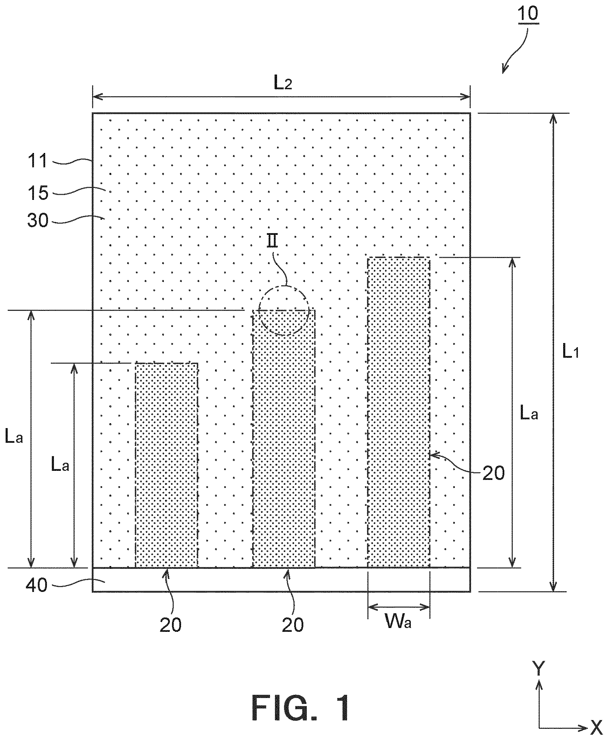

First, a first embodiment will be described by way of Fig. 1 to Fig. 7. Fig. 1 to Fig. 7 are diagrams illustrating the first embodiment.

The diagrams described below are schematically illustrated diagrams. Accordingly, sizes and shapes of each of the portions are exaggerated as appropriate, in order to facilitate understanding. Also, implementation can be carried out modified as appropriate without departing from the technical spirit. Note that in the diagrams described below, parts that are the same are denoted by the same signs, and detailed description may be partly omitted. Also, numerical values such as dimensions and names of materials of the members described in the present specification are exemplary as embodiments, and can be selected as appropriate and used without being limited thereto. In the present specification, terms that identify shapes or geometrical conditions, such as for example, the terms parallel, orthogonal, perpendicular, and so forth, can be interpreted including, in addition to strict meanings thereof, states that are substantially the same.

In the first embodiment, "X direction" is a direction that is perpendicular to a longitudinal direction of a mesh wiring layer, and is a direction that is perpendicular to a lengthwise direction corresponding to a frequency band of first-direction wiring lines. "Y direction" is a direction that is perpendicular to the X direction and also that is parallel to the longitudinal direction of the mesh wiring layer, and is a direction that is parallel to the lengthwise direction corresponding to the frequency band of the first-direction wiring lines. "Z direction" is a direction that is perpendicular to both the X direction and the Y direction, and that is parallel to a thickness direction of a wiring board. Also, a "front face" is a face on a plus side in the Z direction, and is a face on which the first-direction wiring lines are provided on the substrate. Also, a "rear face" is a face on a minus side in the Z direction, and is a face opposite to the face on which the first-direction wiring lines are provided on the substrate. Note that in the present embodiment, an example will be described in which a mesh wiring layer 20 is a mesh wiring layer having radio wave transmission/reception functions (functions as an antenna), but the mesh wiring layer 20 does not have to have such radio wave transmission/reception functions (functions as an antenna).

[Configuration of Wiring Board]

A configuration of the wiring board according to the present embodiment will be described with reference to Fig. 1 to Fig. 5B. Fig. 1 to Fig. 5B are diagrams illustrating the wiring board according to the present embodiment.

As illustrated in Fig. 1, a wiring board 10 according to the present embodiment is to be disposed on a display of an image display device, for example. Such a wiring board 10 includes a substrate 11 that has transparency, a primer layer 15 disposed on the substrate 11, and the mesh wiring layer 20 disposed on the primer layer 15. Out of these, a power supply unit 40 is electrically connected to the mesh wiring layer 20. Also, the wiring board 10 further includes a dummy wiring layer 30 that is disposed on the primer layer 15, around the mesh wiring layer 20. First, the substrate 11 will be described here.

The substrate 11 has a generally rectangular shape in plan view, with a longitudinal direction thereof being parallel to the Y direction, and a lateral direction thereof being parallel to the X direction. The substrate 11 has transparency and also has a generally plate-like shape, and a thickness thereof is generally uniform overall. A length $L_1$ of the substrate 11 in the longitudinal direction (Y direction) can be selected from a range of 2 mm or more and 300 mm or less, for example, and may be selected from a range of 10 mm or more and 200 mm or less. Also, the length $L_1$ of the substrate 11 in the longitudinal direction (Y direction) can be selected from a range of 20 mm or more and 500 mm or less, for example, and may be selected from a range of 100 mm or more and 200 mm or less. A length $L_2$ of the substrate 11 in the lateral direction (X direction) can be selected from a range of 2 mm or more and 300 mm or less, for example, and may be selected from a range of 3 mm or more and 100 mm or less. Also, the length $L_2$ of the substrate 11 in the lateral direction (X direction) can be selected from a range of 20 mm or more and 500 mm or less, for example, and may be selected from a range of 50 mm or more and 100 mm or less. Note that corner portions of the substrate 11 may each be rounded.

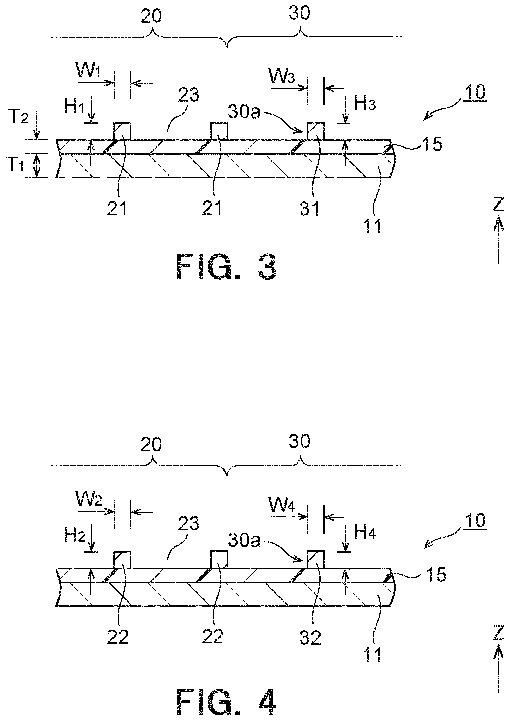

It is sufficient for material of the substrate 11 to be a material that has transparency in the visible light domain, and electrical insulating properties. Although the material for the substrate 11 is polyethylene terephthalate in the present embodiment, this is not restrictive. A polyester-based resin such as polyethylene terephthalate or the like, an acrylic-based resin such as polymethyl methacrylate, a polycarbonate-based resin, a polyimide-based resin, or a polyolefin-based resin such as a cycloolefin polymer, a cellulose-based resin such as triacetyl cellulose or the like, a fluororesin material such as PTFE, PFA, and so forth, and like organic insulating materials, for example, is preferably used as the material of the substrate 11. Also, depending on the usage, glass, ceramics, and so forth can be selected as appropriate as the material of the substrate 11. Note that an example is illustrated in which the substrate 11 is made up of a single layer, but this is not restrictive, and a structure may be made in which a plurality of base materials or layers are laminated. Also, the substrate 11 may be film-like or may be plate-like. Accordingly, there is no limit in particular for the thickness of the substrate 11, and selection can be made as appropriate in accordance with the usage, but in one example a thickness $T_1$ (length in Z direction, see Fig. 3) of the substrate 11 may be a range of 10 $\mu$m or more and 200 $\mu$m or less, for example.

The dielectric loss tangent of the substrate 11 may be 0.002 or less, and preferably is 0.001 or less. Note that while there is no particular lower limit, the dielectric loss tangent of the substrate 11 may be greater than 0. Having the dielectric loss tangent of the substrate 11 in the above range enables loss of gain (sensitivity) in conjunction with transmission/reception of electromagnetic waves to be reduced, particularly in a case in which the electromagnetic waves transmitted/received by the mesh wiring layer 20 (e.g., millimeter waves) are radio frequency waves. Note that the lower limit of the dielectric loss tangent of the substrate 11 is not limited in particular. The relative permittivity of the substrate 11 is not limited in particular, but may be 2.0 or more and 10.0 or less. A greater range of options is available as the material of the substrate 11 by the relative permittivity of the substrate 11 being 2.0 or greater. Also, loss of gain (sensitivity) in conjunction with transmission/reception of electromagnetic waves can be reduced by the relative permittivity of the substrate 11 being 10.0 or less. That is to say, in a case in which the relative permittivity of the substrate 11 is great, the effects of the thickness of the substrate 11 on propagation of electromagnetic waves increases. Also, in a case in having adverse effects on the propagation of electromagnetic waves, the dielectric loss tangent of the substrate 11 increases, and loss of gain (sensitivity) in conjunction with transmission/reception of electromagnetic waves can increase. Conversely, the relative permittivity of the substrate 11 being 10.0 or less can reduce the effects of the thickness of the substrate 11 on the propagation of electromagnetic waves. Accordingly, loss of gain (sensitivity) in conjunction with transmission/reception of electromagnetic waves can be reduced. In particular, in a case in which the electromagnetic waves transmitted/received by the mesh wiring layer 20 (e.g., millimeter waves) are radio frequency waves, loss of gain (sensitivity) in conjunction with transmission/reception of electromagnetic waves can be reduced.

The dielectric loss tangent of the substrate 11 can be measured in conformance with IEC 62562. Specifically, first, a portion of the substrate 11 on which the mesh wiring layer 20 is not formed is cut out to prepare a test piece. Alternatively, a portion of the substrate 11 on which the mesh wiring layer 20 is formed may be cut out, and the mesh wiring layer 20 may be removed by etching or the like. The dimensions of the test piece are 10 mm to 20 mm in width and 50 mm to 100 mm in length. Next, the dielectric loss tangent is measured in conformance with IEC 62562. The dielectric loss tangent and the relative permittivity of the substrate 11 can also be measured in conformance with ASTM D150.

The substrate 11 has transparency. In the present specification, the term having transparency means transmittance of light rays having a wavelength of 400 nm or higher and 700 nm or lower being 85% or more. The transmittance of the substrate 11 regarding visible light rays may be 85% or more, and preferably is 90% or more. There is no upper limit to the transmittance of visible light rays of the substrate 11 in particular, but may be 100% or less, for example. Having the transmittance of visible light rays of the substrate 11 in the above range enables the transparency of the wiring board 10 to be increase, and visual recognition of the display of the image display device into which the wiring board 10 is assembled to be facilitated. Note that the term visible light rays refers to light rays having a wavelength of 400 nm or higher and 700 nm or lower. Also, the term transmittance of visible light rays of 85% or more means that transmittance of the entire wavelength domain of 400 nm or higher and 700 nm or lower is 85% or more when light absorbance is measured for the substrate 11 using a known spectrophotometer (e.g., ultraviolet-visible spectrophotometer: V-670 manufactured by JASCO Corporation). Note that transmittance of a predetermined domain can also be measured for the wiring board 10 using the above ultraviolet-visible spectrophotometer "V-670". In a case of measuring the transmittance of a region in which the mesh wiring layer 20 is present, measurement is performed such that the mesh wiring layer 20 is included in the entirety of the measurement range (e.g., range of 10 mm $\times$ 3 mm) of measurement by the above ultraviolet-visible spectrophotometer.

Next, the primer layer 15 will be described. The primer layer 15 has a role of improving adhesion of first-direction wiring lines 21, second-direction wiring lines 22, and dummy wiring lines 30a to the substrate 11. In the present embodiment, the primer layer 15 is provided on generally the entire region of the front face of the substrate 11. Thus, patterning of the primer layer 15 becomes unnecessary. Consequently, the number of process steps can be reduced. Note that the primer layer 15 may be provided only a region of the front face of the substrate 11 in which the first-direction wiring lines 21, the second-direction wiring lines 22, and the dummy wiring lines 30a are provided.

The primer layer 15 contains a polymer material. Accordingly, the adhesion of the first-direction wiring lines 21, the second-direction wiring lines 22, and the dummy wiring lines 30a to the substrate 11 can be effectively improved. In this case, a colorless and transparent polymer material can be used as the material for the primer layer 15.

The primer layer 15 preferably contains an acrylic-based resin or a polyester-based resin. Accordingly, the adhesion of the first-direction wiring lines 21, the second-direction wiring lines 22, and the dummy wiring lines 30a to the substrate 11 can be improved more effectively. In a case of the primer layer 15 containing an acrylic-based resin, examples of the acrylic-based resin include polymers of which acrylic acid, methacrylic acid, and derivatives thereof are monomer components. For example, polymers obtained by copolymerizing a primary component such as acrylic acid, methyl acrylate, ethyl acrylate, propyl acrylate, butyl acrylate, methacrylic acid, ethyl methacrylate, propyl methacrylate, butyl methacrylate, 2-ethylhexyl acrylate, acrylamide, acrylonitrile, hydroxyl acrylate, or the like, with copolymerizable monomers (e.g., styrene, divinylbenzene, acrylonitrile, or the like) can be used. Also, curing can be performed by cross-linking of acrylic-based resin by adding dimers having two acrylic groups or methacrylic groups per molecule, or polyfunctional urethane acrylate, or the like, besides the above monomers, or adding organic molecules having two or more epoxy groups per molecule. A primer layer formed by curing has excellent adhesion. Functions of excellent water resistance, acid resistance, alkali resistance, solvent resistance, or combinations thereof, can be manifested. Accordingly, deterioration of adhesion at the time of forming the wiring lines or over time can be suppressed.

In a case of the primer layer 15 containing a polyester-based resin, the primer layer 15 can be formed by curing a hydroxyl-group-containing polyester-based resin by cross-linking with a curing agent that reacts to hydroxyl groups, for example. An example of the hydroxyl-group-containing polyester-based resin is polyester polyol, and an example of the curing agent is polyisocyanate and/or a polyisocyanate prepolymer. The primer layer 15 formed by performing curing of the polyester polyol and the polyisocyanate and/or the polyisocyanate prepolymer has excellent adhesion. Also, functions of excellent water resistance, acid resistance, alkali resistance, solvent resistance, or combinations thereof, can be manifested. Accordingly, deterioration of adhesion over time can be suppressed. Also, the primer layer 15 formed by performing curing of the polyester polyol and the polyisocyanate and/or polyisocyanate prepolymer has excellent heat resistance. Accordingly, effects of heat generated in the film formation steps and so forth performed after formation of the primer layer 15 occur less readily, and whitening, cracking and so forth of the primer layer 15 under heat can be suppressed.

Also, examples of preferable polyisocyanates and/or polyisocyanate prepolymers include IPDI-based, XDI-based, and HDI-based polyisocyanates and/or polyisocyanate prepolymers. Using these enables yellow discoloration of the primer layer 15 to be suppressed. Now, IPDI-based means isophorone diisocyanate and denatured forms thereof, XDI-based means xylylene diisocyanate and denatured forms thereof, and HDI-based means hexamethylene diisocyanate and denatured forms thereof. Examples of denatured forms include trimethylolpropane (TMP) adducts, isocyanurates, biurets, allophanates, and so forth.

Also, the polymer material of the primer layer 15 may be cured through cross-linking by irradiation of the polymer material by visible light rays, ultraviolet rays, X-rays, electron beams, alpha rays, beta rays, gamma rays, and so forth. Accordingly, scratch resistance and heat resistance of the primer layer 15 can be improved.

A thickness $T_2$ of the primer layer 15 (length in Z direction, see Fig. 3) is preferably 0.05 $\mu$m or more and 0.5 $\mu$m or less. By the thickness $T_2$ of the primer layer 15 being 0.05 $\mu$m or more, the adhesion of the first-direction wiring lines 21, the second-direction wiring lines 22, and the dummy wiring lines 30a to the substrate 11 can be effectively improved. Also, by the thickness $T_2$ of the primer layer 15 being 0.5 $\mu$m or less, transparency of the wiring board 10 can be secured.

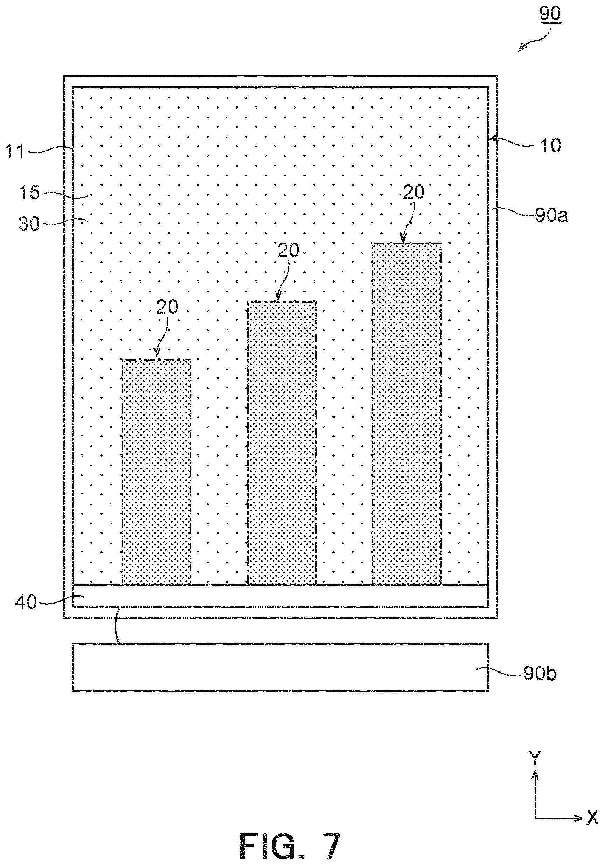

Next, the mesh wiring layer 20 will be described. In the present embodiment, the mesh wiring layer 20 is made up of an antenna pattern having functions as an antenna. In Fig. 1, a plurality of (three) mesh wiring layers 20 are present on the substrate 11, each corresponding to different frequency bands. That is to say, lengths (length in Y direction) $L_a$ of the plurality of mesh wiring layers 20 differ from each other, each having a length corresponding to a particular frequency band. Note that the lower frequency the corresponding frequency band is, the longer the length $L_a$ of the mesh wiring layer 20 is. In a case in which the wiring board 10 is disposed on a display 90a (see Fig. 7, which will be described later) of an image display device 90, the wiring board 10 may have radio wave transmission/reception functions regarding each mesh wiring layer 20. In this case, each mesh wiring layer 20 may correspond to one of an antenna for telephone, an antenna for WiFi, an antenna for 3G, an antenna for 4G, an antenna for 5G, an antenna for LTE, an antenna for Bluetooth (registered trademark), an antenna for NFC, and so forth. Alternatively, in a case in which the wiring board 10 does not have radio wave transmission/reception functions, each mesh wiring layer 20 may have functions such as, for example, hovering (a function enabling a user to perform operations even without directly touching the display), fingerprint authentication, heater, noise reduction (shielding), and so forth.

Each mesh wiring layer 20 has a generally rectangular shape in plan view. With each mesh wiring layer 20, the longitudinal direction thereof is parallel to the Y direction, and the lateral direction is parallel to the X direction. The length $L_a$ of each mesh wiring layer 20 in the longitudinal direction (Y direction) can be selected from a range of 1 mm or more and 100 mm or less, for example, and may be selected from a range of 3 mm or more and 100 mm or less. A width $W_a$ in the lateral direction (X direction) of each mesh wiring layer 20 can be selected from a range of 1 mm or more and 10 mm or less, for example. In particular, the mesh wiring layer 20 may be a millimeter wave antenna. That is to say, the wiring board 10 may have millimeter wave transmission/reception functions. In a case in which the mesh wiring layer 20 is a millimeter wave antenna, the length $L_a$ of the mesh wiring layer 20 can be selected from a range of 1 mm or more and 10 mm or less, more preferably 1.5 mm or more and 5 mm or less.

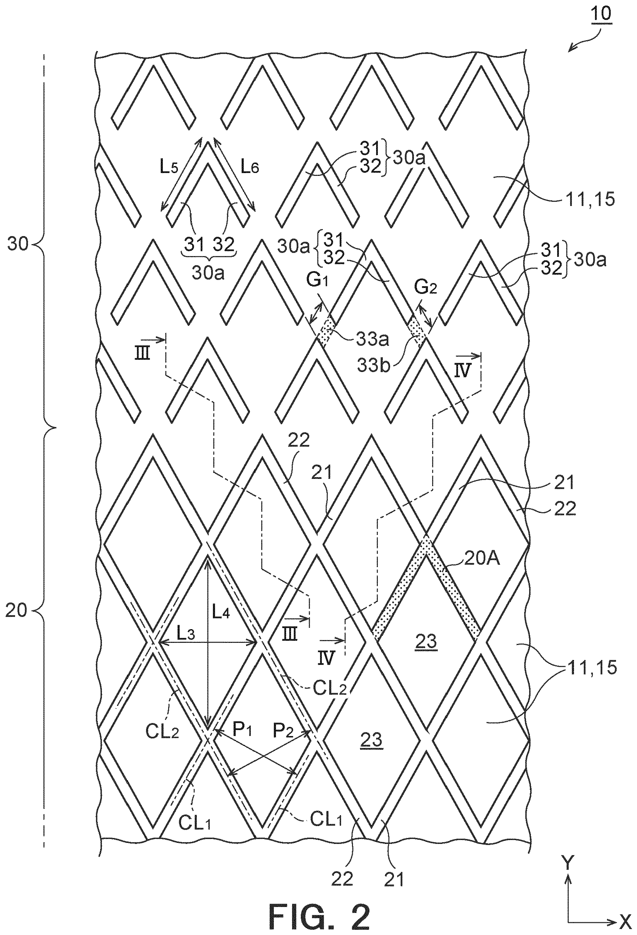

The mesh wiring layer 20 is formed with respective metal lines being formed in a grid-like or fishnet-like form, having a uniform repetitive pattern in the X direction and in the Y direction. That is to say, as illustrated in Fig. 2, the mesh wiring layer 20 is made up of a repetition of a unit pattern 20A that is generally L-shaped (shaded portion in Fig. 2), made up of a portion of the second-direction wiring lines 22 which will be described later, and a portion of the first-direction wiring lines 21 which will be described later.

As illustrated in Fig. 2A and Fig. 2B, each mesh wiring layer 20 includes a plurality of the first-direction wiring lines (antenna wiring lines) 21 having functions as an antenna, and a plurality of the second-direction wiring lines (antenna interconnection wiring lines) 22 interconnecting the plurality of first-direction wiring lines 21. Specifically, the plurality of first-direction wiring lines 21 and the plurality of second-direction wiring lines 22 overall and integrally form a regular grid-like or fishnet-like form. The first-direction wiring lines 21 and the second-direction wiring lines 22 each extend inclined in a direction (Y direction) corresponding to the frequency band of the antenna. Note that the first-direction wiring lines 21 and the second-direction wiring lines 22 intersect each other at an acute angle or an obtuse angle, but this is not restrictive, and intersecting each other may be orthogonal. In this case, the first-direction wiring lines 21 may extend in a direction corresponding to the frequency band of the antenna (Y direction), and the second-direction wiring lines 22 may extend in a direction orthogonal to the first-direction wiring lines 21 (X direction).

In each mesh wiring layer 20, a plurality of openings 23 are formed by being surrounded by the first-direction wiring lines 21 adjacent to each other and the second-direction wiring lines 22 adjacent to each other. Also, the first-direction wiring lines 21 and the second-direction wiring lines 22 are disposed equidistantly to each other. That is to say, the plurality of first-direction wiring lines 21 are disposed equidistantly to each other, and a pitch $P_1$ thereof (see Fig. 2) can be in a range of 0.01 mm or more and 1 mm or less, for example. Also, the plurality of second-direction wiring lines 22 are disposed equidistantly to each other, and a pitch $P_2$ thereof (see Fig. 2) can be in a range of 0.01 mm or more and 1 mm or less, for example. In this way, due to the plurality of first-direction wiring lines 21 and the plurality of second-direction wiring lines 22 being each disposed equidistantly, variance in the size of the openings 23 in each mesh wiring layer 20 is eliminated, and the mesh wiring layer 20 can be made to be difficult to visually recognize by the bare eye. Also, the pitch $P_1$ of the first-direction wiring lines 21 is equal to the pitch $P_2$ of the second-direction wiring lines 22. Accordingly, the openings 23 each have a generally rhombic shape in plan view, and the primer layer 15 that has transparency and the substrate 11 that has transparency are exposed from each of the openings 23. Thus, the transparency of the wiring board 10 overall can be increased by increasing the area of the openings 23. Note that a length $L_3$ (see Fig. 2) of the openings 23 in the X direction can be in a range of 0.01 mm or more and 1 mm or less, for example. Also, a length $L_4$ (see Fig. 2) of the openings 23 in the Y direction can be in a range of 0.01 mm or more and 1 mm or less, for example. Also, the openings 23 may each have shapes such as generally square shapes in plan view, generally rectangular shapes in plan view, and so forth. Further, the shapes of the openings 23 preferably are the same shape and the same size over the entire area, but do not have to be uniform over the entire area, with changes being made thereto depending on the location, or the like.

As illustrated in Fig. 3, the cross-section of each first-direction wiring line 21 perpendicular to the longitudinal direction is a generally rectangular shape or a generally square shape. In this case, the cross-sectional shape of the first-direction wiring lines 21 is generally uniform in the longitudinal direction of the first-direction wiring lines 21. Also, as illustrated in Fig. 4, the cross-sectional shape of each second-direction wiring line 22 perpendicular to the longitudinal direction is a generally rectangular shape or a generally square shape, and is generally the same as the cross-sectional shape of the first-direction wiring lines 21 described above. In this case, the cross-sectional shape of the second-direction wiring lines 22 is generally uniform in the longitudinal direction of the second-direction wiring lines 22. The cross-sectional shape of the first-direction wiring lines 21 and the second-direction wiring lines 22 does not necessarily have to be a generally rectangular shape or a generally square shape, and for example may be a generally trapezoidal shape in which the front face side (plus side in the Z direction) is narrower than the rear face side (minus side in the Z direction), or a shape in which the side faces situated on both sides in width direction are curved.

In the present embodiment, a line width $W_1$ (see Fig. 3) of the first-direction wiring lines 21 and a line width $W_2$ (see Fig. 4) of the second-direction wiring lines 22 are not limited in particular, and can be selected as appropriate in accordance with the usage. For example, the line width $W_1$ of the first-direction wiring lines 21 can be selected from a range of 0.1 $\mu$m or more and 5.0 $\mu$m or less, and preferably is 0.2 $\mu$m or more and 2.0 $\mu$m or less. Also, the line width $W_2$ of the second-direction wiring lines 22 can be selected from a range of 0.1 $\mu$m or more and 5.0 $\mu$m or less, and preferably is 0.2 $\mu$m or more and 2.0 $\mu$m or less. Also, for example, a height $H_1$ (length in Z direction, see Fig. 3) of the first-direction wiring lines 21 and a height $H_2$ (length in Z direction, see Fig. 4) of the second-direction wiring lines 22 are not limited in particular and can be selected as appropriate in accordance with the usage, and can be selected from a range of 0.1 $\mu$m or more and 5.0 $\mu$m or less for example, and preferably are 0.2 $\mu$m or more and 2.0 $\mu$m or less.

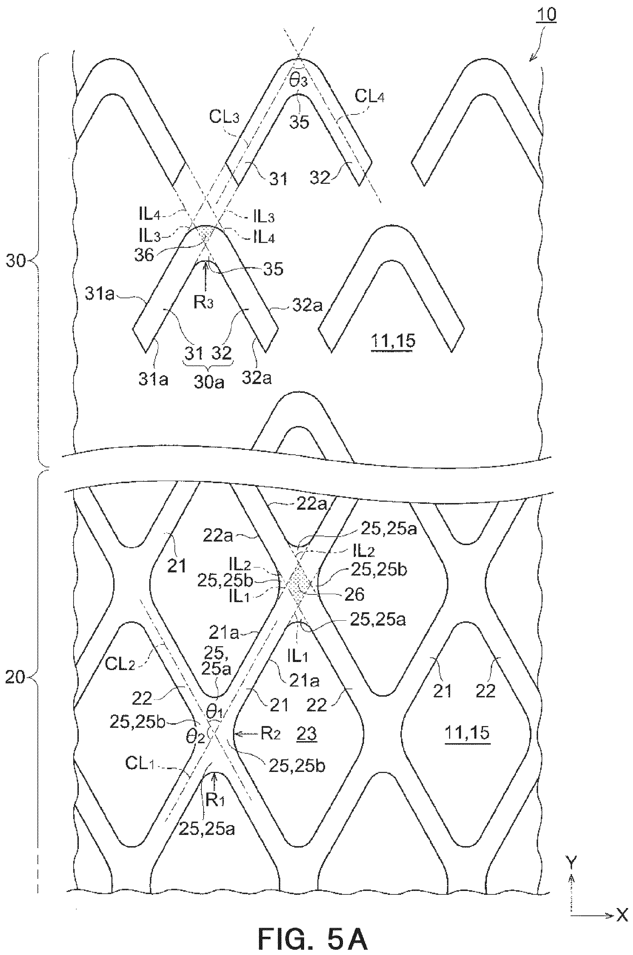

Now, as described above, the plurality of first-direction wiring lines 21 and the plurality of second-direction wiring lines 22 integrally form a regular fishnet-like form overall. Accordingly, as illustrated in Fig. 5A, four corner portions 25 are formed between one first-direction wiring line 21 and one second-direction wiring line 22, by the one first-direction wiring line 21 and the one second-direction wiring line 22 intersecting. In the present embodiment, between one first-direction wiring line 21 and one second-direction wiring line 22, a pair of corner portions 25a in which an angle $\theta_1$ formed between a center line $CL_1$ of the first-direction wiring line 21 and a center line $CL_2$ of the second-direction wiring line 22 is an acute angle in plan view, and a pair of corner portions 25b in which an angle $\theta_2$ formed between the center line $CL_1$ and the center line $CL_2$ is an obtuse angle in plan view, are formed. In other words, the corner portions 25a are formed at the sides at which the angle $\theta_1$ formed between the center line $CL_1$ and the center line $CL_2$ is an acute angle in plan view, and the corner portions 25b are formed at the sides at which the angle $\theta_2$ formed between the center line $CL_1$ and the center line $CL_2$ is an obtuse angle in plan view.

At an intersection between the first-direction wiring line 21 and the second-direction wiring line 22, the four corner portions 25 formed between the first-direction wiring line 21 and the second-direction wiring line 22 may each be rounded in plan view. Each of the corner portion 25 are formed around an intersection portion 26 (shaded portion in Fig. 5A) where the first-direction wiring line 21 and the second-direction wiring line 22 intersect, and are recessed toward the intersection portion 26 in plan view. In this case, a curvature radius $R_1$ of the corner portions 25a each may be 0 $\mu$m or more and 500 $\mu$m or less for example, and more preferably may be 3 $\mu$m or more and 400 $\mu$m or less. Also, a curvature radius $R_2$ of the corner portions 25b each may be 0 $\mu$m or more and 500 $\mu$m or less for example, and more preferably may be 5 $\mu$m or more and 400 $\mu$m or less. Now, in a case in which the curvature radius $R_1$ or the curvature radius $R_2$ is 0, this means that the corner portion 25 are not rounded. However, there are no cases in which both the curvature radius $R_1$ and the curvature radius $R_2$ are 0. In particular, the curvature radius $R_1$ not being 0 is preferable from the point of being able to suppress deterioration in non-visibility. Note that in the present specification, "intersection portion where the first-direction wiring line and the second-direction wiring line intersect" means a region in plan view that is surrounded by a pair of first imaginary straight lines $IL_1$ that each extend from a pair of side faces 21a of the first-direction wiring line 21 and are also each parallel to the pair of side faces 21a of the first-direction wiring line 21, and a pair of second imaginary straight lines $IL_2$ that each extend from a pair of side faces 22a of the second-direction wiring line 22 and are also each parallel to the pair of side faces 22a of the second-direction wiring line 22.

Thus, adhesion of the first-direction wiring lines 21 and the second-direction wiring lines 22 to the primer layer 15 can be improved by the corner portions 25 being rounded in plan view. In particular, at the corner portions 25a where the angle $\theta_1$ between the center line $CL_1$ and the center line $CL_2$ is an acute angle in plan view, there is a possibility that a great force will be locally applied to the corner portions 25a in cases of flexing the wiring board 10 or the like. Conversely, the corner portions 25a of which the angle $\theta_1$ is an acute angle in plan view being rounded in plan view can suppress a great force from being locally applied to the corner portions 25a even in a case of flexing the wiring board 10 or the like. Accordingly, adhesion of the first-direction wiring lines 21 and the second-direction wiring lines 22 to the primer layer 15 can be effectively improved.

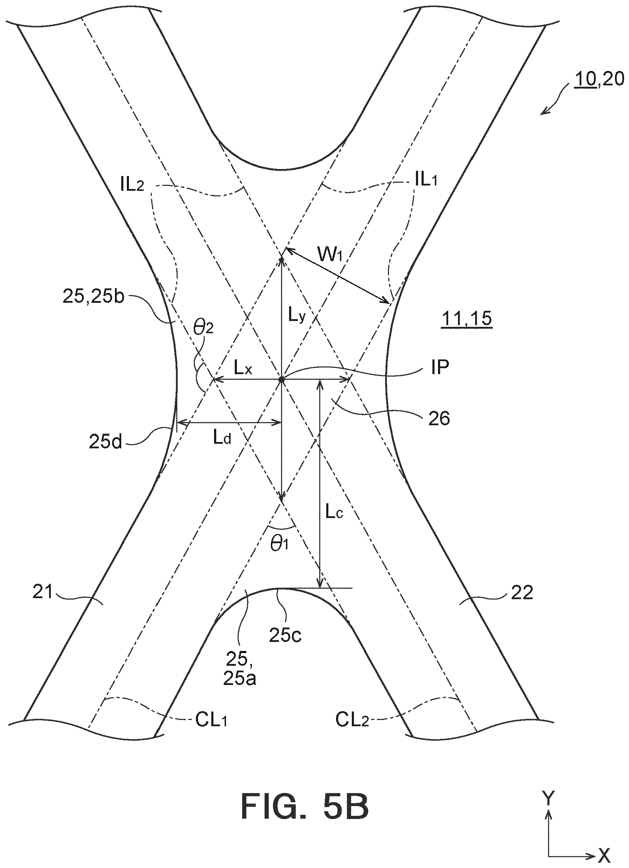

Now, as illustrated in Fig. 5B, a relation according to the following Expression (1) holds with regard to a length $L_Y$ of the intersection portion 26 in the Y direction, the line width $W_1$ of the first-direction wiring line 21 and the angle $\theta_1$.

$$\sin (\theta_1 / 2) = W_1 / L_Y \ldots \text{Expression (1)}$$

Accordingly, the length $L_Y$ of the intersection portion 26 in the Y direction can be expressed as in the following Expression (2), using the line width $W_1$ of the first-direction wiring line 21 and the angle $\theta_1$.

$$L_Y = W_1 / \sin (\theta_1 / 2) \ldots \text{Expression (2)}$$

In this case, a shortest distance $L_c$ from an intersection point IP of the center line $CL_1$ of the first-direction wiring line 21 and the center line $CL_2$ of the second-direction wiring line 22 to a side face 25c of the corner portion 25a may be 0.5 times the length $L_Y$ of the intersection portion 26 in the Y direction or more, and 1.0 times thereof or less, and more preferably may be 0.55 times or more and 0.9 times or less. The shortest distance $L_c$ being 0.5 times the length $L_Y$ or more, preferably 0.55 times or more, enables adhesion of the first-direction wiring lines 21 and second-direction wiring lines 22 to the primer layer 15 to be effectively improved. Also, the shortest distance $L_c$ being 1.0 times the length $L_Y$ or less, and more preferably 0.9 times or less, enables deterioration in non-visibility to be suppressed.

Also, as illustrated in Fig. 5B, a relation according to the following Expression (3) holds with regard to a length $L_X$ of the intersection portion 26 in the X direction, the line width $W_1$ of the first-direction wiring line 21 and the angle $\theta_1$.

$$\sin (\theta_2 / 2) = W_1 / L_X \ldots \text{Expression (3)}$$

Accordingly, the length $L_X$ of the intersection portion 26 in the X direction can be expressed as in the following Expression (4), using the line width $W_1$ of the first-direction wiring line 21 and the angle $\theta_2$.

$$L_x = W_1 / \sin(\theta_2 / 2) \dots \text{Expression (4)}$$

In this case, a shortest distance $L_d$ from the intersection point IP of the center line $CL_1$ of the first-direction wiring line 21 and the center line $CL_2$ of the second-direction wiring line 22 to a side face 25d of the corner portion 25b may be 0.5 times the length $L_X$ of the intersection portion 26 in the X direction or more, and 1.0 times thereof or less, and more preferably may be 0.55 times or more and 0.9 times or less. Due to the shortest distance $L_d$ being 0.5 times the length $L_X$ or more, preferably 0.55 times or more, adhesion of the first-direction wiring lines 21 and second-direction wiring lines 22 to the primer layer 15 can be effectively improved. Also, due to the shortest distance $L_d$ being 1.0 times the length $L_X$ or less, and more preferably 0.9 times or less, deterioration in non-visibility can be suppressed.

It is sufficient for the material of the first-direction wiring lines 21 and the second-direction wiring lines 22 to be a metal material that has conductivity. The material of the first-direction wiring lines 21 and the second-direction wiring lines 22 is copper in the present embodiment, but is not limited thereto. Metal materials (including alloys) such as gold, silver, copper, platinum, tin, aluminum, iron, nickel, and so forth, for example, can be used as the material of the first-direction wiring lines 21 and the second-direction wiring lines 22. Also, the first-direction wiring lines 21 and the second-direction wiring lines 22 may be plating layers formed by electrolytic plating.

Next, the dummy wiring layer 30 will be described. Referencing Fig. 1 again, the dummy wiring layer 30 is provided so as to surround each mesh wiring layer 20, and is formed so as to surround, with the exception of the power supply unit 40 side (minus side in Y direction), all peripheral regions of each mesh wiring layer 20 (plus side in X direction, minus side in X direction, and plus side in Y direction). In this case, the dummy wiring layer 30 is disposed on the substrate 11 and the primer layer 15 over generally the entire region excluding the mesh wiring layers 20 and the power supply unit 40. Unlike the mesh wiring layers 20, this dummy wiring layer 30 does not substantially function as an antenna.

As illustrated in Fig. 2, the dummy wiring layer 30 is made up of a repetition of dummy wiring lines 30a having a predetermined unit pattern. That is to say, the dummy wiring layer 30 includes a plurality of dummy wiring lines 30a of the same shape, and each dummy wiring line 30a is electrically isolated from each of the mesh wiring layers 20 (first-direction wiring lines 21 and second-direction wiring lines 22) and the power supply unit 40. Also, the plurality of dummy wiring lines 30a are regularly disposed over the entire region within the dummy wiring layer 30. These dummy wiring lines 30a are each generally L-shaped in plan view, having a first dummy wiring line portion 31 that extends parallel to the first-direction wiring lines 21, and a second dummy wiring line portion 32 that extends parallel to the second-direction wiring lines 22. Of these, the first dummy wiring line portion 31 has a predetermined length $L_5$, the second dummy wiring line portion 32 has a predetermined length $L_6$, and these are equal to each other ($L_5 = L_6$).

Void portions 33a (shaded portions in Fig. 2) are formed between dummy wiring lines 30a that are adjacent to each other in a direction in which the first dummy wiring line portions 31 extend, and void portions 33b (shaded portions in Fig. 2) are formed between dummy wiring lines 30a that are adjacent to each other in a direction in which the second dummy wiring line portions 32 extend. In this case, the dummy wiring lines 30a are disposed equidistantly to each other. That is to say, the dummy wiring lines 30a that are adjacent to each other in the direction in which the first dummy wiring line portions 31 extend are disposed across equidistantly to each other, and a gap $G_1$ therebetween can be in a range of 1 $\mu$m or more and 20 $\mu$m or less, for example. In the same way, the dummy wiring lines 30a that are adjacent to each other in the direction in which the second dummy wiring line portions 32 extend are disposed across equidistantly to each other, and a gap $G_2$ therebetween can be in a range of 1 $\mu$m or more and 20 $\mu$m or less, for example. Note that the greatest values of the gaps $G_1$ and $G_2$ may be 0.8 times the above-described pitches $P_1$ and $P_2$ or less, respectively. In this case, the gap $G_1$ of the dummy wiring lines 30a is equal to the gap $G_2$ of the dummy wiring lines 30a ($G_1 = G_2$).

In the present embodiment, the dummy wiring lines 30a have a shape in which part of the unit patterns 20A of the mesh wiring layer 20 described above is missing. That is to say, the shape of the dummy wiring lines 30a is a shape in which the above-described void portions 33a and 33b are removed from the L-shaped unit patterns 20A of the mesh wiring layer 20. That is to say, a shape in which the plurality of dummy wiring lines 30a of the dummy wiring layer 30 and the plurality of void portions 33a and 33b thereof are combined is equivalent to the fishnet-like form that forms the mesh wiring layer 20. Thus, difference between the mesh wiring layer 20 and the dummy wiring layer 30 can be made to be difficult to visually recognize by the dummy wiring lines 30a of the dummy wiring layer 30 having the shape in which part of the unit pattern 20A of the mesh wiring layer 20 is missing, and also the mesh wiring layer 20 disposed on the substrate 11 can be made to be difficult to see.

In Fig. 2, the mesh wiring layer 20 and the dummy wiring layer 30 are adjacent in the Y direction. Near a boundary of the mesh wiring layer 20 and the dummy wiring layer 30, the first dummy wiring line portions 31 are formed upon lines extending from the first-direction wiring lines 21. Accordingly, the difference between the mesh wiring layer 20 and the dummy wiring layer 30 is difficult to visually recognize. Also, for the same reason, the second dummy wiring line portions 32 are preferably formed upon lines extending from the second-direction wiring lines 22 where the mesh wiring layer 20 and the dummy wiring layer 30 are adjacent in the X direction, although this is not illustrated.

As illustrated in Fig. 3, the cross-section of the first dummy wiring line portion 31 of each dummy wiring line 30a perpendicular to the longitudinal direction thereof is a generally rectangular shape or a generally square shape. Also, as illustrated in Fig. 4, the cross-section of the second dummy wiring line portion 32 of each dummy wiring line 30a perpendicular to the longitudinal direction thereof is a generally rectangular shape or a generally square shape. In this case, the cross-sectional shape of the first dummy wiring line portion 31 is generally the same as the cross-sectional shape of the first-direction wiring line 21, and the cross-sectional shape of the second dummy wiring line portion 32 is generally the same as the cross-sectional shape of the second-direction wiring line 22.

In the present embodiment, a line width $W_3$ (see Fig. 3) of the first dummy wiring line portion 31 is generally the same as the line width $W_1$ of the first-direction wiring line 21, and a line width $W_4$ (see Fig. 4) of the second dummy wiring line portion 32 is generally the same as the line width $W_2$ of the second-direction wiring line 22. Also, a height $H_3$ (length in Z direction, see Fig. 3) of the first dummy wiring line portion 31 and a height $H_4$ (length in Z direction, see Fig. 4) of the second dummy wiring line portion 32 are generally the same as the height $H_1$ of the first-direction wiring line 21 and the height $H_2$ of the second-direction wiring line 22, respectively.

Also, as illustrated in Fig. 5A, a corner portion 35 is formed between the first dummy wiring line portion 31 and the second dummy wiring line portion 32. In the present embodiment, an angle $\theta_3$ formed by a center line $CL_3$ of the first dummy wiring line portion 31 and a center line $CL_4$ of the second dummy wiring line portion 32 that make up the corner portion 35 is an acute angle in plan view.

This corner portion 35 is rounded in plan view. The corner portion 35 is formed around an intersection portion 36 (shaded portion in Fig. 5A) where the first dummy wiring line portion 31 and the second dummy wiring line portion 32 intersect, and is recessed toward the intersection portion 36 in plan view. In this case, a curvature radius $R_3$ of the corner portion 35 may be 3 μm or more and 500 μm or less, for example. Note that in the present specification, "intersection portion where the first dummy wiring line portion and the second dummy wiring line portion intersect" means, in the dummy wiring lines 30a, a region in plan view that is surrounded by a pair of third imaginary straight lines $IL_3$ that each extend from a pair of side faces 31a of the first dummy wiring line portion 31 and are also parallel to each of the pair of side faces 31a of the first dummy wiring line portion 31, and a pair of fourth imaginary straight lines $IL_4$ that each extend from a pair of side faces 32a of the second dummy wiring line portion 32 and also are parallel to each of the pair of side faces 32a of the second dummy wiring line portion 32.

Thus, adhesion between the dummy wiring lines 30a and the primer layer 15 can be improved by the corner portion 35 being rounded in plan view. In particular, at the corner portion 35 where the angle $\theta_3$ between the center line $CL_3$ and the center line $CL_4$ is an acute angle in plan view, there is a possibility that a great force will be locally applied to the corner portion 35 in cases of flexing the wiring board 10 or the like. Conversely, the corner portion 35 of which the angle $\theta_3$ is an acute angle in plan view being rounded in plan view can suppress a great force from being locally applied to the corner portion 35 even in a case of flexing the wiring board 10 or the like. Accordingly, adhesion between the dummy wiring lines 30a and the primer layer 15 can be effectively improved.

The same metal material as the material for the first-direction wiring lines 21 and the material for the second-direction wiring lines 22 can be used as the material for the dummy wiring lines 30a.

Now, in the present embodiment, the above-described mesh wiring layer 20 and dummy wiring layer 30 have predetermined aperture ratios At1 and At2, respectively. Of these, the aperture ratio At1 of the mesh wiring layer 20 can be in a range of, for example, 85% or more and 99.9% or less, may be in a range of 87% or more and less than 100%, and preferably is 95% or more. By setting the aperture ratio At1 of the entire mesh wiring layer 20 to this range, conductivity and transparency of the wiring board 10 can be secured. Also, due to the aperture ratio At1 of the entire mesh wiring layer 20 being 95% or more, transparency can be raised while securing conductivity of the wiring board 10. Also, the aperture ratio At2 of the dummy wiring layer 30 can be in a range of, for example, 87% or more and less than 100%. In this case, the aperture ratio At2 of the dummy wiring layer 30 is greater than the aperture ratio At1 of the mesh wiring layer 20 (At2 > At1). Accordingly, transparency of the wiring board 10 can be secured. Note that this is not restrictive, and the aperture ratio At2 of the dummy wiring layer 30 may be smaller than the aperture ratio At1 of the mesh wiring layer 20 (At2 < At1).

Further, the entire aperture ratio of the mesh wiring layer 20 and the dummy wiring layer 30 (the aperture ratio of the mesh wiring layer 20 and the dummy wiring layer 30 together) may be in a range of, for example, 87% or more and less than 100%. Setting an aperture ratio At3 of the entire wiring board 10 to this range enables conductivity and transparency of the wiring board 10 to be secured.

Note that the aperture ratio is the ratio (%) of area of opening regions (regions where no metal portions, such as the first-direction wiring lines 21, second-direction wiring lines 22, dummy wiring lines 30a, and so forth, are present, and the substrate 11 is exposed) within a unit area of a predetermined region (the mesh wiring layer 20, the dummy wiring layer 30, or the mesh wiring layer 20 and dummy wiring layer 30).

Also, a protective layer may be formed on the front face of the substrate 11 so as to cover the mesh wiring layers 20, although not illustrated. The protective layer is to protect the mesh wiring layers 20, and is formed so as to cover at least the mesh wiring layers 20 on the substrate 11. Acrylic resins such as polymethyl (meth) acrylate, polyethyl (meth) acrylate, and so forth, and denatured resins and copolymers thereof, polyvinyl resins such as polyester, polyvinyl alcohol, polyvinyl acetate, polyvinyl acetal, polyvinyl butyral, and so forth, and denatured resins and copolymers thereof, polyurethane, epoxy resin, polyamide, chlorinated polyolefin, and so forth, and like insulating resins that are colorless and transparent, can be used as the material of the protective layer.

Referencing Fig. 1 again, the power supply unit 40 is electrically connected to the mesh wiring layer 20. This power supply unit 40 is made up of a thin-plate-like member that is generally rectangular and that has conductivity. The longitudinal direction of the power supply unit 40 is parallel to the X direction, and the lateral direction of the power supply unit 40 is parallel to the Y direction. Also, the power supply unit 40 is disposed on the longitudinal-direction end portion (minus-side end portion in the Y direction) of the substrate 11. Metal materials (including alloys) such as gold, silver, copper, platinum, tin, aluminum, iron, nickel, and so forth, for example, can be used as the material of the power supply unit 40. When the wiring board 10 is assembled into the image display device 90 (see Fig. 7), the power supply unit 40 is electrically connected to a wireless communication circuit 90b of the image display device 90. Note that while the power supply unit 40 is provided on the front face of the substrate 11, this is not restrictive, and part or all of the power supply unit 40 may be situated on an outer side from a peripheral edge of the substrate 11. Also, the power supply unit 40 may be formed flexibly, such that the power supply unit 40 can run around to a side face and a rear face of the image display device 90 for electrical connection on the side face and the rear face.

[Method for Manufacturing Wiring Board]

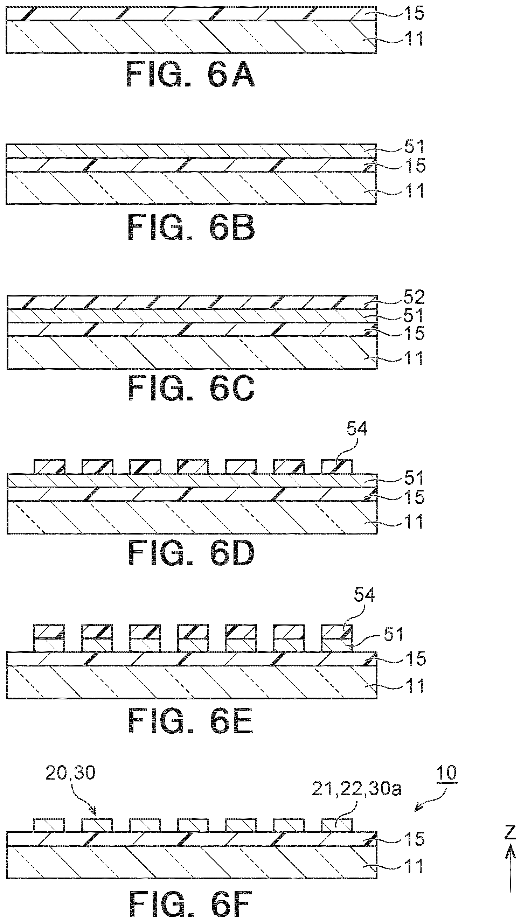

Next, a method for manufacturing the wiring board according to the present embodiment will be described with reference to Fig. 6A to Fig. 6F. Fig. 6A to Fig. 6F are cross-sectional views illustrating the method for manufacturing the wiring board according to the present embodiment.

First, the substrate 11 that has transparency is prepared.

Next, as illustrated in Fig. 6A, the primer layer 15 is formed on the substrate 11. At this time, the primer layer 15 may be formed on generally the entire region of the front face of the substrate 11. Roll coating, gravure coating, reverse gravure coating, micro-gravure coating, slot-die coating, die coating, knife coating, ink-jet coating, dispenser coating, kiss coating, spray coating, screen printing, offset printing, or flexo printing may be used as the method for forming the primer layer 15.

Next, the mesh wiring layer 20 including the plurality of first-direction wiring lines 21, and the plurality of second-direction wiring lines 22 interconnecting the plurality of first-direction wiring lines 21 is formed on the primer layer 15. Also, at this time, the dummy wiring layer 30 that includes the plurality of dummy wiring lines 30a which are disposed around the mesh wiring layer 20 and are electrically isolated from the first-direction wiring lines 21 is formed on the primer layer 15.

At this time, as illustrated in Fig. 6B, first, a metal foil 51 is laminated on generally the entire region of the surface of the primer layer 15. A thickness of the metal foil 51 in the present embodiment may be 0.1 $\mu$m or more and 5.0 $\mu$m or less. The metal foil 51 in the present embodiment may contain copper.

Next, as illustrated in Fig. 6C, a photo-curing insulating resist 52 is supplied to generally the entire region of a surface of the metal foil 51. Examples of this photo-curing insulating resist 52 include organic resins such as acrylic resins, epoxy-based resins, and so forth.

Next, as illustrated in Fig. 6D, an insulating layer 54 is formed by photolithography. In this case, the photo-curing insulating resist 52 is patterned by photolithography, thereby forming the insulating layer 54 (resist pattern). At this time, the insulating layer 54 is formed such that the metal foil 51 corresponding to the first-direction wiring lines 21, the second-direction wiring lines 22, and the dummy wiring lines 30a is exposed.

Next, as illustrated in Fig. 6E, the metal foil 51 on the surface of the primer layer 15 is removed. At this time, the metal foil 51 is etched such that the surface of the primer layer 15 is exposed, by performing wet processing using such as ferric chloride, cupric chloride, strong acids such as sulfuric acid, hydrochloric acid, and the like, persulfate, hydrogen peroxide, or aqueous solutions thereof, or combinations of the above, or the like.

Next, as illustrated in Fig. 6F, the insulating layer 54 is removed. At this time, the insulating layer 54 on the metal foil 51 is removed by performing wet processing using a permanganate solution, N-methyl-2-pyrrolidone, acid or alkali solutions, or the like, or dry processing using oxygen plasma.

Note that as for a different method for manufacturing the wiring board 10, the following method that is the so-called lift-off process can be used. In this case, first, the photo-curing insulating resist 52 is supplied to generally the entire region of the surface of the primer layer 15. Next, the photo-curing insulating resist 52 is patterned by photolithography, thereby forming the insulating layer 54 (resist pattern). Next, the metal foil 51 is formed on generally the entire region of a surface of the insulating layer 54 and the surface of the primer layer 15 exposed from the insulating layer 54. Thereafter, the insulating layer 54 is removed, and the metal foil 51 formed directly on the primer layer 15 remains as a pattern form.

Thus, the wiring board 10 that has the substrate 11, the primer layer 15 provided on the substrate 11, and the mesh wiring layer 20 and the dummy wiring layer 30 disposed on the primer layer 15, is obtained. In this case, the mesh wiring layer 20 includes the first-direction wiring lines 21 and the second-direction wiring lines 22, and the dummy wiring layer 30 includes the dummy wiring lines 30a.

[Effects of Present Embodiment]

Next, the effects of the wiring board having such a configuration will be described.

As illustrated in Fig. 7, the wiring board 10 is assembled into the image display device 90 that has the display 90a. The wiring board 10 is disposed on the display 90a. Examples of such an image display device 90 include mobile terminal equipment such as smartphones, tablets, and so forth. The mesh wiring layer 20 of the wiring board 10 is electrically connected to the wireless communication circuit 90b of the image display device 90 via the power supply unit 40. Thus, radio waves of predetermined frequencies can be transmitted/received via the mesh wiring layer 20, and communication can be performed by using the image display device 90. Note that the dummy wiring layer 30 is separated from the mesh wiring layer 20, and is electrically isolated. Accordingly, there are no effects on transmission/reception of radio waves even in a case of providing the dummy wiring layer 30.

Now, generally, adhesion force of the first-direction wiring lines 21 and the second-direction wiring lines 22 that are made of metal, and the substrate 11 that is made of resin, is not necessarily strong, due to the materials thereof being different. It is conceivable that the first-direction wiring lines 21 and the second-direction wiring lines 22 might peel away from the substrate 11 in a case in which force is applied to the wiring board 10 in a bending direction while using the image display device 90, or the like.

Conversely, according to the present embodiment, the wiring board 10 includes the substrate 11 that has transparency, the primer layer 15 provided on the substrate 11, and the mesh wiring layer 20 including the plurality of first-direction wiring lines 21 and the plurality of second-direction wiring lines 22 interconnecting the plurality of first-direction wiring lines 21 that is provided on the primer layer 15. Also, the primer layer 15 contains a polymer material. Further, four corner portions 25 formed between the first-direction wiring lines 21 and the second-direction wiring lines 22 at intersections of the first-direction wiring lines 21 and the second-direction wiring lines 22 are rounded in plan view. Accordingly, adhesion of the first-direction wiring lines 21 and the second-direction wiring lines 22 to the primer layer 15 can be improved. Accordingly, the first-direction wiring lines 21 and the second-direction wiring lines 22 can be suppressed from peeling away from the primer layer 15 even in a case of flexing the wiring board 10.

Now, in order to improve the adhesion of the first-direction wiring line 21 and the second-direction wiring line 22 to the primer layer 15, making the line width $W_1$ of the first-direction wiring line 21 and the line width $W_2$ of the second-direction wiring line 22 wider is conceivable. On the other hand, in a case of the line width of the first-direction wiring lines 21 and so forth being made wide, for example, there is a possibility that the aperture ratio At1 of the mesh wiring layer 20 will decrease, and the aperture ratio At3 of the entire wiring board 10 will decrease. Accordingly, there is a possibility that the wiring board 10 will become dark overall. Conversely, according to the present embodiment, the four corner portions 25 formed between the first-direction wiring line 21 and the second-direction wiring line 22 are rounded in plan view. Thus, the adhesion of the first-direction wiring line 21 and the second-direction wiring line 22 to the primer layer 15 can be improved without the aperture ratio At3 of the entire wiring board 10 decreasing.

Further, the wiring board 10 includes the substrate 11 that has transparency, the primer layer 15 provided on the substrate 11, and the mesh wiring layer 20 including the plurality of first-direction wiring lines 21 and the plurality of second-direction wiring lines 22 that is provided on the primer layer 15, and accordingly transparency of the wiring board 10 is secured. Accordingly, the display 90a can be visually recognized from the openings 23 of the mesh wiring layer 20 when the wiring board 10 is disposed on the display 90a, and thus visual recognition of the display 90a is not impeded.

Also, according to the present embodiment, the angle $\theta_1$ formed by the center line $CL_1$ of the first-direction wiring line 21 and the center line $CL_2$ of the second-direction wiring line 22 forming the corner portions 25a is an acute angle in plan view. Thus, due to the corner portions 25a of which the angle $\theta_1$ is an acute angle in plan view being rounded in plan view, a great force can be suppressed from being locally applied to the corner portions 25a even in a case of flexing the wiring board 10 or the like. Accordingly, adhesion of the first-direction wiring lines 21 and the second-direction wiring lines 22 to the primer layer 15 can be effectively improved.

Also, according to the present embodiment, the primer layer 15 includes an acrylic-based resin or a polyester-based resin. Accordingly, adhesion of the first-direction wiring lines 21, the second-direction wiring lines 22, and the dummy wiring lines 30a to the substrate 11, can be effectively improved.

Also, according to the present embodiment, the polymer material of the primer layer 15 is cross-linked. Accordingly, scratch resistance and heat resistance of the primer layer 15 can be improved.

Further, according to the present embodiment, the wiring board 10 further includes the dummy wiring layer 30 including the plurality of dummy wiring lines 30a that are disposed around the mesh wiring layer 20 and are electrically isolated from the first-direction wiring line 21. Laying out the dummy wiring layer 30 around the mesh wiring layer 20 in this way enables the boundary between the mesh wiring layer 20 and other regions to be made obscure. Accordingly, the mesh wiring layer 20 can be made to be difficult to see in the image display device 90, and the mesh wiring layer 20 can be made to be difficult to recognize by the bare eye of the user of the image display device 90.

Note that while description has been made in the above-described embodiment regarding an example in which each of the four corner portions 25 formed between the first-direction wiring line 21 and the second-direction wiring line 22 is rounded in plan view, this is not restrictive. For example, although not illustrated, it is sufficient for at least one corner portion 25 of the four corner portions 25 formed between the first-direction wiring line 21 and the second-direction wiring line 22 to be rounded in plan view. That is to say, there may be corner portions 25 formed between the first-direction wiring line 21 and the second-direction wiring line 22 that are not rounded in plan view. In this case as well, adhesion of the first-direction wiring line 21 and the second-direction wiring line 22 to the primer layer 15 can be improved by at least one corner portion 25 being rounded in plan view. Accordingly, the first-direction wiring line 21 and the second-direction wiring line 22 can be suppressed from peeling away from the primer layer 15 even in a case of flexing the wiring board 10 or the like.

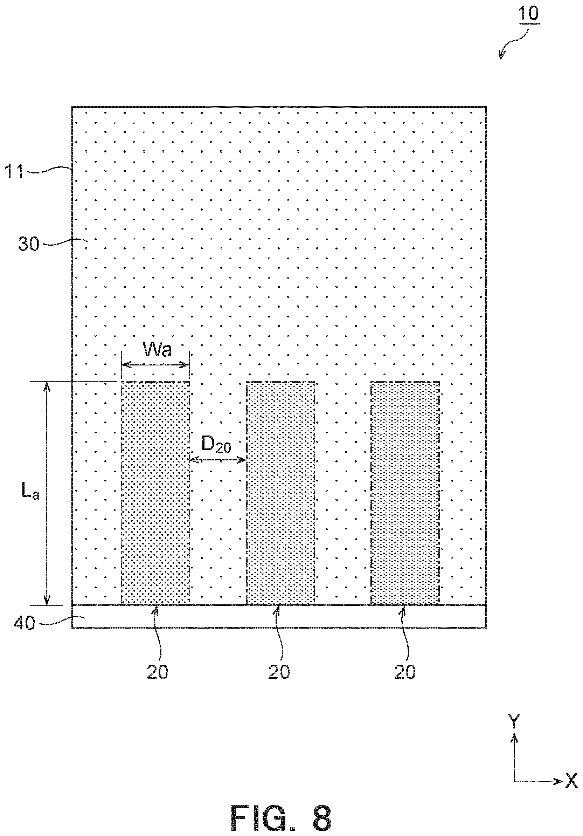

Also, an example is described in the above-described embodiment in which the mesh wiring layer 20 is made up of an antenna pattern having functions as an antenna. In this case, the wiring board 10 may have millimeter wave transmission/reception functions, as described above. Also, as illustrated in Fig. 8, the mesh wiring layer 20 may be configured as an array antenna. In a case of configuring the mesh wiring layer 20 as an array antenna, millimeter wave antenna performance of transmitting/receiving millimeter waves that have high straight-line propagation properties can be improved. Note that an array antenna is an antenna in which a plurality of antenna elements (radiating elements) are laid out in a regular manner, and the amplitudes and phases of excitation of the elements can be independently controlled.

Two or more mesh wiring layers 20 are preferably formed on the substrate 11, and four or more are preferably formed on the substrate 11. In the example that is illustrated, three mesh wiring layers 20 are formed on the substrate 11 (see Fig. 8). The mesh wiring layers 20 may each have the same shape as each other. In this case, error in the length (length in Y direction) $L_a$ and error in the width (length in X direction) $W_a$ in each of the mesh wiring layers 20 are preferably within 10%. Thus, millimeter wave antenna performance can be effectively raised.

A distance $D_{20}$ between mesh wiring layers 20 (see Fig. 8) is preferably 1 mm or more and 5 mm or less. Due to the distance $D_{20}$ between the mesh wiring layers 20 being 1 mm or more, unintentional interference of electromagnetic waves between the antenna elements can be suppressed. Due to the distance $D_{20}$ between the mesh wiring layers 20 being 5 mm or less, the size of the overall array antenna made up of the mesh wiring layers 20 can be reduced. For example, in a case in which the mesh wiring layers 20 are a millimeter wave antenna for 28 GHz, the distance $D_{20}$ between the mesh wiring layers 20 may be 3.5 mm. Also, in a case in which the mesh wiring layers 20 are a millimeter wave antenna for 60 GHz, the distance $D_{20}$ between the mesh wiring layers 20 may be 1.6 mm.

(Second Embodiment)

<First Implementation Mode>

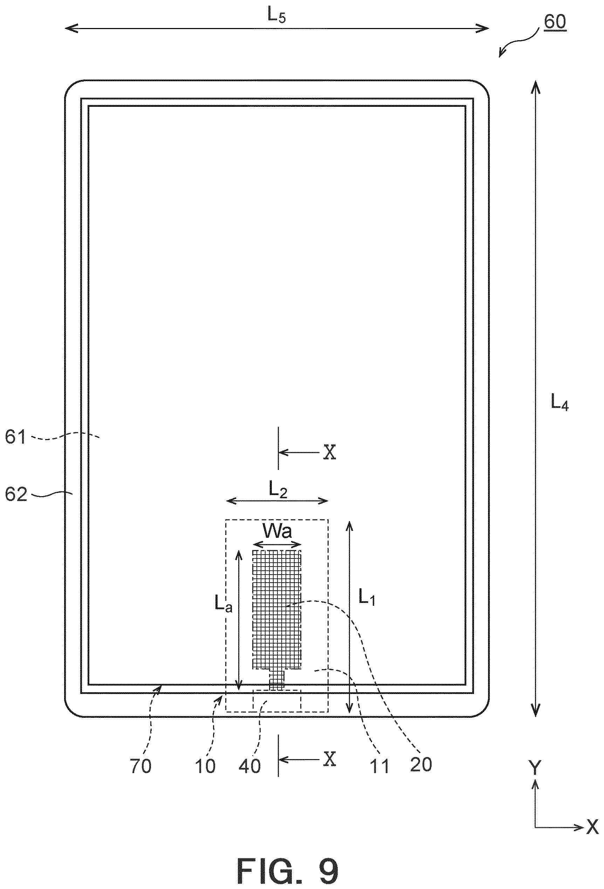

Next, a first implementation mode of a second embodiment will be described with reference to Fig. 9 to Fig. 15F. Fig. 9 to Fig. 15F are diagrams illustrating the first implementation mode of the second embodiment. In Fig. 9 to Fig. 15F, portions that are the same as in the first embodiment illustrated in Fig. 1 to Fig. 8 are denoted with the same signs, and detailed description may be omitted.

In the second embodiment, "X direction" is a direction parallel to one side of an image display device. "Y direction" is a direction that is perpendicular to the X direction and also parallel to the other side of the image display device. "Z direction" is a direction that is perpendicular to both the X direction and the Y direction, and is parallel to a thickness direction of the image display device. Also, "front face" is a face on the plus side in the Z direction, which is a light-emitting face side of the image display device, and is a face that faces the observer side. "Rear face" is a face on the minus side in the Z direction, which is a face opposite to the light-emitting face of the image display device and to the face that faces the observer side.

[Configuration of Image Display Device]

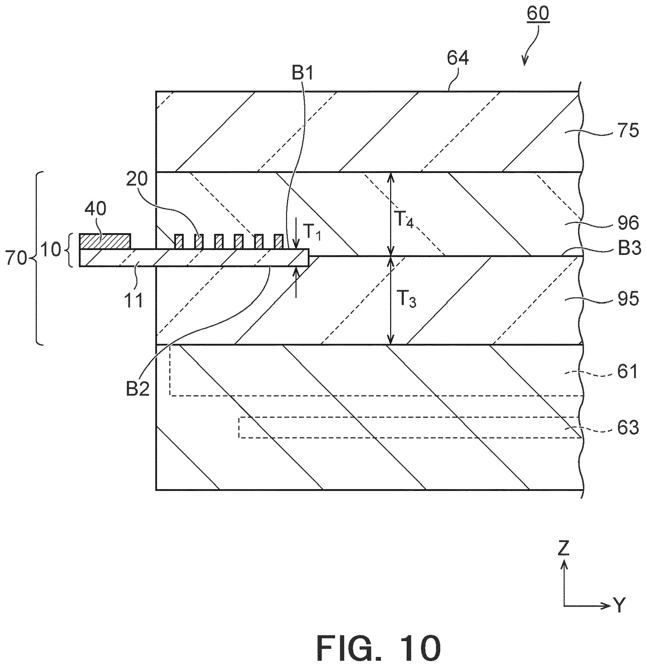

A configuration of the image display device according to the first implementation mode of the present embodiment will be described with reference to Fig. 9 and Fig. 10.

As illustrated in Fig. 9 and Fig. 10, an image display device 60 according to the present implementation mode includes an image display device laminate 70, and a display device (display) 61 that is laminated on the image display device laminate 70. Of these, the image display device laminate 70 has a first transparent adhesive layer 95, a second transparent adhesive layer 96, and the wiring board 10 that is situated between the first transparent adhesive layer 95 and the second transparent adhesive layer 96. The wiring board 10 has the substrate 11 that has transparency, and the mesh wiring layer 20 disposed on the substrate 11. The power supply unit 40 is electrically connected to the mesh wiring layer 20. Also, a communication module 63 is disposed on the minus side of the display device 61 in the Z direction. The image display device laminate 70, the display device 61, and the communication module 63 are accommodated in a housing 62.

In the image display device 60 illustrated in Fig. 9 and Fig. 10, radio waves of a predetermined frequency can be transmitted/received, and communication can be performed via the communication module 63. The communication module 63 may include one of an antenna for telephone, an antenna for WiFi, an antenna for 3G, an antenna for 4G, an antenna for 5G, an antenna for LTE, an antenna for Bluetooth (registered trademark), an antenna for NFC, and so forth. Examples of such image display devices 60 include mobile terminal equipment such as smartphones, tablets, and so forth.

As illustrated in Fig. 10, the image display device 60 has a light-emitting face 64. The image display device 60 has the wiring board 10 that is situated on a light-emitting face 64 side (plus side in Z direction) as to the display device 61, and the communication module 63 that is situated on the opposite side from the light-emitting face 64 (minus side in Z direction) as to the display device 61.

The display device 61 is made up of an organic EL (Electro Luminescence) display device. The display device 61 may include a metal layer, a support base material, a resin base material, a thin-film transistor (TFT), and an organic EL layer, which are not illustrated, for example. A touch sensor that is not illustrated may be disposed on the display device 61. Also, the wiring board 10 is disposed on the display device 61 via the first transparent adhesive layer 95. Note that the display device 61 is not limited to an organic EL display device. For example, the display device 61 may be another display device that has functions of light emission in itself, and may be a micro-LED display device including microscopic LED elements (light emitters). Alternatively, the display device 61 may be a liquid crystal display device including liquid crystal. A cover glass (surface protective plate) 75 is disposed on the wiring board 10 via the second transparent adhesive layer 96. Note that a decorative film and a polarizing plate, which are not illustrated, may be disposed between the second transparent adhesive layer 96 and the cover glass 75.

The first transparent adhesive layer 95 is an adhesive layer that directly or indirectly performs adhesion of the display device 61 to the wiring board 10. The first transparent adhesive layer 95 has optical transparency, and may be an OCA (Optical Clear Adhesive) layer. The OCA layer is a layer that is fabricated as follows, for example. First, a curable adhesive layer composition that is in a liquid state and that includes a polymerizable compound is coated on a releasing film of polyethylene terephthalate (PET) or the like, and cured by using ultraviolet rays (UV) for example, thereby obtaining an OCA sheet. This OCA sheet is applied to an object, following which the releasing film is removed by separation, thereby obtaining the OCA layer. The material of the first transparent adhesive layer 95 may be an acrylic-based resin, a silicone-based resin, a urethane-based resin, or the like.

The wiring board 10 is disposed on the light-emitting face 64 side from the display device 61, as described above. In this case, the wiring board 10 is situated between the first transparent adhesive layer 95 and the second transparent adhesive layer 96. More specifically, a partial region of the substrate 11 of the wiring board 10 is disposed in a partial region between the first transparent adhesive layer 95 and the second transparent adhesive layer 96. In this case, the first transparent adhesive layer 95, the second transparent adhesive layer 96, the display device 61, and the cover glass 75 each have a broader area than that of the substrate 11 of the wiring board 10. Thus, disposing the substrate 11 of the wiring board 10 in not the entire area of the image display device 60 in plan view but in a partial region thereof enables the overall thickness of the image display device 60 to be reduced.

The wiring board 10 has the substrate 11 that has transparency, and the mesh wiring layer 20 disposed on the substrate 11. The power supply unit 40 is electrically connected to the mesh wiring layer 20. The power supply unit 40 is electrically connected to the communication module 63. Also, part of the wiring board 10 is not disposed between the first transparent adhesive layer 95 and the second transparent adhesive layer 96, but protrudes to an outer side (minus side in Y direction) from between the first transparent adhesive layer 95 and the second transparent adhesive layer 96. Specifically, a region of the wiring board 10 in which the power supply unit 40 is provided protrudes to the outer side. Accordingly, electrical connection between the power supply unit 40 and the communication module 63 is facilitated. On the other hand, a region of the wiring board 10 in which the mesh wiring layer 20 is provided is situated between the first transparent adhesive layer 95 and the second transparent adhesive layer 96. Note that details of the wiring board 10 in the first implementation mode of the present embodiment will be described later.

The second transparent adhesive layer 96 is an adhesive layer that directly or indirectly performs adhesion of the wiring board 10 to the cover glass 75. The second transparent adhesive layer 96 has optical transparency, and may be an OCA (Optical Clear Adhesive) layer, in the same way as the first transparent adhesive layer 95. The material of the second transparent adhesive layer 96 may be an acrylic-based resin, a silicone-based resin, a urethane-based resin, or the like.

In the present implementation mode, the difference in refractive index between the substrate 11 and the first transparent adhesive layer 95 is 0.1 or less, and preferably is 0.05 or less. Also, the difference in refractive index between the second transparent adhesive layer 96 and the substrate 11 is 0.1 or less, and preferably is 0.05 or less. Further, the difference in refractive index between the first transparent adhesive layer 95 and the second transparent adhesive layer 96 is 0.1 or less, and preferably is 0.05 or less. Note that refractive index here refers to absolute refractive index, and can be found on the basis of Method A of JIS K-7142. For example, in a case in which the material of the first transparent adhesive layer 95 and the material of the second transparent adhesive layer 96 are acrylic-based resin (refractive index 1.49), the refractive index of the substrate 11 is 1.39 or more and 1.59 or less. Examples of such materials include fluororesins, silicone-based resins, polyolefin resins, polyester-based resins, acrylic-based resins, polycarbonate-based resins, polyimide-based resins, cellulose-based resins, and so forth.

Thus, by suppressing the difference in the refractive index between the substrate 11 and the first transparent adhesive layer 95 to 0.1 or less, reflection of visible light at an interface B1 between the substrate 11 and the first transparent adhesive layer 95 can be suppressed, and the substrate 11 can be made to be difficult to visually recognize by the bare eye of the observer. Also, by suppressing the difference in the refractive index between the second transparent adhesive layer 96 and the substrate 11 to 0.1 or less, reflection of visible light at an interface B2 between the second transparent adhesive layer 96 and the substrate 11 can be suppressed, and the substrate 11 can be made to be difficult to visually recognize by the bare eye of the observer. Further, by suppressing the difference in the refractive index between the first transparent adhesive layer 95 and the second transparent adhesive layer 96 to 0.1 or less, reflection of visible light at an interface B3 between the first transparent adhesive layer 95 and the second transparent adhesive layer 96 can be suppressed, and the first transparent adhesive layer 95 and the second transparent adhesive layer 96 can be made to be difficult to visually recognize by the bare eye of the observer.

In particular, the material of the first transparent adhesive layer 95 and the material of the second transparent adhesive layer 96 is preferably the same as each other. Accordingly, the difference in the refractive index between the first transparent adhesive layer 95 and the second transparent adhesive layer 96 can be further reduced, and reflection of visible light at the interface B3 of the first transparent adhesive layer 95 and the second transparent adhesive layer 96 can be suppressed.

Also, in Fig. 10, at least one thickness of thickness $T_3$ of the first transparent adhesive layer 95 and thickness $T_4$ of the second transparent adhesive layer 96 may be 2 times the thickness $T_1$ of the substrate 11 or more, and preferably is 2.5 times thereof or more. By making the thickness $T_3$ of the first transparent adhesive layer 95 or the thickness $T_4$ of the second transparent adhesive layer 96 to be sufficiently thick as to the thickness $T_1$ of the substrate 11 in this way, the first transparent adhesive layer 95 or the second transparent adhesive layer 96 deforms in the thickness direction in a region overlapping the substrate 11, and takes up the thickness of the substrate 11. Accordingly, stepped portions can be suppressed from being formed in the first transparent adhesive layer 95 or the second transparent adhesive layer 96 at the peripheral edge of the substrate 11, and the presence of the substrate 11 can be made to be difficult to be recognized by the observer.

Also, at least one thickness of the thickness $T_3$ of the first transparent adhesive layer 95 and the thickness $T_4$ of the second transparent adhesive layer 96 may be 10 times the thickness $T_1$ of the substrate 11 or less, and preferably is five times thereof or less. Accordingly, the thickness $T_3$ of the first transparent adhesive layer 95 or the thickness $T_4$ of the second transparent adhesive layer 96 does not become too thick, and the thickness of the overall image display device 60 can be reduced.

Also, in Fig. 10, the thickness $T_3$ of the first transparent adhesive layer 95 and the thickness $T_4$ of the second transparent adhesive layer 96 may be the same as each other. In this case, the thickness $T_3$ of the first transparent adhesive layer 95 and the thickness $T_4$ of the second transparent adhesive layer 96 may each be 1.5 times the thickness $T_1$ of the substrate 11 or more, and preferably 2.0 times thereof or more. That is to say, the total of the thickness $T_3$ of the first transparent adhesive layer 95 and the thickness $T_4$ of the second transparent adhesive layer 96 ($T_3 + T_4$) is three times the thickness $T_1$ of the substrate 11 or more. Thus, by making the total of thicknesses $T_3$ and $T_4$ of the first transparent adhesive layer 95 and the second transparent adhesive layer 96 to be sufficiently thick with respect to the thickness $T_1$ of the substrate 11, the first transparent adhesive layer 95 and the second transparent adhesive layer 96 deform in the thickness direction in the region overlapping the substrate 11, and take up the thickness of the substrate 11. Accordingly, stepped portions can be suppressed from being formed in the first transparent adhesive layer 95 or the second transparent adhesive layer 96 at the peripheral edge of the substrate 11, and the presence of the substrate 11 can be made to be difficult to be recognized by the observer.

Also, in a case in which the thickness $T_3$ of the first transparent adhesive layer 95 and the thickness $T_4$ of the second transparent adhesive layer 96 are the same as each other, the thickness $T_3$ of the first transparent adhesive layer 95 and the thickness $T_4$ of the second transparent adhesive layer 96 may each be five times the thickness $T_1$ of the substrate 11 or less, and preferably three times thereof or less. Accordingly, the thicknesses $T_3$ and $T_4$ of both of the first transparent adhesive layer 95 and the second transparent adhesive layer 96 do not become too thick, and the thickness of the overall image display device 60 can be reduced.

Specifically, the thickness $T_1$ of the substrate 11 may be 10 μm or more and 50 μm or less for example, and preferably is 15 μm or more and 25 μm or less. By making the thickness $T_1$ of the substrate 11 to be 10 μm or more,

strength of the wiring board 10 can be maintained, so that the first-direction wiring line 21 and the second-direction wiring line 22 of the mesh wiring layer 20 are not readily deformed. Also, by making the thickness $T_1$ of the substrate 11 to be 50 $\mu$m or less, stepped portions can be suppressed from being formed in the first transparent adhesive layer 95 and the second transparent adhesive layer 96 at the peripheral edge of the substrate 11, and the presence of the substrate 11 can be made to be difficult to be recognized by the observer.

The thickness $T_3$ of the first transparent adhesive layer 95 may be 15 $\mu$m or more and 500 $\mu$m or less for example, and preferably is 20 $\mu$m or more and 250 $\mu$m or less. The thickness $T_4$ of the second transparent adhesive layer 96 may be 15 $\mu$m or more and 500 $\mu$m or less for example, and preferably is 20 $\mu$m or more and 250 $\mu$m or less.

As described above, the image display device laminate 70 is made up of the wiring board 10, the first transparent adhesive layer 95 that has a broader area than that of the substrate 11 of the wiring board 10, and the second transparent adhesive layer 96 that has a broader area than that of the substrate 11. Such an image display device laminate 70 is also provided in the present implementation mode.

The cover glass (surface protective plate) 75 is directly or indirectly disposed on the second transparent adhesive layer 96. This cover glass 75 is a member made of glass that transmits light. The cover glass 75 is plate-like, and may have a rectangular shape in plan view. The thickness of the cover glass 75 may be 200 $\mu$m or more and 1000 $\mu$m or less for example, and preferably is 300 $\mu$m or more and 700 $\mu$m or less. The length of the cover glass 75 in the longitudinal direction (Y direction) may be 20 mm or more and 500 mm or less for example, and preferably 100 mm or more and 200 mm or less, and a length of the cover glass 75 in the lateral direction (X direction) may be 20 mm or more and 500 mm or less, and preferably 50 mm or more and 100 mm or less.

As illustrated in Fig. 9, the image display device 60 is generally rectangular overall in plan view, the longitudinal direction thereof is parallel to the Y direction, and the lateral direction thereof is parallel to the X direction. A length $L_4$ of the image display device 60 in the longitudinal direction (Y direction) can be selected from a range of 20 mm or more and 500 mm or less for example, and preferably 100 mm or more and 200 mm or less. A length $L_5$ of the substrate 11 in the lateral direction (X direction) can be selected from a range of 20 mm or more and 500 mm or less for example, and preferably 50 mm or more and 100 mm or less. Note that the corner portions of the image display device 60 each may be rounded.

[Configuration of Wiring Board]

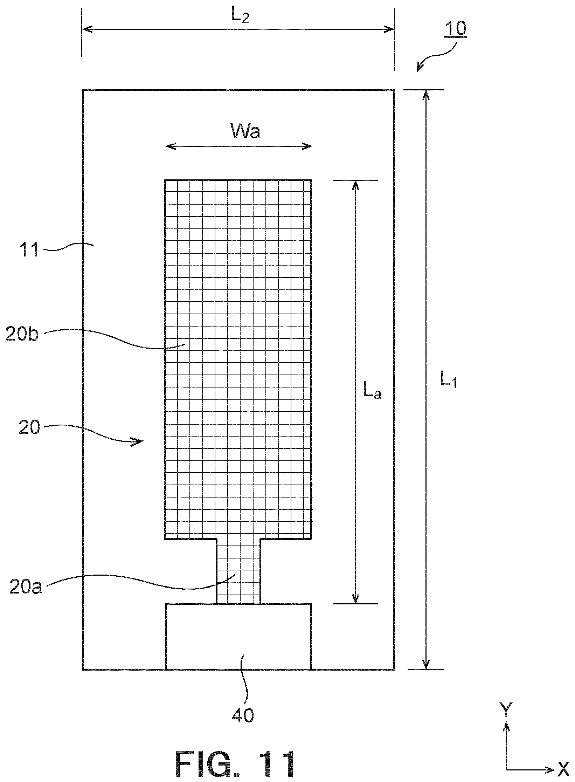

A configuration of the wiring board will be described next with reference to Fig. 11 to Fig. 14. Fig. 11 to Fig. 14 are diagrams illustrating the wiring board according to the present implementation mode.

As illustrated in Fig. 11, the wiring board 10 according to the present implementation mode is used in the image display device 60 described above (see Fig. 9 and Fig. 10), and is disposed between the first transparent adhesive layer 95 and the second transparent adhesive layer 96 closer to the light-emitting face 64 side than the display device 61. Such a wiring board 10 includes the substrate 11 that has transparency and the mesh wiring layer 20 disposed on the substrate 11. Also, the power supply unit 40 is electrically connected to the mesh wiring layer 20.

The material of the substrate 11 is a material that has transparency in the visible light domain, and electrical insulating properties. A material of which the difference in refractive index as to the first transparent adhesive layer 95 is 0.1 or less, and of which the difference in refractive index as to the second transparent adhesive layer 96 is 0.1 or less, as described above, is used for the substrate 11. In this case as well, the material that is the same as in the first embodiment can be used as the material for the substrate 11.

In the present implementation mode, the mesh wiring layer 20 is made up of an antenna pattern having functions as an antenna. In Fig. 11, one mesh wiring layer 20 is formed on the substrate 11. This mesh wiring layer 20 corresponds to a predetermined frequency band. That is to say, the length (length in the Y direction) $L_a$ of the mesh wiring layer 20 is a length corresponding to the particular frequency band. Note that a plurality of mesh wiring layers 20 may be formed on the substrate 11. In this case, the lengths of the plurality of mesh wiring layers 20 may differ from each other, and may each correspond to different frequency bands.

The mesh wiring layer 20 has a basal end side portion 20a on the power supply unit 40 side, and a distal end side portion 20b that is connected to the basal end side portion 20a. The basal end side portion 20a and the distal end side portion 20b each have generally rectangular shapes in plan view. In this case, the length (distance in Y direction) of the distal end side portion 20b is longer than the length (distance in Y direction) of the basal end side portion 20a, and the width (distance in X direction) of the distal end side portion 20b is broader than the width (distance in X direction) of the basal end side portion 20a. Note that in the present implementation mode, a width $W_a$ in the lateral direction (X direction) of the mesh wiring layer 20 may be the width of the distal end side portion 20b in the lateral direction (X direction).

Note that while Fig. 11 illustrates a form of a case in which the mesh wiring layer 20 functions as a monopole antenna, but this is not restrictive, and forms may be used such as a dipole antenna, a loop antenna, a slot antenna, a microstrip antenna, a patch antenna, and so forth.

The mesh wiring layer 20 is formed with the respective metal lines being formed in a grid-like or fishnet-like form, having a repetitive pattern in the X direction and the Y direction. That is to say, the mesh wiring layer 20 has a pattern form that is made up of portions extending in the X direction (second-direction wiring lines 22) and portions extending in the Y direction (first-direction wiring lines 21).

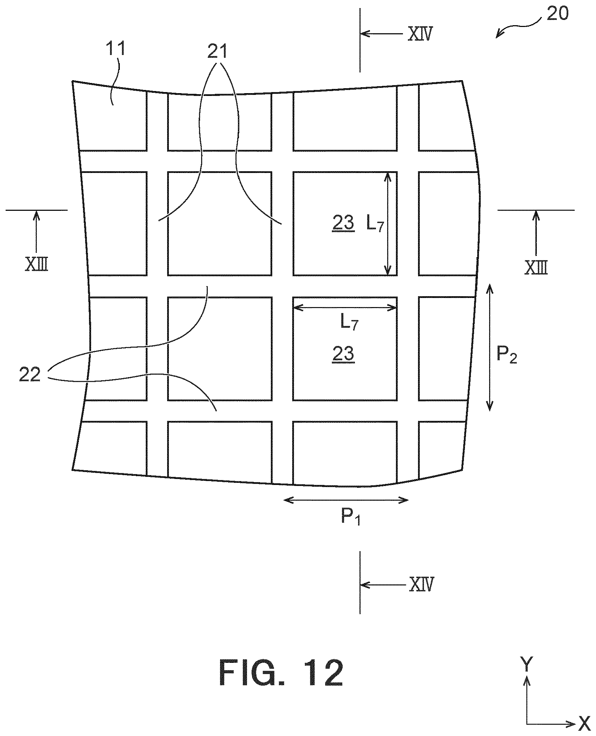

As illustrated in Fig. 12, the mesh wiring layer 20 includes a plurality of first-direction wiring lines (antenna wiring lines (wiring lines)) 21 having functions as an antenna, and a plurality of second-direction wiring lines (antenna interconnection wiring lines (wiring lines)) 22 interconnecting the plurality of first-direction wiring lines 21. Specifically, the plurality of first-direction wiring lines 21 and the plurality of second-direction wiring lines 22 overall and integrally form a regular grid-like or fishnet-like form. The first-direction wiring lines 21 each extend in a direction corresponding to the frequency band of the antenna (longitudinal direction, Y direction), and the second-direction wiring lines 22 extend in a direction that is orthogonal to the first-direction wiring lines 21(width direction, X direction). By having the length $L_a$ corresponding to a predetermined frequency (the length of the mesh wiring layer 20 described above, see Fig. 11), the first-direction wiring lines 21 exhibit functions primarily as an antenna. On the other hand, the second-direction wiring lines 22 interconnect these first-direction wiring lines 21 to each other, and thereby serve to suppress trouble in which the first-direction wiring lines 21 are disconnected, or the first-direction wiring lines 21 and the power supply unit 40 lose electrical connection.

As described above, in the mesh wiring layers 20, a plurality of openings 23 are formed by being surrounded by first-direction wiring lines 21 adjacent to each other and second-direction wiring lines 22 adjacent to each other. Also, the first-direction wiring lines 21 and the second-direction wiring lines 22 are disposed equidistantly to each other. That is to say, the plurality of first-direction wiring lines 21 are disposed equidistantly to each other, and the pitch $P_1$ thereof can be in a range of 0.01 mm or more and 1 mm or less, for example. Also, the plurality of second-direction wiring lines 22 are disposed equidistantly to each other, and the pitch $P_2$ thereof can be in a range of 0.01 mm or more and 1 mm or more, for example. In this way, due to the plurality of first-direction wiring lines 21 and the plurality of second-direction wiring lines 22 being each disposed equidistantly, variance in the size of the openings 23 in the mesh wiring layer 20 is eliminated, and the mesh wiring layer 20 can be made to be difficult to visually recognize by the bare eye. Also, the pitch $P_1$ of the first-direction wiring lines 21 is equal to the pitch $P_2$ of the second-direction wiring lines 22. Accordingly, in the present implementation mode, the openings 23 each have a generally square shape in plan view, and the substrate 11 that has transparency is exposed from each of the openings 23. Thus, the transparency of the wiring board 10 overall can be increased by increasing the area of the openings 23. Note that a length $L_7$ of each side the openings 23 can be in a range of 0.01 mm or more and 1 mm or less, for example. Note that the first-direction wiring lines 21 and the second-direction wiring line 22 are orthogonal to each other, but this is not restrictive, and may intersect each other at acute angles or obtuse angles. Note that the angle formed between the first-direction wiring lines 21 and the second-direction wiring lines 22 is preferably 30° or larger and 150° or smaller. Accordingly, the first-direction wiring lines 21 and the second-direction wiring lines 22 can be formed more readily when forming the mesh wiring layer 20. Also, the shapes of the openings 23 preferably are the same shape and the same size over the entire area, but do not have to be uniform over the entire area, with changes being made thereto depending on the location or the like.

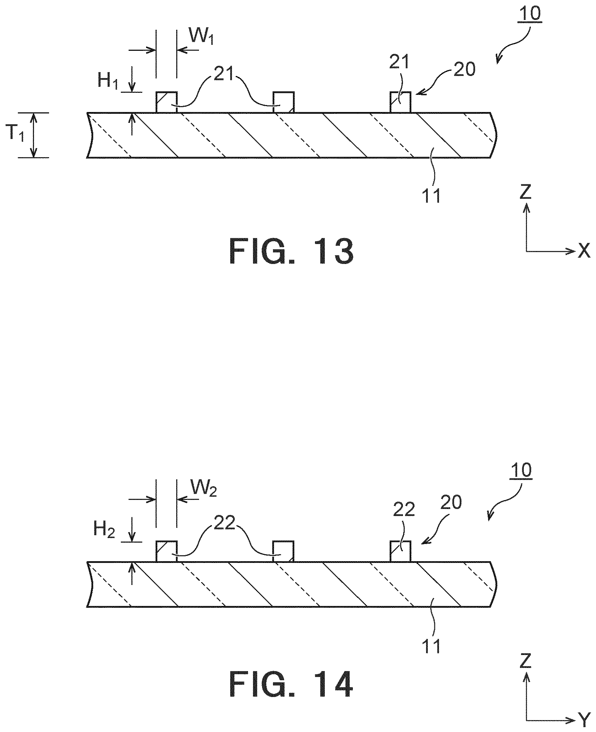

As illustrated in Fig. 13, the cross-section of each first-direction wiring line 21 perpendicular to the longitudinal direction (X direction cross-section) is a generally rectangular shape or a generally square shape. In this case, the cross-sectional shape of the first-direction wiring lines 21 is generally uniform along the longitudinal direction (Y direction) of the first-direction wiring lines 21. Also, as illustrated in Fig. 14, the shape of the cross-section of each second-direction wiring line 22 perpendicular to the longitudinal direction (Y direction cross-section) is a generally rectangular shape or a generally square shape, and is generally the same as the cross-sectional shape of the first-direction wiring lines 21 described above (X direction cross-section). In this case, the cross-sectional shape of the second-direction wiring lines 22 is generally uniform in the longitudinal direction (X direction) of the second-direction wiring lines 22.

In the present implementation mode as well, the line width $W_1$ (length in X direction, see Fig. 13) of the first-direction wiring lines 21 and the line width $W_2$ (length in Y direction, see Fig. 14) of the second-direction wiring lines 22 are not limited in particular, and can be selected as appropriate in accordance with the usage. For example, the line width $W_1$ of the first-direction wiring lines 21 can be selected from a range of 0.1 $\mu$m or more and 5.0 $\mu$m or less, and preferably is 0.2 $\mu$m or more and 2.0 $\mu$m or less. Also, the line width $W_2$ of the second-direction wiring lines 22 can be selected from a range of 0.1 $\mu$m or more and 5.0 $\mu$m or less, and preferably is 0.2 $\mu$m or more and 2.0 $\mu$m or less. Further, the height $H_1$ (length in Z direction, see Fig. 13) of the first-direction wiring lines 21 and the height $H_2$ (length in Z direction, see Fig. 14) of the second-direction wiring lines 22 are not limited in particular, and can be selected as appropriate in accordance with usage. The height $H_1$ of the first-direction wiring line 21 and the height $H_2$ of the second-direction wiring line 22 can each be selected from a range of 0.1 $\mu$m or more and 5.0 $\mu$m or less for example, and preferably is 0.2 $\mu$m or more and 2.0 $\mu$m or less.

Referencing Fig. 11 again, the power supply unit 40 is electrically connected to the mesh wiring layer 20. When the wiring board 10 is assembled into the image display device 60 (see Fig. 9 and Fig. 10), this power supply unit 40 is electrically connected to the communication module 63 of the image display device 60. Note that while the power supply unit 40 is provided on the front face of the substrate 11, this is not restrictive, and part or all of the power supply unit 40 may be situated on the outer side from the peripheral edge of the substrate 11. Also, the power supply unit 40 may be formed flexibly, such that the power supply unit 40 can run around to the side face and the rear face of the image display device 60 for electrical connection on the side face and the rear face.

[Method for Manufacturing Wiring Board]

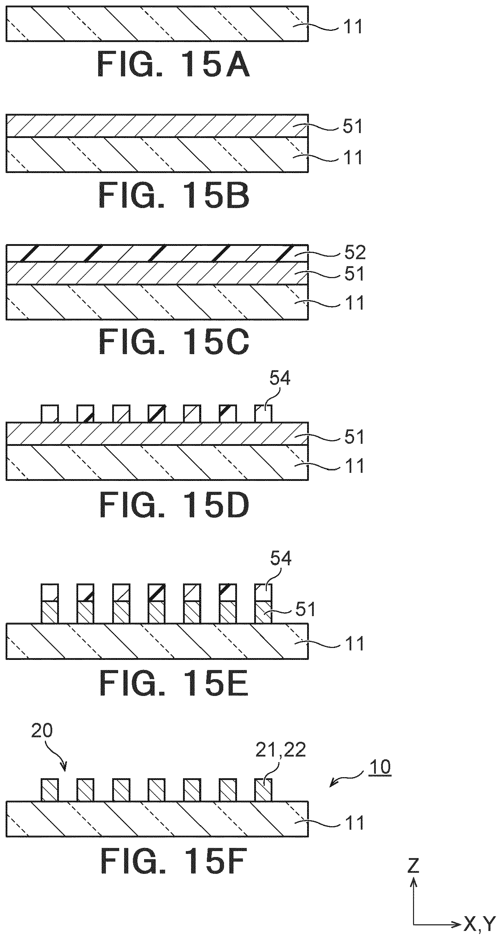

Next, a method for manufacturing the wiring board according to the present implementation mode will be described with reference to Fig. 15A to Fig. 15F. Fig. 15A to Fig. 15F are cross-sectional views illustrating the method for manufacturing the wiring board according to the present implementation mode.

As illustrated in Fig. 15A, the substrate 11 that has transparency is prepared.

Next, the mesh wiring layer 20 including the plurality of first-direction wiring lines 21, and the plurality of second-direction wiring lines 22 interconnecting the plurality of first-direction wiring lines 21 is formed on the substrate 11.

At this time, first, as illustrated in Fig. 15B, the metal foil 51 is laminated on generally the entire region of the surface of the substrate 11. The thickness of the metal foil 51 in the present implementation mode may be 0.1 $\mu$m or more and 5.0 $\mu$m or less. The metal foil 51 in the present implementation mode may contain copper.

Next, as illustrated in Fig. 15C, the photo-curing insulating resist 52 is supplied to generally the entire region of the surface of the metal foil 51. Examples of this photo-curing insulating resist 52 include organic resins such as acrylic resins, epoxy-based resins, and so forth.

Next, as illustrated in Fig. 15D, the insulating layer 54 is formed by photolithography. In this case, the photo-curing insulating resist 52 is patterned by photolithography, thereby forming the insulating layer 54 (resist pattern). At this time, the insulating layer 54 is formed such that the metal foil 51 corresponding to the first-direction wiring lines 21 and the second-direction wiring lines 22 is exposed.

Next, as illustrated in Fig. 15E, the metal foil 51 situated at portions on the surface of the substrate 11 not covered by the insulating layer 54 is removed. At this time, the metal foil 51 is etched such that the surface of the substrate 11 is exposed, by performing wet processing using such as ferric chloride, cupric chloride, strong acids such as sulfuric acid, hydrochloric acid, or the like, persulfate, hydrogen peroxide, or aqueous solutions thereof, or combinations of the above, or the like.

Next, as illustrated in Fig. 15F, the insulating layer 54 is removed. At this time, the insulating layer 54 on the metal foil 51 is removed by performing wet processing using a permanganate solution, N-methyl-2-pyrrolidone, acid or alkali solutions, or the like, or dry processing using oxygen plasma.

Thus, the wiring board 10 that has the substrate 11, and the mesh wiring layer 20 provided on the substrate 11, is obtained. In this case, the mesh wiring layer 20 includes the first-direction wiring lines 21 and the second-direction wiring lines 22.

[Effects of Present Implementation Mode]

Next, the effects of the present implementation mode having such a configuration will be described.

As illustrated in Fig. 9 and Fig. 10, the wiring board 10 is assembled into the image display device 60 that has the display device 61. At this time, the wiring board 10 is disposed above the display device 61. The mesh wiring layer 20 of the wiring board 10 is electrically connected to the communication module 63 of the image display device 60 via the power supply unit 40. In this way, radio waves of the predetermined frequency can be transmitted/received via the mesh wiring layer 20, and communication can be performed by using the image display device 60.

According to the present implementation mode, a partial region of the substrate 11 is disposed in a partial region between the first transparent adhesive layer 95 and the second transparent adhesive layer 96. Also, the difference in refractive index between the substrate 11 and the first transparent adhesive layer 95 is 0.1 or less, the difference in refractive index between the second transparent adhesive layer 96 and the substrate 11 is 0.1 or less, and the difference in refractive index between the first transparent adhesive layer 95 and the second transparent adhesive layer 96 is 0.1 or less. Thus, reflection of visible light at the interface B1 between the substrate 11 and the first transparent adhesive layer 95, the interface B2 between the second transparent adhesive layer 96 and the substrate 11, and the interface B3 between the first transparent adhesive layer 95 and the second transparent adhesive layer 96, can be suppressed. Accordingly, when an observer observes the image display device 60 from the light-emitting face 64 side, the substrate 11 of the wiring board 10 can be made to be difficult to visually recognize by the bare eye of the observer. In particular, in a case in which the first transparent adhesive layer 95 and the second transparent adhesive layer 96 each have an area that is broader than that of the substrate 11, the outer edge of the substrate 11 can be made to be difficult to be visually recognized by the bare eye of the observer, and the observer can be kept from recognizing the presence of the substrate 11.

Also, according to the present implementation mode, at least one thickness of the thickness $T_3$ of the first transparent adhesive layer 95 and the thickness $T_4$ of the second transparent adhesive layer 96 may be 2 times the

thickness $T_1$ of the substrate 11 or more. Alternatively, the thickness $T_3$ of the first transparent adhesive layer 95 and the thickness $T_4$ of the second transparent adhesive layer 96 may be the same as each other, and the thickness $T_3$ of the first transparent adhesive layer 95 and the thickness $T_4$ of the second transparent adhesive layer 96 may each be 1.5 times the thickness $T_1$ of the substrate 11 or more. Thus, the first transparent adhesive layer 95 and the second transparent adhesive layer 96 shrink in the thickness direction and take up the thickness of the substrate 11, and accordingly, stepped portions can be suppressed from being formed at positions in the first transparent adhesive layer 95 or the second transparent adhesive layer 96 corresponding to the outer edge of the substrate 11. Thus, the outer edge of the substrate 11 can be made to be difficult to be visually recognized by the bare eye of the observer, and the observer can be kept from recognizing the presence of the substrate 11.

Also, according to the present implementation mode, the material of the first transparent adhesive layer 95 and the material of the second transparent adhesive layer 96 may be the same as each other. Also, the material of the first transparent adhesive layer 95 and the material of the second transparent adhesive layer 96 may each be an acrylic-based resin. Accordingly, the difference in refractive index between the first transparent adhesive layer 95 and the second transparent adhesive layer 96 can be substantially done away with, and the reflection of visible light at the interface B3 of the first transparent adhesive layer 95 and the second transparent adhesive layer 96 can be suppressed in a surer manner.

Also, according to the present implementation mode, the wiring board 10 includes the substrate 11 that has transparency, and the mesh wiring layer 20 disposed on the substrate 11. This mesh wiring layer 20 has a conductor portion serving as a formation portion of a non-transparent conductor layer, and a mesh-like pattern with a great number of openings, and thus the transparency of the wiring board 10 is secured. Accordingly, when the wiring board 10 is disposed on the display device 61, the display device 61 can be visually recognized from the openings 23 of the mesh wiring layer 20, and visual recognition of the display device 61 is not impeded.

[Modifications]

Next, modifications of the wiring board according to the present implementation mode will be described.

(First Modification)

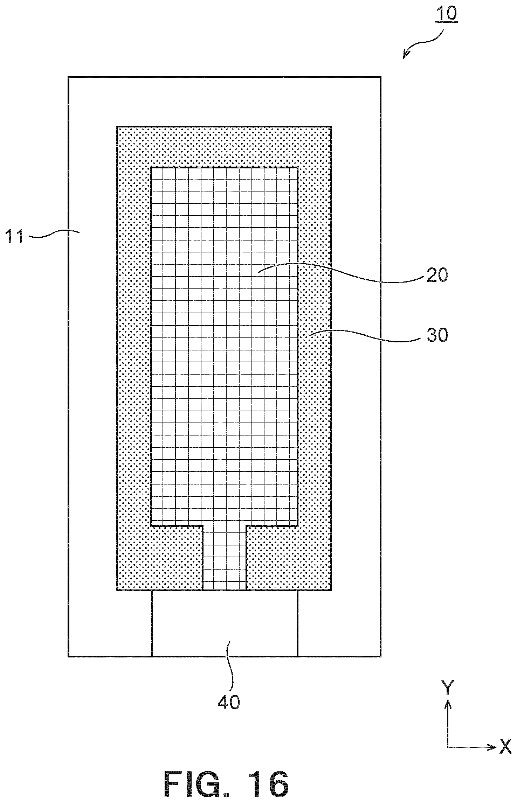

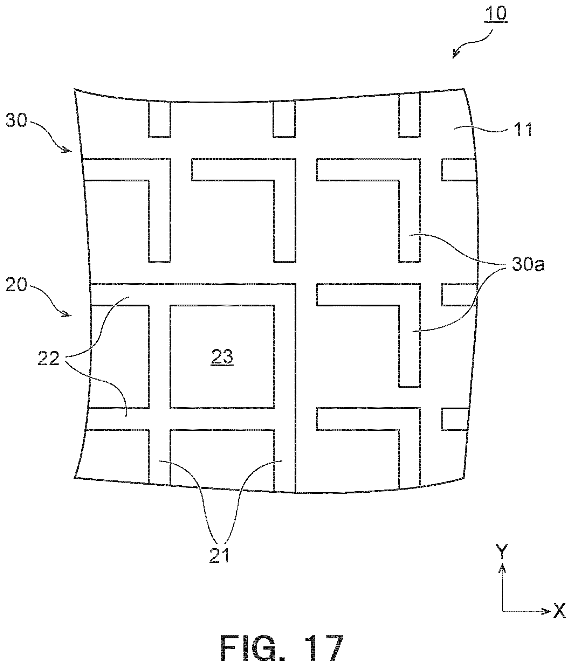

Fig. 16 and Fig. 17 illustrate a first modification of the wiring board. The modification illustrated in Fig. 16 and Fig. 17 differs with respect to the point of the dummy wiring layer 30 being provided around the mesh wiring layer 20, and other configurations are generally the same as the implementation mode described above, which is illustrated in Fig. 9 to Fig. 15F. In Fig. 16 and Fig. 17, portions that are the same as in the implementation mode illustrated in Fig. 9 to Fig. 15F are denoted by the same signs, and detailed description will be omitted.

In the wiring board 10 illustrated in Fig. 16, the dummy wiring layer 30 is provided so as to follow around the mesh wiring layer 20. Unlike the mesh wiring layer 20, this dummy wiring layer 30 does not substantially function as an antenna.

As illustrated in Fig. 17, the dummy wiring layer 30 is made up of a repetition of the dummy wiring lines 30a having a predetermined unit pattern shape. That is to say, the dummy wiring layer 30 includes a plurality of dummy wiring lines 30a of the same shape, and each dummy wiring line 30a is electrically isolated from each of the mesh wiring layers 20 (first-direction wiring lines 21 and second-direction wiring lines 22). Also, the dummy wiring lines 30a are regularly disposed over the entire region within the dummy wiring layer 30. The plurality of dummy wiring lines 30a are distanced from each other in a planar direction, and are also disposed so as to protrude on the substrate 11. That is to say, each dummy wiring line 30a is electrically isolated from the mesh wiring layer 20, the power supply unit 40, and other dummy wiring lines 30a. The dummy wiring lines 30a are each generally L-shaped in plan view.

In this case, the dummy wiring lines 30a have a shape in which part of the unit pattern shape of the mesh wiring layer 20 described above (see Fig. 12) is missing. Thus, difference between the mesh wiring layer 20 and the dummy wiring layer 30 can be made to be difficult to visually recognize, and the mesh wiring layer 20 disposed on the substrate 11 can be made to be difficult to see. An aperture ratio of the dummy wiring layer 30 may be the same as the aperture ratio of the mesh wiring layer 20, or may be different, but preferably is near the aperture ratio of the mesh wiring layer 20.

Thus, by disposing the dummy wiring layer 30 that is electrically isolated from the mesh wiring layer 20 around the mesh wiring layer 20, an outer edge of the mesh wiring layer 20 can be made obscure. Accordingly, the mesh wiring layer 20 can be made difficult to see on a front face of the image display device 60, and the mesh wiring layer 20 can be made to be difficult to recognize by the bare eye of the user of the image display device 60.

(Second Modification)

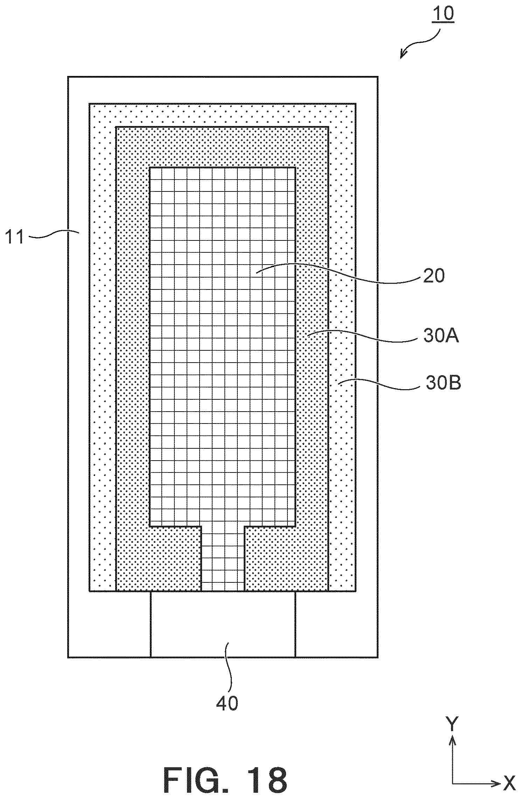

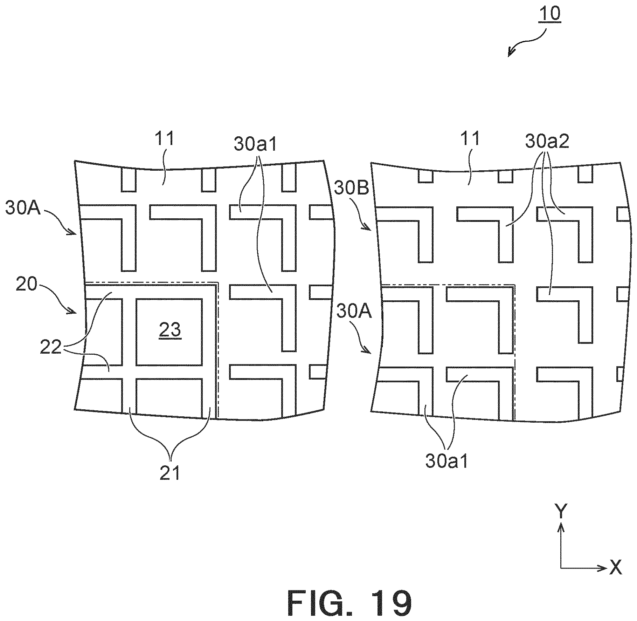

Fig. 18 and Fig. 19 illustrate a second modification of the wiring board. The modification illustrated in Fig. 18 and Fig. 19 differs with respect to the point that a plurality of dummy wiring layers 30A and 30B that have different aperture ratios from each other are provided around the mesh wiring layer 20, and other configurations are generally the same as the implementation mode illustrated in Fig. 9 to Fig. 17 described above. In Fig. 18 and Fig. 19, portions that are the same as in the implementation mode illustrated in Fig. 9 to Fig. 17 are denoted by the same signs, and detailed description will be omitted.

In the wiring board 10 illustrated in Fig. 18, the plurality of (two in this case) of dummy wiring layers 30A and 30B (first dummy wiring layer 30A and second dummy wiring layer 30B) that have different aperture ratios from each other are provided so as to follow around the mesh wiring layer 20. Specifically, the first dummy wiring layer 30A is disposed so as to follow around the mesh wiring layer 20, and the second dummy wiring layer 30B is disposed so as to follow around the first dummy wiring layer 30A. Unlike the mesh wiring layer 20, these dummy wiring layers 30A and 30B do not substantially function as an antenna.

As illustrated in Fig. 19, the first dummy wiring layer 30A is made up of a repetition of dummy wiring lines 30a1 that have a predetermined unit pattern form. Also, the second dummy wiring layer 30B is made up of a repetition of dummy wiring lines 30a2 that have a predetermined unit pattern form. That is to say, the dummy wiring layers 30A and 30B include a plurality of dummy wiring lines 30a1 and 30a2 of the same shapes, respectively, and each of the dummy wiring lines 30a1 and 30a2 is electrically isolated from the mesh wiring layer 20. Also, each of the dummy wiring lines 30a1 and 30a2 is regularly disposed over the entire region of the respective dummy wiring layers 30A and 30B. The dummy wiring lines 30a1 and 30a2 are each distanced from each other in the planar direction, and are also disposed so as to protrude on the substrate 11. The dummy wiring lines 30a1 and 30a2 are each electrically isolated from the mesh wiring layer 20, the power supply unit 40, and other dummy wiring lines 30a1 and 30a2. Also, the dummy wiring lines 30a1 and 30a2 are each generally L-shaped in plan view.

In this case, the dummy wiring lines 30a1 and 30a2 have shapes in which part of the unit pattern shape of the mesh wiring layer 20 described above (see Fig. 12) is missing. Thus, difference between the mesh wiring layer 20 and the first dummy wiring layer 30A, and difference between the first dummy wiring layer 30A and the second dummy wiring layer 30B can be made to be difficult to visually recognize, and the mesh wiring layer 20 disposed on the substrate 11 can be made to be difficult to see. The aperture ratio of the first dummy wiring layer 30A is larger than the aperture ratio of the mesh wiring layer 20, and the aperture ratio of the first dummy wiring layer 30A is larger than the aperture ratio of the second dummy wiring layer 30B.

Note that the area of each dummy wiring line 30a1 of the first dummy wiring layer 30A is larger than the area of each dummy wiring line 30a2 of the second dummy wiring layer 30B. In this case, the line width of each dummy wiring line 30a1 is the same as the line width of each dummy wiring line 30a2, but this is not restrictive, and the line width of each dummy wiring line 30a1 may be wider than the line width of each dummy wiring line 30a2. Also, three or more dummy wiring layers with aperture ratios different from each other may be provided. In this case, the aperture ratio of each dummy wiring layer preferably gradually increases from those close to the mesh wiring layer 20 toward those far away.

Thus, by disposing the dummy wiring layers 30A and 30B that are electrically isolated from the mesh wiring layer 20, the outer edge of the mesh wiring layer 20 can be made obscure. Accordingly, the mesh wiring layer 20 can be made difficult to see on the front face of the image display device 60, and the mesh wiring layer 20 can be made to be difficult to recognize by the bare eye of the user of the image display device 60.

(Third Modification)

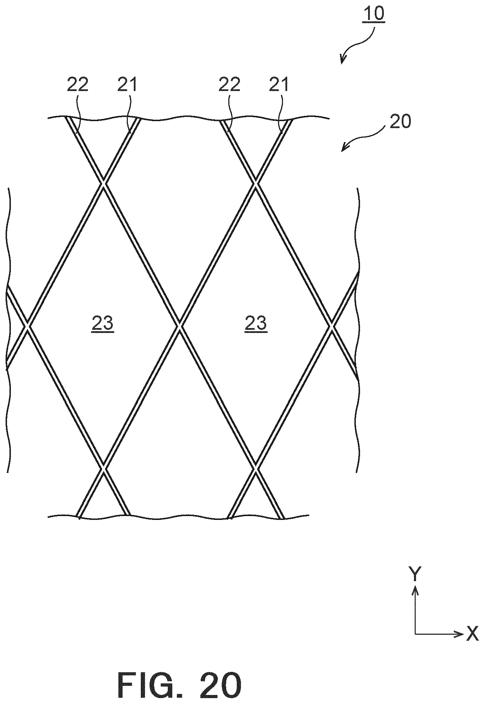

Fig. 20 illustrates a third modification of the wiring board. The modification illustrated in Fig. 20 differs in the planar form of the mesh wiring layer 20, and other configurations are generally the same as the implementation mode illustrated in Fig. 9 to Fig. 19 described above. In Fig. 20, portions that are the same as in the implementation mode illustrated in Fig. 9 to Fig. 19 are denoted by the same signs, and detailed description will be omitted.

Fig. 20 is an enlarged plan view illustrating the mesh wiring layer 20 according to a modification. In Fig. 20, the first-direction wiring lines 21 and the second-direction wiring lines 22 intersect obliquely (non-orthogonally), and each opening 23 is formed as a rhombus shape in plan view. The first-direction wiring lines 21 and the second-direction wiring lines 22 are each not parallel to either of the X direction and the Y direction, but one of the first-direction wiring lines 21 and the second-direction wiring lines 22 may be parallel to the X direction or the Y direction.

(Fourth Modification)

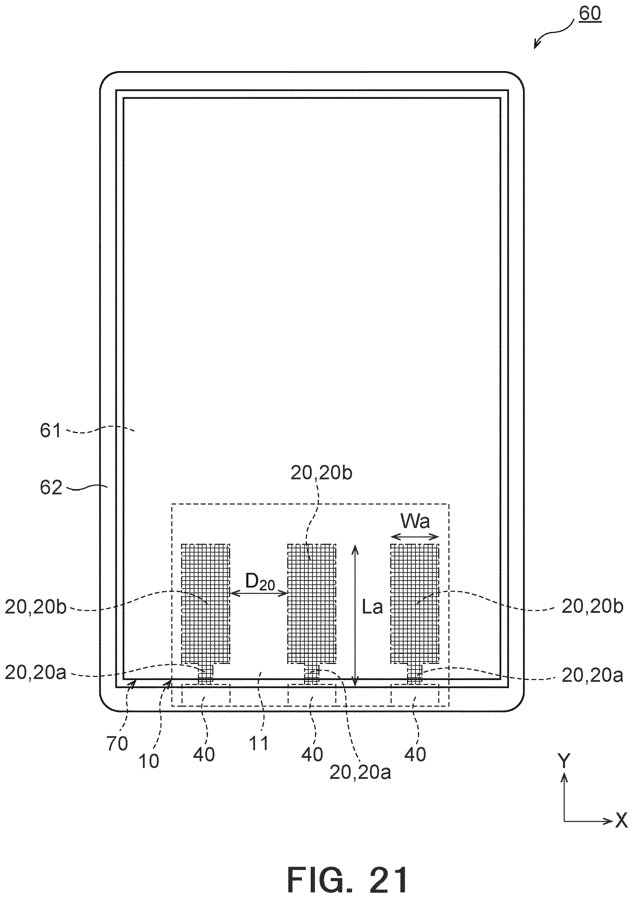

Fig. 21 illustrates a fourth modification of the wiring board. The modification illustrated in Fig. 21 differs with respect to the point that the mesh wiring layer 20 is configured as an array antenna, and other configurations are generally the same as the implementation mode illustrated in Fig. 9 to Fig. 20 described above. In Fig. 21, portions that are the same as in the implementation mode illustrated in Fig. 9 to Fig. 20 are denoted by the same signs, and detailed description will be omitted.

Fig. 21 is a plan view illustrating an image display device 60 according to a modification. In Fig. 21, the mesh wiring layer 20 is configured as an array antenna. In a case in configuring the mesh wiring layer 20 as an array antenna in this way, millimeter wave antenna performance of transmitting/receiving millimeter waves that have high straight-line propagation properties can be improved.

Two or more mesh wiring layers 20 are preferably formed on the substrate 11, and four or more are preferably formed on the substrate 11. In the example that is illustrated, three mesh wiring layers 20 are formed on the substrate 11 (see Fig. 21).

A distance $D_{20b}$ (see Fig. 21) between distal end side portions 20b preferably is 1 mm or more and 5 mm or less. Due to the distance $D_{20b}$ between the distal end side portions 20b being 1 mm or more, unintentional interference of electromagnetic waves between the antenna elements can be suppressed. Due to the distance $D_{20b}$ between the distal end side portions 20b being 5 mm or less, the size of the overall array antenna made up of the mesh wiring layers 20 can be reduced. For example, in a case in which the mesh wiring layers 20 are a millimeter wave antenna for 28 GHz, the distance $D_{20b}$ between the distal end side portions 20b may be 3.5 mm. Also, in a case in which the mesh wiring layers 20 are a millimeter wave antenna for 60 GHz, the distance $D_{20b}$ between the distal end side portions 20b may be 1.6 mm.

<Second Implementation Mode>

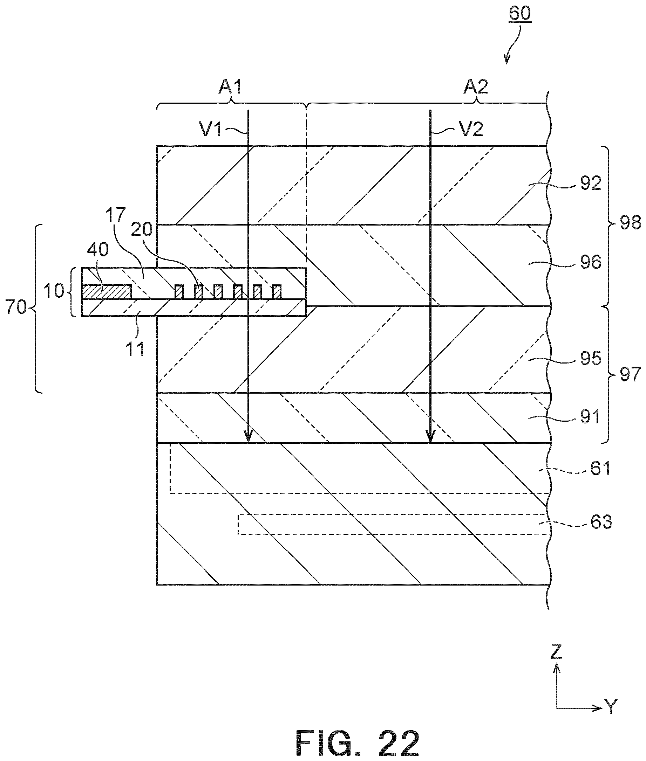

Next, a second implementation mode of the second embodiment will be described with reference to Fig. 22. Fig. 22 is a cross-sectional view illustrating an image display device according to the second implementation mode of the second embodiment. In Fig. 22, portions that are the same as in the first embodiment illustrated in Fig. 1 to Fig. 8, or the first implementation mode of the second embodiment illustrated in Fig. 9 to Fig. 21 are denoted with the same signs, and detailed description may be omitted.

As illustrated in Fig. 22, the image display device 60 according to the present implementation mode includes the image display device laminate 70, and the display device (display) 61. Of these, the image display device laminate 70 has a first dielectric layer 97, a second dielectric layer 98, and the wiring board 10. The wiring board 10 has the substrate 11, the mesh wiring layer 20, and a protective layer 17.

The protective layer 17 is formed on the front face of the substrate 11 so as to cover the mesh wiring layer 20. The protective layer 17 protects the mesh wiring layer 20. The protective layer 17 may cover the entire region of the mesh wiring layer 20 and the entire region of the power supply unit 40. In this case, the protective layer 17 is formed on the entire region of the substrate 11. Specifically, the protective layer 17 is formed on generally the entire region of the substrate 11 in the width direction (X direction) and the longitudinal direction (Y direction). Note that this is not restrictive, and the protective layer 17 may be provided only on a partial region of the substrate 11. For example, the protective layer 17 may be formed only on a partial region in the width direction of the substrate 11.

Acrylic resins such as polymethyl (meth) acrylate, polyethyl (meth) acrylate, and so forth, and denatured resins and copolymers thereof, polyvinyl resins such as polyester, polyvinyl alcohol, polyvinyl acetate, polyvinyl acetal, polyvinyl butyral, and so forth, and copolymers thereof, polyurethane, epoxy resin, polyamide, chlorinated polyolefin, and so forth, and like insulating resins that are colorless and transparent, can be used as the material of the protective layer 17, for example. Also, the thickness of the protective layer 17 may be 0.3 $\mu$m or more and 10 $\mu$m or less.

A primer layer that is not illustrated (e.g., the primer layer 15 illustrated in Fig. 3 and Fig. 4) may be formed between the substrate 11 and the mesh wiring layer 20. The primer layer improves adhesion between the mesh wiring layer 20 and the substrate 11. The primer layer may be provided on generally the entire region of the front face of the substrate 11. The primer layer may be colorless and transparent. Also, the primer layer may contain a polymer material. Accordingly, the adhesion between the mesh wiring layer 20 and the substrate 11 can be effectively improved. The primer layer preferably contains an acrylic-based resin or a polyester-based resin. Accordingly, the adhesion as to the mesh wiring layer 20 can be effectively improved. The thickness of the primer layer may be 0.05 $\mu$m or more and 0.5 $\mu$m or less. Having the thickness of the primer layer in the above range enables adhesion of the mesh wiring layer 20 and the substrate 11 to be improved, and also transparency of the wiring board 10 to be secured. In a case in which the primer layer that is not illustrated is formed between the substrate 11 and the mesh wiring layer 20, the difference in refractive index between a laminate made up of the substrate 11 and the primer layer 15, and the substrate 11, is 0.1 or less, and preferably is 0.05 or less. Accordingly, reflection of visible light at an interface of the substrate 11 and the primer layer can be suppressed, and the substrate 11 can be made to be difficult to visually recognize by the bare eye of the observer.

Other configurations of the wiring board 10 may be the same configurations as in the case of the first implementation mode described above.

The wiring board 10 is disposed between the first dielectric layer 97 and the second dielectric layer 98. More specifically, a partial region of the wiring board 10 is disposed in a partial region between the first dielectric layer 97 and the second dielectric layer 98. In this case, each of the first dielectric layer 97 and the second dielectric layer 98 has a broader area than the substrate 11 of the wiring board 10.

The entire first dielectric layer 97 is made of a dielectric substance. The first dielectric layer 97 has the first transparent adhesive layer 95 and a first base material layer 91. Of these, the first transparent adhesive layer 95 may have the same configuration as in the case of the first implementation mode described above.

The first base material layer 91 may be situated between the display device 61 and the first transparent adhesive layer 95. Alternatively, the first base material layer 91 may make up part of the display device 61. The first base material layer 91 has transparency in the visible light domain, and electric insulating properties. An organic insulating material such as, for example, a cycloolefin polymer (e.g., ZF-16 manufactured by Zeon Corporation), a polynorbornene polymer (manufactured by Sumitomo Bakelite Co. Ltd.), or the like may be used as the material of the first base material layer 91. Also, depending on the usage, glass, ceramic, or the like can be selected as appropriate for the material of the first base material layer 91. Note that the first dielectric layer 97 does not have to include the first base material layer 91. For example, the first dielectric layer 97 may include the first transparent adhesive layer 95 alone.

The entire second dielectric layer 98 is made of a dielectric substance. The second dielectric layer 98 has the second transparent adhesive layer 96 and a second base material layer 92. Of these, the second transparent adhesive layer 96 may have the same configuration as in the case of the first implementation mode described above.

The second base material layer 92 is directly or indirectly disposed on the second transparent adhesive layer 96. The second base material layer 92 has transparency in the visible light domain, and electric insulating properties. An organic insulating material such as, for example, a cycloolefin polymer (e.g., ZF-16 manufactured by Zeon Corporation), a polynorbornene polymer (manufactured by Sumitomo Bakelite Co. Ltd.), or the like may be used as the material of the second base material layer 92. Also, depending on the usage, glass, ceramic, or the like can be selected as appropriate for the material of the second base material layer 92. The above-described cover glass 75 may be used as the second base material layer 92. Note that the second dielectric layer 98 does not have to include the second base material layer 92. For example, the second dielectric layer 98 may include the second transparent adhesive layer 96 alone.

In the present implementation mode, a region of the image display device laminate 70 where all of the wiring board 10, the first dielectric layer 97, and the second dielectric layer 98 are present is a first region A1. When viewing the image display device laminate 70 from the direction of the normal of the light-emitting face 64, the first region A1 is a region in which the wiring board 10, the first dielectric layer 97, and the second dielectric layer 98 are present, being stacked together. Also, a region of the image display device laminate 70 where the first dielectric layer 97 and the second dielectric layer 98 are present but the wiring board 10 is not present is a second region A2. When viewing the image display device laminate 70 from the direction of the normal of the light-emitting face 64, the second region A2 is a region in which the first dielectric layer 97 and the second dielectric layer 98 are present, being stacked together, and the wiring board 10 is not present.

In Fig. 22, visible light rays that are transmitted through the first region A1 are denoted by sign V1. In the present implementation mode, the visible light rays V1 are transmitted through the second base material layer 92, the second transparent adhesive layer 96, the protective layer 17, the substrate 11, the first transparent adhesive layer 95, and the first base material layer 91. Note that in a case in which a primer layer is present between the protective layer 17 and the substrate 11, the visible light rays V1 is transmitted through the primer layer as well. Also, in Fig. 22, visible light rays that are transmitted through the second region A2 are denoted by sign V2. In the present implementation mode, the visible light rays V2 are transmitted through the second base material layer 92, the second transparent adhesive layer 96, the first transparent adhesive layer 95, and the first base material layer 91.

In this case, transmittance of the image display device laminate 70 regarding visible light rays in the first region A1 will be referred to as first transmittance $t1$. For example, in Fig. 22, transmittance of the visible light rays V1 is the first transmittance $t1$. Note that the first transmittance $t1$ is measured at a place where no metal making up the mesh wiring layer 20, the dummy wiring layer 30, and so forth, is present. In this case, the first transmittance $t1$ may be 83% or more, or may be 87% or more. Also, the first transmittance $t1$ may be 90% or less, or may be 89% or less. Note that the first transmittance $t1$ is preferably in the above range in 80% or more of the region of the first region A1, and the first transmittance $t1$ is preferably in the above range over the entire region of the first region A1 where metal is not present.

Also, transmittance of the image display device laminate 70 regarding visible light rays in the second region A2 will be referred to as second transmittance $t2$. For example, in Fig. 22, transmittance of the visible light rays V2 is the second transmittance $t2$. At this time, the difference between the first transmittance $t1$ and the second transmittance $t2$ ($|t1 - t2|$) may be 1.5% or less, or may be 1.1% or less. The difference between the first transmittance $t1$ and the second transmittance $t2$ ($|t1 - t2|$) may be 0% or more. Note that the relation in magnitude between the first transmittance $t1$ and the second transmittance $t2$ is not restricted. Note that the difference between the first transmittance $t1$ and the second transmittance $t2$ at any point in 80% or more of the region of the first region A1 and any point in 80% or more of the region of the second region A2 is preferably within the above range. Also, the difference between the first transmittance $t1$ and the second transmittance $t2$ at any point in the entire region of the first region A1 where metal is not present and any point in the entire region of the second region A2 is preferably within the above range.

The first transmittance t1 and the second transmittance t2 can be measured as an average value of transmittance measured every 1 nm in a range of wavelength of 400 nm or more and 700 nm or less, using an ultraviolet-visible spectrophotometer "V-670" manufactured by JASCO Corporation. Transmittance of 100% means that light of all wavelengths measured every 1 nm in the range of wavelength of 400 nm or more and 700 nm or less is completely transmitted through the object. For example, transmittance of 100% is a value obtained by performing measurement in a state with no object set, using the above ultraviolet-visible spectrophotometer "V-670" under an environment of temperature of 20°C or more and 25°C or less, and humidity of 30% or more and 70% or less. Also, the first transmittance t1 of 83% or more and 90% or less, for example, means that the average value of transmittance measure every 1 nm in the range of wavelength of 400 nm or more and 700 nm or less is included in the range of 83% or more and 90% or less.

In the present implementation mode, each transmittance of the second base material layer 92, the second transparent adhesive layer 96, the protective layer 17, the substrate 11, the first transparent adhesive layer 95, and the first base material layer 91 is adjusted as appropriate. Accordingly, the first transmittance t1 can be set to 83% or more and 90% or less, and the difference between the first transmittance t1 and the second transmittance t2 can be set to 1.5% or less. Thus, when the observer observes the image display device 60 from the light-emitting face 64 side, an outer edge of the wiring board 10 can be made to be difficult to visually recognize by the bare eye. As a result, the observer can be made to not recognize the presence of the wiring board 10.

Also, a haze value of the image display device laminate 70 in the first region A1 will be referred to as first haze value h1. For example, in Fig. 22, the degree of scattering of the visible light rays V1 is the first haze value h1. Note that the first haze value h1 is measured at places where no metal making up the mesh wiring layer 20 is present. In this case, the first haze value h1 may be 0.5% or more, or may be 0.8% or more. Also, the first haze value h1 may be 2% or less, or may be 1.5% or less. Note that in a region of 80% or more of the first region A1, the first haze value h1 is preferably in the above range, and the first haze value h1 is more preferably in the above range in the entire region of the first region A1 where metal is not present.

Also, a haze value of the image display device laminate 70 in the second region A2 will be referred to as second haze value h2. For example, in Fig. 22, the degree of scattering of the visible light rays V2 is the second haze value h2. At this time, the difference between the first haze value h1 and the second haze value h2 ($|h1 - h2|$) may be 0.5% or less, or may be 0.3% or less. The difference between the first haze value h1 and the second haze value h2 ($|h1 - h2|$) may be 0% or more. Note that the relation in magnitude between the first haze value h1 and the second haze value h2 is not restricted. Note that the difference between the first haze value h1 and the second haze value h2 at any point in 80% or more of the region of the first region A1 and any point in 80% or more of the region of the second region A2 is preferably within the above range. Also, the difference between the first haze value h1 and the second haze value h2 at any point in the entire region of the first region A1 where metal is not present and any point in the entire region of the second region A2 is preferably within the above range.

The first haze value h1 and the second haze value h2 can be measured in conformance with JIS K-7136.

In the present implementation mode, each haze value of the second base material layer 92, the second transparent adhesive layer 96, the protective layer 17, the substrate 11, the first transparent adhesive layer 95, and the first base material layer 91 is adjusted as appropriate. Accordingly, the first haze value h1 can be set to 0.5% or more and 2% or less, and the difference between the first haze value h1 and the second haze value h2 can be set to 0.5% or less. Thus, when the observer observes the image display device 60 from the light-emitting face 64 side, the outer edge of the wiring board 10 can be made to be difficult to visually recognize by the bare eye. As a result, the observer can be made to not recognize the presence of the wiring board 10.

Also, total light reflectance and diffuse light reflectance of the image display device laminate 70 in the first region A1 will be referred to as first total light reflectance $R_{SCI}1$ and first diffuse light reflectance $R_{SCE}1$, respectively. For example, in Fig. 22, the total light reflectance ($R_{SCI}$) of the visible light rays V1 is the first total light reflectance $R_{SCI}1$. Also, the diffuse light reflectance ($R_{SCE}$) of the visible light rays V1 is the first diffuse light reflectance $R_{SCE}1$. Note that the first total light reflectance $R_{SCI}1$ and the first diffuse light reflectance $R_{SCE}1$ are values at places where no metal making up the mesh wiring layer 20 is present. In this case, the first total light reflectance $R_{SCI}1$ may be 9% or more, or may be 9.5% or more. Also, the first total light reflectance $R_{SCI}1$ may be 11% or less, or may be 10.5% or less. Note that in a region of 80% or more of the first region A1, the first total light reflectance $R_{SCI}1$ is preferably in the above range. Also, the first total light reflectance $R_{SCI}1$ is more preferably within the above range in the entire region of the first region A1 where metal is not present.

Further, the first diffuse light reflectance $R_{SCE}1$ may be 0.05% or more, or may be 0.07% or less. Also, the first diffuse light reflectance $R_{SCE}1$ may be 1% or less, or may be 0.5% or less, or may be 0.15% or less, or may be 0.12% or less. Note that in a region of 80% or more of the first region A1, the first diffuse light reflectance $R_{SCE}1$ is preferably in the above range. Also, the first diffuse light reflectance $R_{SCE}1$ is more preferably in the above range in the entire region of the first region A1 where metal is not present.

Also, total light reflectance and diffuse light reflectance of the image display device laminate 70 in the second region A2 will be referred to as second total light reflectance $R_{SCI}2$ and second diffuse light reflectance $R_{SCE}2$, respectively. For example, in Fig. 22, the total light reflectance ($R_{SCI}$) of the visible light rays V2 is the second total light reflectance $R_{SCI}2$. Also, the diffuse light reflectance ($R_{SCE}$) of the visible light rays V2 is the second diffuse light reflectance $R_{SCE}2$. At this time, the difference between the first total light reflectance $R_{SCI}1$ and the second total light reflectance $R_{SCI}2$ ($|R_{SCI}1 - R_{SCI}2|$) may be 1% or less, or may be 0.5% or less. The difference between the first total light reflectance $R_{SCI}1$ and the second total light reflectance $R_{SCI}2$ ($|R_{SCI}1 - R_{SCI}2|$) may be 0% or more. The relation in magnitude between the first total light reflectance $R_{SCI}1$ and the second total light reflectance $R_{SCI}2$ is not restricted. Note that the difference between the first total light reflectance $R_{SCI}1$ and the second total light reflectance $R_{SCI}2$ at any point in 80% or more of the region of the first region A1 and any point in 80% or more of the region of the second region A2 is preferably within the above range. Also, the difference between the first total light reflectance $R_{SCI}1$ and the second total light reflectance $R_{SCI}2$ at any point in the entire region of the first region A1 where metal is not present and any point in the entire region of the second region A2 is preferably within the above range.

Further, the difference between the first diffuse light reflectance $R_{SCE}1$ and the second diffuse light reflectance $R_{SCE}2$ ($|R_{SCE}1 - R_{SCE}2|$) may be 1.5% or less, or may be 0.5% or less, or may be 0.05% or less, or may be 0.03% or less. The difference between the first diffuse light reflectance $R_{SCE}1$ and the second diffuse light reflectance $R_{SCE}2$ ($|R_{SCE}1 - R_{SCE}2|$) may be 0% or more. The relation in magnitude between the first diffuse light reflectance $R_{SCE}1$ and the second diffuse light reflectance $R_{SCE}2$ is not restricted. Note that the difference between the first diffuse light reflectance $R_{SCE}1$ and the second diffuse light reflectance $R_{SCE}2$ at any point in 80% or more of the region of the first region A1 and any point in 80% or more of the region of the second region A2 is preferably within the above range. Also, the difference between the first diffuse light reflectance $R_{SCE}1$ and the second diffuse light reflectance $R_{SCE}2$ at any point in the entire region of the first region A1 where metal is not present and any point in the entire region of the second region A2 is preferably within the above range.

The first total light reflectance $R_{SCI}1$, the first diffuse light reflectance $R_{SCE}1$, the second total light reflectance $R_{SCI}2$, and the second diffuse light reflectance $R_{SCE}2$ can each be measured in conformance with JIS Z 8722.

In the present implementation mode, each total light reflectance ($R_{SCI}$) and each diffuse light reflectance ($R_{SCE}$) of the second base material layer 92, the second transparent adhesive layer 96, the protective layer 17, the substrate 11, the first transparent adhesive layer 95, and the first base material layer 91 are adjusted as appropriate. Accordingly, the first diffuse light reflectance $R_{SCE}1$ can be set to 0.05% or more and 1% or less. Also, the difference between the first diffuse light reflectance $R_{SCE}1$ and the second diffuse light reflectance $R_{SCE}2$ can be set to 1.5% or less. Accordingly, when the observer observes the image display device 60 from the light-emitting face 64 side, the outer edge of the wiring board 10 can be made to be difficult to visually recognize by the bare eye. As a result, the observer can be made to not recognize the presence of the wiring board 10.

Now, when performing flex resistance testing of the image display device laminate 70, the amount of increase in resistance value of the mesh wiring layer 20 may be 20% or less, or may be 10% or less. Flex resistance testing is testing in which a cylindrical mandrel flex tester is used to repeat work of bending the image display device laminate 70 along the periphery of a cylinder that is 1 mm in diameter to 180°, and then straightened out, which is performed 100 times.

Specifically, testing is performed as follows. First, electric resistance value is measured between both longitudinal-direction ends of the mesh wiring layer 20. The resistance value at this time is taken as R0 ($\Omega$). Next, the image display device laminate 70 is wound on the cylinder of the cylindrical mandrel flex tester, so that both longitudinal-direction ends of the image display device laminate 70 face in 180° opposite directions. Thereafter the image display device laminate 70 is removed from the cylinder, and is straightened flat. This work is repeated 100 times. Thereafter, the electrical resistance between both longitudinal-direction ends of the mesh wiring layer 20 is measured again. The resistance value at this time is taken as $R_1$ ($\Omega$). A value obtained by (($R_1 - R_0$) / $R_0$) $\times$ 100 (%) at this time is taken as the amount of increase of resistance value. Due to this amount of increase of resistance value being 20% or less, the durability of the image display device laminate 70 can be improved in a case of using the image display device laminate 70 curved or flexed.

[Examples]

Next, specific examples according to the present implementation mode will be described.

(Example 1)

An image display device laminate (Example 1) including a wiring board, a first dielectric layer, and a second dielectric layer was fabricated. The wiring board includes a substrate, a metal layer, and a protective layer. The substrate was made of cycloolefin polymer (COP) (refractive index: 1.535), and the thickness thereof was 13 $\mu$m. The metal layer was made of copper, and the thickness was 1 $\mu$m. The line width of the mesh wiring layer was all 1 $\mu$m and the openings were all squares of which one side was 100 $\mu$m. The protective layer was formed on the entire region of the substrate. The protective layer was made of acrylic-based resin (refractive index: 1.53), and the thickness thereof was 10 $\mu$m. The

first dielectric layer includes a first transparent adhesive layer and a first base material layer. For the first transparent adhesive layer, an OCA film (refractive index: 1.53) made of acrylic-based resin 25 $\mu$m thick was used. For the first base material layer, cycloolefin polymer (COP) (refractive index: 1.535) 100 $\mu$m thick was used. The second dielectric layer includes a second transparent adhesive layer and a second base material layer. For the second transparent adhesive layer, an OCA film (refractive index: 1.53) made of acrylic-based resin 25 $\mu$m thick was used. For the second base material layer, cycloolefin polymer (COP) (refractive index: 1.535) 100 $\mu$m thick was used.

(Comparative Example 1)

An image display device laminate (Comparative Example 1) was fabricated in the same way as Example 1, other than using an OCA film (refractive index: 1.62) made of acrylic-based resin 25 $\mu$m thick as the first transparent adhesive layer and using an OCA film (refractive index: 1.62) made of acrylic-based resin 25 $\mu$m thick as the second transparent adhesive layer.

[Transmittance]

Next, the first transmittance t1 that is the transmittance of visible light rays in the first region, and the second transmittance t2 that is the transmittance of visible light rays in the second region, were each measured regarding the image display device laminates according to Example 1 and Comparative Example 1. The measurement method for transmittance is as described above.
Next, non-visibility was evaluated for each of the image display device laminates according to Example 1 and Comparative Example 1 when assembled into the image display device. The results are shown in Table 1.
Note that for evaluation of non-visibility, those regarding which the outer edge of the wiring board could not be visually recognized when observing the front face of the image display device under a general visual inspection environment of observation from angles of 30°, 60°, and 90°, were judged to be "high". Also, those regarding which the outer edge of the wiring board could be visually recognized when observing the front face of the base material under a general visual inspection environment of observation from angles of 30°, 60°, and 90°, were judged to be "low".

[Table 1]

| | First transmittance t1 | Second transmittance t2 | \|t1-t2\| | Transmittance of second base material layer | Transmittance of second transparent adhesive layer | Transmittance of protective layer | Transmittance of substrate | Transmittance of first transparent adhesive layer | Transmittance of first base material layer | Evaluation |
|---|---|---|---|---|---|---|---|---|---|---|
| Example 1 | 88% | 89% | 1% | 91.5% | 92% | 90.7% | 91.5% | 92% | 91.5% | High |
| Comparative Example 1 | 86% | 88% | 2% | 91.5% | 92% | 90.7% | 91.5% | 92% | 91.5% | Low |

Thus, the image display device laminate according to Example 1 was found to have high non-visibility than the image display device laminate according to Comparative Example 1.

[Haze Value]

Next, the first haze value h1 that is the haze value in the first region, and the second haze value h2 that is the haze value in the second region, were each measured regarding the image display device laminates according to Example 1 and Comparative Example 1. The measurement method for haze value is as described above.

Next, non-visibility was evaluated for each of the image display device laminates according to Example 1 and Comparative Example 1 when assembled into the image display device. The results are shown in Table 2. The method of evaluating non-visibility is as described above.

[Table 2]

| | First haze value h1 | Second haze value h2 | \|h1-h2\| | Haze value of second base material layer | Haze value of second transparent adhesive layer | Haze value of protective layer | Haze value of substrate | Haze value of first transparent adhesive layer | Haze value of first base material layer | Evaluation |
|---|---|---|---|---|---|---|---|---|---|---|
| Example 1 | 1.2% | 1.1% | 0.1% | 0.1% | 0.5% | 0.3% | 0.9% | 0.5% | 0.1% | High |
| Comparative Example 1 | 1.8% | 1.1% | 0.7% | 0.1% | 0.8% | 0.3% | 0.1% | 0.8% | 0.1% | Low |

Thus, the image display device laminate according to Example 1 was found to have high non-visibility than the image display device laminate according to Comparative Example 1.

[Diffuse Light Reflectance]

Next, the first diffuse light reflectance $R_{SCE}1$ was measured regarding each of the image display device laminates according to Example 1 and Comparative Example 1. In the same way, the second diffuse light reflectance $R_{SCE}2$ was measured regarding the image display device laminates according to Example 1 and Comparative Example 1. The measurement method for diffuse light reflectance is as described above.

Next, non-visibility was evaluated for each of the image display device laminates according to Example 1 and Comparative Example 1 when assembled into the image display device. The results are shown in Table 3. The method of evaluating non-visibility is as described above.

[Table 3]

| | First diffuse light reflectance $R_{SCE}1$ | Second diffuse light reflectance $R_{SCE}2$ | $\lvert R_{SCE}1-R_{SCE}2\rvert$ | Evaluation |
|---|---|---|---|---|
| Example 1 | 0.09% | 0.04% | 0.05% | High |
| Comparative Example 1 | 3% | 3% | 2% | Low |

Thus, the image display device laminate according to Example 1 was found to have high non-visibility than the image display device laminate according to Comparative Example 1.

(Third Embodiment)

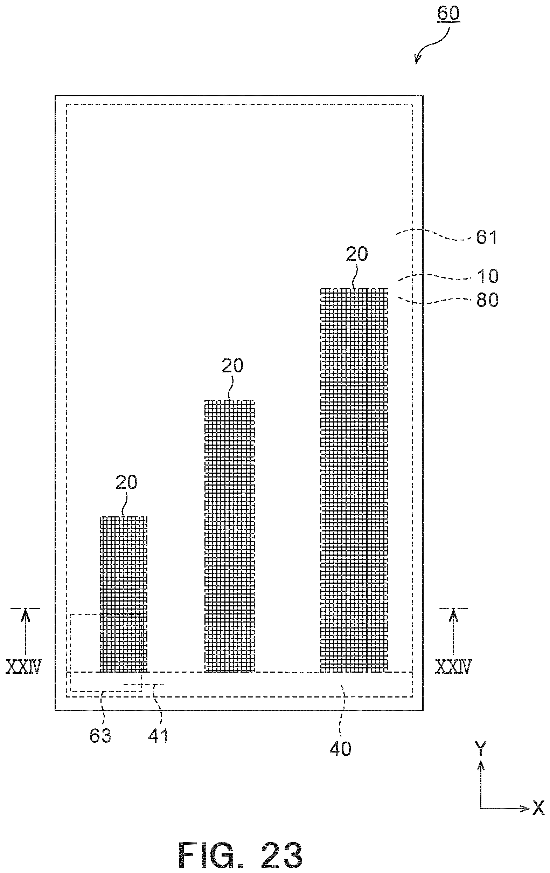

Next, a third embodiment will be described with reference to Fig. 23 to Fig. 33G. Fig. 23 to Fig. 33G are plan views illustrating the present embodiment. In Fig. 23 to Fig. 33G, portions that are the same as in the first embodiment illustrated in Fig. 1 to Fig. 8 or in the second embodiment illustrated in Fig. 9 to Fig. 22 are denoted with the same signs, and detailed description may be omitted.

In the third embodiment, "X direction" is a direction parallel to one side of an image display device. "Y direction" is a direction that is perpendicular to the X direction and also parallel to the other side of the image display device. "Z direction" is a direction that is perpendicular to both the X direction and the Y direction, and is parallel to the thickness direction of the image display device. Also, "front face" is a face on the plus side in the Z direction, which is a light-emitting face side of the image display device, and is a face that faces the observer side. "Rear face" is a face on the minus side in the Z direction, which is a face opposite to the light-emitting face of the image display device and to the face that faces the observer side. Note that in the present embodiment, an example will be described regarding a case in which the mesh wiring layer 20 is a mesh wiring layer 20 having radio wave transmission/reception functions (functions as an antenna), but the mesh wiring layer 20 does not have to have radio wave transmission/reception functions (functions as an antenna).

[Configuration of Image Display Device]

A configuration of the image display device according to the present embodiment will be described with reference to Fig. 23 to Fig. 26.

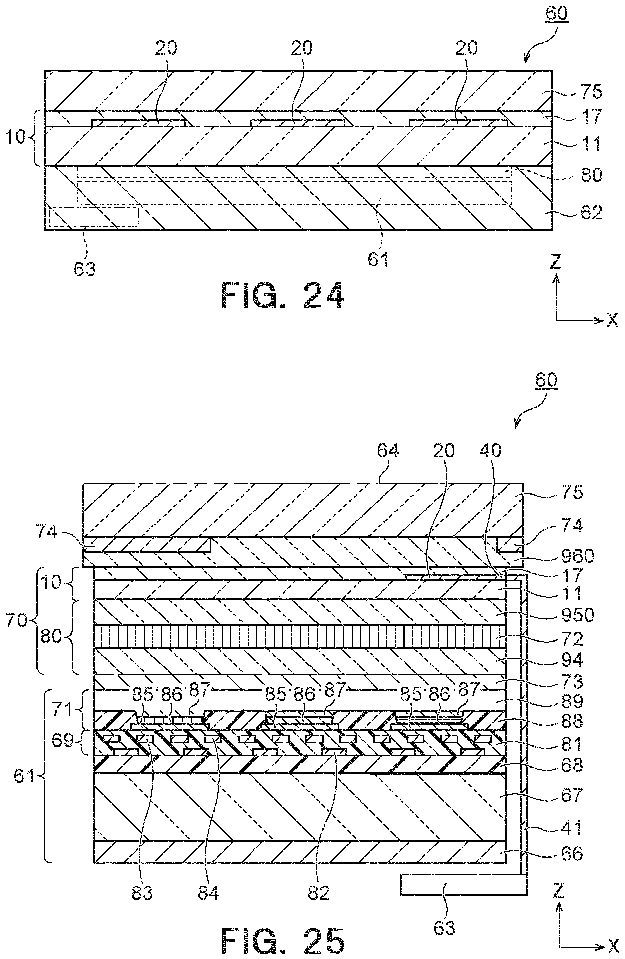

As illustrated in Fig. 23 and Fig. 24, the image display device 60 includes the wiring board 10, and the display device 61 that is laminated on the wiring board 10. Of these, the wiring board 10 has the substrate 11 that has transparency, and the mesh wiring layer 20 disposed on the substrate 11. The power supply unit 40 is electrically connected to the mesh wiring layer 20. Also, the communication module 63 is disposed on the minus side of the display device 61 in the Z direction. The wiring board 10, a later-described dielectric layer 80 the display device 61, and the communication module 63 are accommodated in the housing 62.

In the image display device 60 illustrated in Fig. 23 and Fig. 24, radio waves of a predetermined frequency can be transmitted/received, and communication can be performed via the communication module 63. The communication module 63 may include one of an antenna for telephone, an antenna for WiFi, an antenna for 3G, an antenna for 4G, an antenna for 5G, an antenna for LTE, an antenna for Bluetooth (registered trademark), an antenna for NFC, and so forth. Examples of such image display devices 60 include mobile terminal equipment such as smartphones, tablets, and so forth. Note that details of the wiring board 10 according to the present embodiment will be described later.

Next, a layer configuration of the image display device 60 will be described with reference to Fig. 25.

As illustrated in Fig. 25, the image display device 60 has the light-emitting face 64. The image display device 60 includes the wiring board 10 that is situated on a light-emitting face 64 side (plus side in Z direction) as to the display device 61, and the communication module 63 that is situated on the opposite side from the light-emitting face 64 (minus side in Z direction) as to the display device 61. Note that the cross-section of the wiring board 10, the display device 61, and the communication module 63 is primarily illustrated in Fig. 25, and illustration of the housing 62 and so forth is omitted.

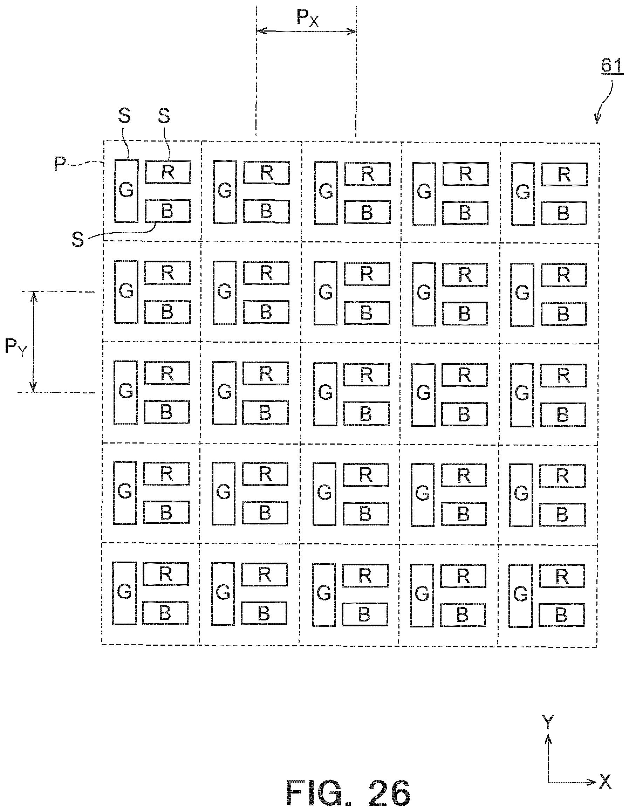

The display device 61 is made up of an organic EL (Electro Luminescence) display device, for example. This display device 61 has a plurality of pixels P (see Fig. 26) that are repetitively laid out in a first direction (e.g., Y direction) and a second direction (e.g., X direction). Details of the pixels P will be described later.

The display device 61 includes, in order from an opposite side of the light-emitting face 64 (minus side in Z direction), a metal layer 66, a support base material 67, a resin base material 68, a thin-film transistor (TFT) 69, and an organic EL layer 71. A touch sensor 73 is disposed on the display device 61. Also, a polarizing plate 72 is disposed on the touch sensor 73, with a first transparent adhesive layer 94 interposed therebetween. Also, the wiring board 10 is disposed on the polarization plate 72, with a second transparent adhesive layer 950 interposed therebetween. A decorative film 74 and the cover glass (surface protection plate) 75 are disposed on the wiring board 10, with a third transparent adhesive layer 960 interposed therebetween.

Note that the display device 61 is not limited to an organic EL display device. For example, the display device 61 may be another display device that has functions of light emission in itself, and may be a micro-LED display device including microscopic LED elements (light emitters). Alternatively, the display device 61 may be a liquid crystal display device including liquid crystal.

The metal layer 66 is situated further on the opposite side from the light-emitting face 64 (minus side in Z direction) than an organic luminescent layer (luminant) 86 of the organic EL layer 71. This metal layer 66 serves a role to protect the display device 61 from electromagnetic waves emitted by other electronic equipment that is not illustrated, situated on the outside of the display device 61. The metal layer 66 may be made of a metal with good conductivity, such as copper or the like, for example. The thickness of the metal layer 66 may be 1 $\mu$m or more and 100 $\mu$m or less, for example, and preferably is 10 $\mu$m or more and 50 $\mu$m or less.

The support base material 67 is disposed on the metal layer 66. The support base material 67 supports the entire display device 61, and may be made of a film that has flexibility, for example. Polyethylene terephthalate, for example, can be used as the material of the support base material 67. The thickness of the support base material 67 may be 75 $\mu$m or more and 300 $\mu$m or less, for example, and preferably is 100 $\mu$m or more and 200 $\mu$m or less.

The resin base material 68 is disposed on the support base material 67. The resin base material 68 is for supporting the thin-film transistor 69, the organic EL layer 71, and so forth, and is made of a flat layer that has flexibility. The resin base material 68 may be formed by coating using a technique such as die coating, ink-jet coating, spray coating, plasma CVD or thermal CVD, capillary coating, slit-and-spin coating, central dripping, or the like. Colored polyimide, for example, can be used for the resin base material 68. The thickness of the resin base material 68 may be 7 $\mu$m or more and 30 $\mu$m or less, for example, and preferably is 10 $\mu$m or more and 20 $\mu$m or less.

The thin-film transistor (TFT) 69 is disposed on the resin base material 68. The thin-film transistor 69 is for driving the organic EL layer 71, and is arranged to control voltage applied to a first electrode 85 and a second electrode 87, which will be described later, of the organic EL layer 71. The thickness of the thin-film transistor 69 may be 7 $\mu$m or more and 30 $\mu$m or less, for example, and preferably is 10 $\mu$m or more and 20 $\mu$m or less.

The thin-film transistor 69 has an insulating layer 81, and a gate electrode 82, a source electrode 83, and a drain electrode 84, which are embedded in the insulating layer 81. The insulating layer 81 is configured by laminating a material that has electrical insulating properties, for example, and any of known organic materials and inorganic materials can be used. Examples of materials that may be used for the insulating layer 81 include silicon oxide ($SiO_2$), silicon nitride (SiNx), silicon oxynitride (SiON), silicon nitride (SiN), and aluminum oxide (AlOx). A molybdenum-tungsten alloy, a laminate of titanium and aluminum, and so forth, for example, can be employed for the gate electrode 82. As for the source electrode 83 and the drain electrode 84, a laminate of titanium and aluminum, a laminate of copper manganese, copper, and molybdenum, and so forth, can be used.

The organic EL layer 71 is disposed on the thin-film transistor 69 and is electrically connected to the thin-film transistor 69. The organic EL layer 71 has the first electrode (reflector electrode, anode electrode) 85 that is disposed above the resin base material 68, the organic luminescent layer (luminant) 86 disposed on the first electrode 85, and the second electrode (transparent electrode, cathode electrode) 87 disposed on the organic luminescent layer 86. Also, a bank 88 is formed on the thin-film transistor 69 to cover end edges of the first electrode 85. Being surrounded by this bank 88 forms an opening, and the organic luminescent layer 86 described above is disposed in this opening. Further, the first electrode 85, the organic luminescent layer 86, the second electrode 87, and the bank 88 are sealed by a sealing resin 89. Note that here, the first electrode 85 makes up the anode electrode, and the second electrode 87 makes up the cathode electrode. However, the polarities of the first electrode 85 and the second electrode 87 are not limited in particular.

The first electrode 85 is formed above the resin base material 68 by a technique such as sputtering, vapor deposition, ion plating, CVD, and so forth. The material used for the first electrode 85 is preferably a material that enables efficient hole injection, and examples thereof include metal materials such as aluminum, chromium, molybdenum, tungsten, copper, silver, gold, alloys thereof, and so forth.

The organic luminescent layer (luminant) 86 has a function of an excitation state being generated by injection and recoupling of holes and electrons, thereby emitting light. The organic luminescent layer 86 is formed on the first electrode 85 by vapor deposition, nozzle coating in which a coating liquid is coated from a nozzle, or printing such as ink jet or the like. A material that contains a fluorescent organic material configured to emit light under application of a predetermined voltage is preferable for the organic luminescent layer 86, examples of which include quinolinol complexes, oxazole complexes, various types of laser dyes, polyparaphenylene vinylene, and so forth. Note that a plurality of the organic luminescent layers 86 is one of a red luminescent layer, a green luminescent layer, and a blue luminescent layer, with red luminescent layers, green luminescent layers, and blue luminescent layers being formed repetitively arrayed.

The second electrode (transparent electrode) 87 is formed on the organic luminescent layer 86. The second electrode 87 may be formed by techniques such as, for example, sputtering, vapor deposition, ion plating, CVD, or the like. A material that lends itself to electron injection and has good light-transmitting properties is preferably used for the second electrode 87. Specific examples include indium tin oxide (ITO) indium zinc oxide (IZO), lithium oxide, cesium carbonate, and so forth.

The bank 88 is formed by using an organic material that has insulating properties, such as resin or the like. Examples of organic materials used for forming the bank 88 include acrylic-based resins, polyimide-based resins, novolac-type phenolic resin, and so forth.

The sealing resin 89 is disposed on the bank 88 and on the second electrode 87. The sealing resin 89 is for protecting the organic luminescent layer 86. Silicon resin or acrylic-based resin, for example, can be used for the sealing resin 89. The thickness of the sealing resin 89 may be 7 $\mu$m or more and 30 $\mu$m or less, for example, and preferably is 10 $\mu$m or more and 20 $\mu$m or less.

Note that light emitted at the organic EL layer 71 is extracted from the light-emitting face 64. That is to say, light from the organic EL layer 71 is extracted from above the sealing resin 89. Thus, the display device 61 according to the present embodiment is a so-called top-emission type display device.

The touch sensor 73 is disposed on the organic EL layer 71. This touch sensor 73 detects and outputs touch position data when a finger or the like is brought into contact with the display device 61. The touch sensor 73 is configured including a metal portion such as copper or the like. The thickness of the touch sensor 73 may be 0.1 $\mu$m or more and 3.0 $\mu$m or less, for example, and preferably is 0.2 $\mu$m or more and 0.5 $\mu$m or less.

The first transparent adhesive layer 94 is an adhesive layer that performs adhesion of the polarizing plate 72 to the touch sensor 73. The first transparent adhesive layer 94 may be an OCA (Optical Clear Adhesive) layer. The OCA layer is a layer that is fabricated as follows, for example. First, a curable adhesive layer composition that is in a liquid state and that includes a polymerizable compound is coated on a releasing film of polyethylene terephthalate (PET) or the like, and cured by using ultraviolet rays (UV) or the like, for example, thereby obtaining an OCA sheet. The material of the above curable adhesive layer composition may be an optical adhesive such as an acrylic-based resin, a silicone-based resin, a urethane-based resin, or the like. This OCA sheet is applied to an object, following which the releasing film is removed by separation, thereby obtaining the OCA layer. The first transparent adhesive layer 94 made of the OCA layer has optical transparency. The thickness of the first transparent adhesive layer 94 may be 10 $\mu$m or more and 50 $\mu$m or less, for example, and preferably is 15 $\mu$m or more and 30 $\mu$m or less.

The polarizing plate 72 is disposed on the touch sensor 73 with the first transparent adhesive layer 94 interposed therebetween. This polarizing plate 72 is for filtering of light from the organic EL layer 71. The polarizing plate 72 may be a circularly polarizing plate. The polarizing plate 72 may have a polarizer, and a pair of protective films that have translucency, which are applied to both faces of the polarizer. The thickness of the polarizing plate 72 may be 15 $\mu$m or more and 200 $\mu$m or less, for example, and preferably is 50 $\mu$m or more and 150 $\mu$m or less.

The second transparent adhesive layer 950 is an adhesive layer that performs adhesion of the wiring board 10 to the polarizing plate 72. In the same way as the first transparent adhesive layer 94, the second transparent adhesive layer 950 may be an OCA (Optical Clear Adhesive) layer. The thickness of the second transparent adhesive layer 950 may be 15 $\mu$m or more and 150 $\mu$m or less, for example, and preferably is 20 $\mu$m or more and 120 $\mu$m or less. Also, the second transparent adhesive layer 950 has the same configuration as the first transparent adhesive layer 95 according to the first implementation mode of the second embodiment.

As described above, the wiring board 10 is disposed toward the light-emitting face 64 side with respect to the display device 61. In this case, the wiring board 10 is situated between the polarizing plate 72 and the decorative film 74. The wiring board 10 has the substrate 11 that has transparency, and the mesh wiring layer 20 that is disposed on the substrate 11. The power supply unit 40 is electrically connected to the mesh wiring layer 20. The power supply unit 40 is electrically connected to the communication module 63 via a connection line 41. The thickness of the substrate 11

may be 10 $\mu$m or more and 200 $\mu$m or less, for example, and preferably is 30 $\mu$m or more and 120 $\mu$m or less. Note that details of the wiring board 10 according to the present embodiment will be described later.

In the present embodiment, the dielectric layer 80 is laminated on the substrate 11 side of the wiring board 10. The dielectric layer 80 is a layer that substantially does not contain metal, and is a layer that has insulating properties. In this case, the dielectric layer 80 includes the first transparent adhesive layer 94, the polarizing plate 72, and the second transparent adhesive layer 950, which are described above. The face of the dielectric layer 80 on the opposite side from the wiring board 10 is adjacent to a layer containing metal. Specifically, the touch sensor 73 is directly laminated on the dielectric layer 80.

Depending on the layer configuration of the image display device 60 not all of the first transparent adhesive layer 94, the polarizing plate 72, and the second transparent adhesive layer 950 necessarily have to be included in the dielectric layer 80. That is to say, part of the first transparent adhesive layer 94, the polarizing plate 72, and the second transparent adhesive layer 950 may be omitted. Alternatively, a layer other than the first transparent adhesive layer 94, the polarizing plate 72, and the second transparent adhesive layer 950, which functions as a dielectric substance, may be provided. In either case, the dielectric layer 80 functions as an insulator that substantially does not contain a conductor such as metal.

The permittivity of the dielectric layer 80 is preferably 3.5 or lower, and even more preferably 3.0 or lower. Suppressing the permittivity of the dielectric layer 80 enables deterioration in functions of the mesh wiring layer 20 such as the above-described antenna functions and the like to be suppressed more effectively.

The third transparent adhesive layer 960 is an adhesive layer that performs adhesion of the wiring board 10 to the decorative film 74 and the cover glass 75. The third transparent adhesive layer 960 may be an OCA (Optical Clear Adhesive) layer, in the same way as the first transparent adhesive layer 94 and the second transparent adhesive layer 950. The thickness of the third transparent adhesive layer 960 may be 20 $\mu$m or more and 200 $\mu$m or less, for example, and preferably is 30 $\mu$m or more and 180 $\mu$m or less. Also, the third transparent adhesive layer 960 may have the same configuration as the second transparent adhesive layer 96 according to the first implementation mode of the second embodiment.

The decorative film 74 is disposed on the wiring board 10. All or part of the decorative film 74 at portions overlapping the display region of the display device 61 when viewed from the observer side is opened, for example, and shields light at portions other than the display region. That is to say, the decorative film 74 is disposed so as to cover end portions of the display device 61 as viewed from the observer side.

The cover glass (surface protection plate) 75 is disposed on the decorative film 74. This cover glass 75 is a member made of glass that transmits light. The cover glass 75 is plate-like, and may have a rectangular shape in plan view. The thickness of the cover glass 75 may be 200 $\mu$m or more and 1000 $\mu$m or less for example, and preferably is 300 $\mu$m or more and 700 $\mu$m or less. Note that the planar shape of the cover glass 75 may be larger than the planar shapes of the wiring board 10, the dielectric layer 80, and the display device 61.

Next, the pixels P of the display device 61 will be described with reference to Fig. 26.

Fig. 26 is a plan view illustrating an example of a layout configuration of the pixels P, and sub-pixels S included in the pixels P. Note that in Fig. 26, sub-pixels S denoted by "R" represent sub-pixels S that emit red light (aforementioned red luminescent layer), sub-pixels S denoted by "G" represent sub-pixels S that emit green light (aforementioned green luminescent layer), and sub-pixels S denoted by "B" represent sub-pixels S that emit blue light (aforementioned blue luminescent layer).

The display device 61 has a plurality of the pixels P that are regularly laid out. The plurality of pixels P are laid out at a constant pitch $P_X$ in the X direction, and the pitch $P_X$ thereof may be in a range of about 50 $\mu$m or more and 200 $\mu$m or less, for example. The plurality of pixels P are also laid out at a constant pitch $P_Y$ in the Y direction, and the pitch $P_Y$ thereof may be in a range of about 50 $\mu$m or more and 200 $\mu$m or less, for example.

The pixels P each include a plurality of sub-pixels S, and each of the sub-pixels S includes an OLED (organic light-emitting diode) that is capable of emitting light of the corresponding color. In the example illustrated in Fig. 26, each pixels P includes sub-pixels S capable of emitting light of three types of color (e.g., red, green, and blue). The sub-pixels S included in each of the pixels P are arrayed in both directions of the X direction and the Y direction. In the example illustrated in Fig. 26, the sub-pixels S that emit green light are arrayed distanced from the sub-pixels S that emit red light and the sub-pixels S that emit blue light in the X direction. Also, the sub-pixels S that emit red light and the sub-pixels S that emit blue light are arrayed distanced from each other in the Y direction.

Note that the types and the number of sub-pixels S included in each of the pixels P (i.e., emitted colors) are not limited in particular, and sub-pixels S that are capable of emitting two types, or four types or more of color, for example, may be included in each of the pixels P. Also, the relative positional relation among the sub-pixels S in the pixels P is not limited in particular either, and may be laid out such that the sub-pixels S are arrayed in only one direction of the X direction and the Y direction, for example, and the sub-pixels S in each of the pixels P may be laid out in close proximity or in close contact with each other.

In this way, each of the sub-pixels S make up individual light-emitting elements, and each of the pixels P is made up of a set of the plurality of sub-pixels S making up repetitive units. Note that the layout of pixels P and sub-pixels S is not limited to the example illustrated in Fig. 26, and layout can be made in optional forms. For example, although one each of sub-pixels S of each color (i.e., red, green, and blue) is included in a range of each pixel P having a square shape in the example illustrated in Fig. 26, the shape of the pixels P is not necessarily limited to a square shape, and also, the plurality of sub-pixels S of each color may be included in each of the pixels P.

[Configuration of Wiring Board]

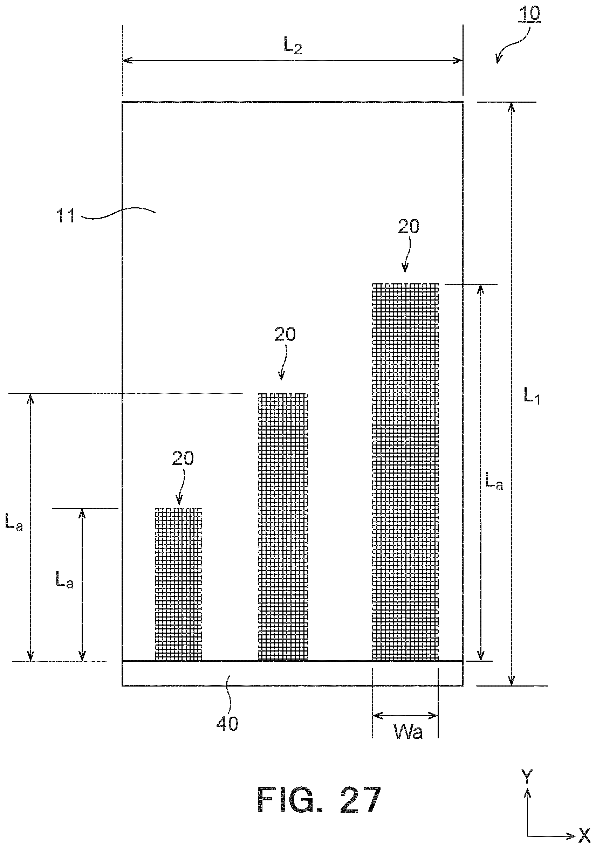

Next, a configuration of the wiring board will be described with reference to Fig. 27 to Fig. 32. Fig. 27 to Fig. 32 are diagrams illustrating the wiring board according to the present embodiment.

As illustrated in Fig. 27, the wiring board 10 according to the present embodiment is used on the image display device 60 (see Fig. 23 to Fig. 25), and is disposed between the cover glass 75 and the dielectric layer 80 on the light-emitting face 64 side from the organic luminescent layer (luminant) 86. Such a wiring board 10 includes the substrate 11 having transparency, and the mesh wiring layer 20 disposed on the substrate 11. Also, the power supply unit 40 is electrically connected to the mesh wiring layer 20.

In the present embodiment, the mesh wiring layer 20 is made up of an antenna pattern having functions as an antenna. In Fig. 27, the plurality (three) of mesh wiring layers 20 are formed on the substrate 11, each corresponding to a different frequency band.

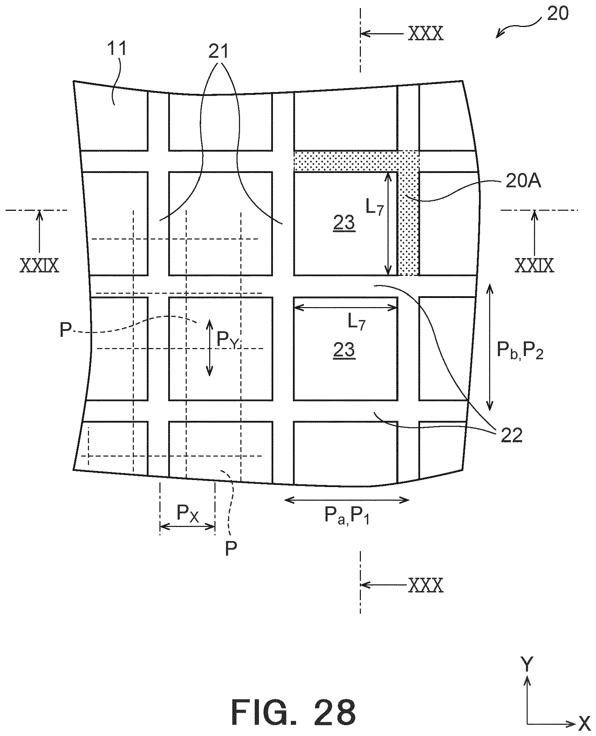

As illustrated in Fig. 28, the mesh wiring layer 20 is made up of a predetermined unit pattern 20A that is repetitively laid out in a first direction (e.g., Y direction) and a second direction (e.g., X direction) that is different from the first direction. Also, this unit pattern 20A is repetitively laid out in the second direction (e.g., X direction) that is different from the first direction. In other words, the mesh wiring layer 20 has a repetitive pattern extending in the X direction and the Y direction in which respective metal lines are formed in a grid-like or fishnet-like form. That is to say, the mesh wiring layer 20 is made up of a repetition of a L-shaped unit pattern 20A (shaded portion in Fig. 28) made up of a portion extending in the X direction (part of the second-direction wiring lines 22) and a portion extending in the Y direction (part of the first-direction wiring lines 21). In other words, the unit pattern 20A includes the first-direction wiring lines (antenna wiring lines (wiring lines)) 21 and the second-direction wiring lines (antenna interconnection wiring lines (wiring lines)) 22 extending in different directions from each other. Accordingly, in the present embodiment, a pitch $P_a$ of the unit pattern 20A in the X direction is equal to the pitch $P_1$ of the first-direction wiring lines 21, and can be in a range of, for example, 0.01 mm or more and 1 mm or less. Also, a pitch $P_b$ of the unit pattern 20A in the Y direction is equal to the pitch $P_2$ of the second-direction wiring lines 22, and can be in a range of, for example, 0.01 mm or more and 1 mm or less.

Now, in the present embodiment, the pitch $P_b$ of the unit pattern 20A in the Y direction (first direction) is (N - 0.05) times (where N is a natural number (not 0)) the pitch $P_Y$ of the pixels P in the Y direction (first direction) or less, or is (N + 0.05) times the pitch $P_Y$ of the pixels P in the Y direction (first direction) or more. Thus, a pitch of the moire that is generated due to regularity (cyclicity) of the mesh wiring layer 20 and regularity (cyclicity) of the pixels P can be reduced to a level that is visually unrecognizable to the bare eye.

That is to say, in the image display device 60 described above, the mesh wiring layer 20 of the wiring board 10 is laid out so as to coincide with the pixels P of the display device 61 in the Z direction. Accordingly, moire can occur due to the regularity (cyclicity) of the mesh wiring layer 20 and the regularity (cyclicity) of the pixels P. Conversely, in the present embodiment, the pitch $P_b$ of the unit pattern 20A in the Y direction (first direction) is (N - 0.05) times (where N is a natural number) the pitch $P_Y$ of the pixels P in the Y direction (first direction) or less, or is (N + 0.05) times the pitch $P_Y$ of the pixels P in the Y direction (first direction) or more. Accordingly, when viewed from the Z direction, the unit pattern 20A and the pixels P are laid out irregularly in the Y direction. Thus, the pitch of moire that is generated due to the regularity (cyclicity) of the mesh wiring layer 20 and the regularity (cyclicity) of the pixels P can be reduced to a level that is visually unrecognizable to the bare eye.

Also, the pitch $P_a$ of the unit pattern 20A in the X direction (second direction) is (M - 0.05) times (where M is a natural number (not 0)) the pitch $P_x$ of the pixels P in the X direction (second direction) or less, or is (M + 0.05) times the pitch $P_X$ of the pixels P in the X direction (second direction) or more. Accordingly, when viewed from the Z direction, the unit pattern 20A and the pixels P are laid out irregularly in the X direction. Thus, the pitch of moire that is generated due to the regularity of the mesh wiring layer 20 and the regularity of the pixels P can be reduced to a level that is visually unrecognizable to the bare eye.

Now, the pitch $P_b$ of the unit pattern 20A in the Y direction (first direction) is preferably (N - 0.2) times the pitch $P_Y$ of the pixels P in the Y direction (first direction) or more, or is (N + 0.2) times the pitch $P_Y$ of the pixels P in the Y direction (first direction) or less. Accordingly, the pitch $P_b$ of the unit pattern 20A can be suppressed from becoming too small even in a case in which N becomes small, for example. Accordingly, the aperture ratio At1 of the mesh wiring layer 20 can be suppressed from becoming small, and transparency of the wiring board 10 can be secured. Also, the pitch $P_b$ of the unit pattern 20A can be suppressed from becoming too large even in a case in which n becomes large, for example. Thus, a sheet resistance value of the mesh wiring layer 20 can be suppressed from becoming too great, and antenna characteristics thereof can be maintained.

Also, the pitch $P_a$ of the unit pattern 20A in the X direction (second direction) is preferably (M - 0.2) times the pitch $P_X$ of the pixels P in the X direction (second direction) or more, or is (M + 0.2) times the pitch $P_X$ of the pixels P in the X direction (second direction) or less. Accordingly, the pitch $P_a$ of the unit pattern 20A can be suppressed from becoming too small even in a case in which M becomes small, for example. Accordingly, the aperture ratio At1 of the mesh wiring layer 20 can be suppressed from becoming small, and transparency of the wiring board 10 can be secured. Also, the pitch $P_a$ of the unit pattern 20A can be suppressed from becoming too large even in a case in which m becomes large, for example. Thus, the sheet resistance value of the mesh wiring layer 20 can be suppressed from becoming too great, and antenna characteristics thereof can be maintained.

Further N and M are each preferably natural numbers of 1 or more and 6 or less. By N and M each being natural numbers of 6 or less, the pitch $P_a$ and the pitch $P_b$ of the unit pattern 20A can be suppressed from becoming too large. Accordingly, the sheet resistance value of the mesh wiring layer 20 can be suppressed from becoming too great, and antenna characteristics thereof can be maintained.

Further, while the first-direction wiring lines 21 and the second-direction wiring lines 22 each are orthogonal to each other in the present embodiment, this is not restrictive, and these may intersect each other at acute angles or obtuse angles. Now, in the unit pattern 20A described above, the angle formed between the first-direction wiring lines 21 and the second-direction wiring lines 22 is preferably 30° or more and 150° or less. Accordingly, at the time of forming the mesh wiring layer 20, the first-direction wiring lines 21 and the second-direction wiring lines 22 can be formed easily.

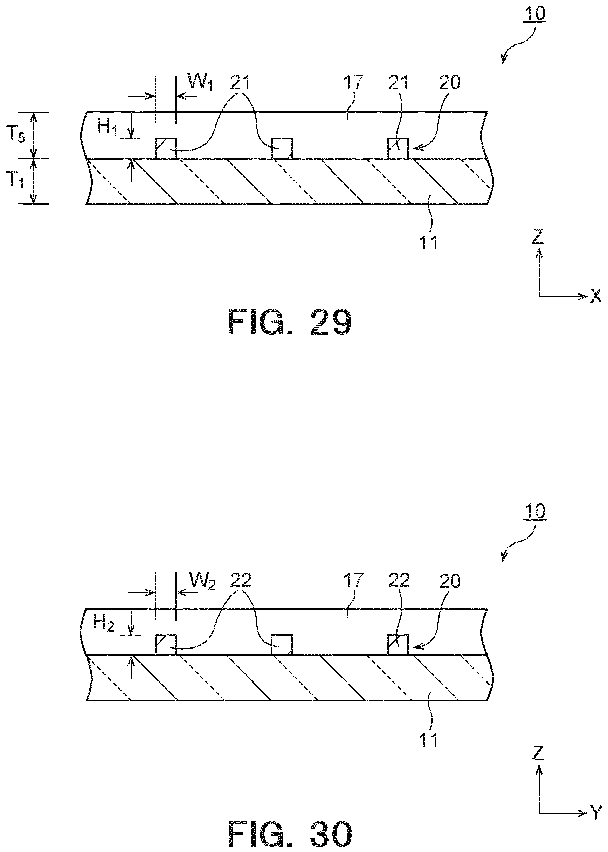

As illustrated in Fig. 29, in the present embodiment as well, the cross-section of each first-direction wiring line 21 perpendicular to the longitudinal direction (X-direction cross-section) thereof is a generally rectangular shape or a generally square shape. In this case, the cross-sectional shape of the first-direction wiring lines 21 is generally uniform in the longitudinal direction of the first-direction wiring lines 21 (Y direction). Also, as illustrated in Fig. 30, in the present embodiment as well, the cross-sectional shape of each second-direction wiring line 22 perpendicular to the longitudinal direction (Y-direction cross-section) is a generally rectangular shape or a generally square shape, and is generally the same as the cross-sectional (X-direction cross-section) shape of the first-direction wiring lines 21 described above.

In the present embodiment as well, the line width $W_1$ (length in X direction, see Fig. 29) of the first-direction wiring lines 21 and the line width $W_2$ (length in Y direction, see Fig. 30) of the second-direction wiring lines 22 are not limited in particular, and can be selected as appropriate in accordance with the usage. For example, the line width $W_1$ of the first-direction wiring lines 21 can be selected from a range of 0.1 $\mu$m or more and 5.0 $\mu$m or less, and preferably is 0.2 $\mu$m or more and 2.0 $\mu$m or less. Also, the line width $W_2$ of the second-direction wiring lines 22 can be selected from a range of 0.1 $\mu$m or more and 5.0 $\mu$m or less, and preferably is 0.2 $\mu$m or more and 2.0 $\mu$m or less. Due to the line width $W_1$ of the first-direction wiring lines 21 being 5.0 $\mu$m or less, even in a case of moire occurring, the intensity of the moire can be reduced, and due to the line width $W_1$ being 2.0 $\mu$m or less, the intensity of the moire can be further reduced. In the same way, due to the line width $W_2$ of the second-direction wiring lines 22 being 5.0 $\mu$m or less, even in a case of moire occurring, the intensity of the moire can be reduced, and due to the line width $W_2$ being 2.0 $\mu$m or less, the intensity of the moire can be further reduced.

Further, in the present embodiment as well, the height $H_1$ (length in Z direction, see Fig. 29) of the first-direction wiring lines 21 and the height $H_2$ (length in Z direction, see Fig. 30) of the second-direction wiring lines 22 are not limited in particular, and can be selected as appropriate in accordance with usage. The height $H_1$ of the first-direction wiring line 21 and the height $H_2$ of the second-direction wiring line 22 can each be selected from a range of 0.1 $\mu$m or more and 5.0 $\mu$m or less for example, and preferably are 0.2 $\mu$m or more and 2.0 $\mu$m or less.

Now, the sheet resistance value of the mesh wiring layer 20 may be 4 ohms per square or less. Sheet resistance value of 4 ohms per square or less enables the performance of the mesh wiring layer 20 to be maintained. Specifically, radiation efficiency of the mesh wiring layer 20 serving as an antenna (a proportion indicating how much of the electric power input to the mesh wiring layer 20 itself has been radiated) can be raised.

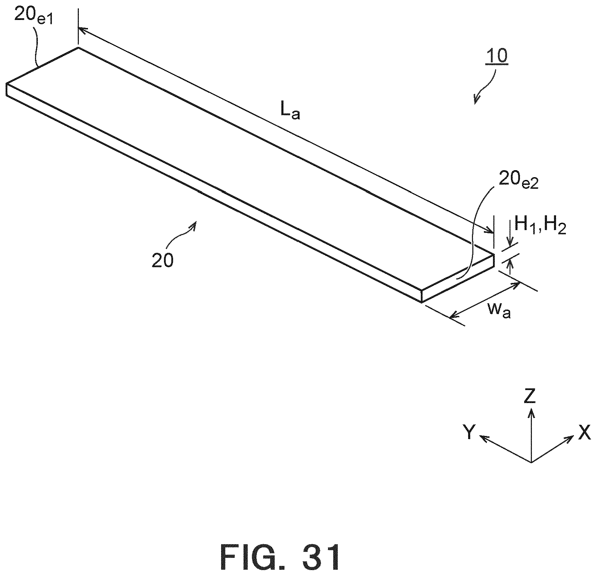

Now, the sheet resistance value (ohms per square) of the mesh wiring layer 20 can be found as follows. That is to say, actual measurement of a resistance value R between both end portions $20_{e1}$ and $20_{e2}$ (see Fig. 31) in the longitudinal direction (Y direction) of the mesh wiring layer 20 is performed. Next, this resistance value R is divided by a ratio ($L_a / W_a$) of the length $L_a$ and width $W_a$ of the mesh wiring layer 20, whereby a sheet resistance value $R_s$ (ohms per square) of the mesh wiring layer 20 can be found. That is to say, sheet resistance value $R_s = R \times W_a / L_a$ holds.

In this way, setting the sheet resistance value of the mesh wiring layer 20 to 4 ohms per square or less enables the radiation efficiency of the mesh wiring layer 20 itself to be raised, and performance of the mesh wiring layer 20 serving as an antenna to be maintained. Also, the width $W_a$ and the heights $H_1$ and $H_2$ of the mesh wiring layer 20 can be minimized to the farthest extent possible within the range of satisfying the above sheet resistance value. Accordingly, the aperture ratio At1 of the mesh wiring layer 20 can be increased, and the mesh wiring layer 20 can be made more difficult to visually recognize.

Also, in the present embodiment, the longest width of each of the first-direction wiring lines 21 and the second-direction wiring lines 22 as viewed from a 120° viewing angle may be 3 $\mu$m or less.

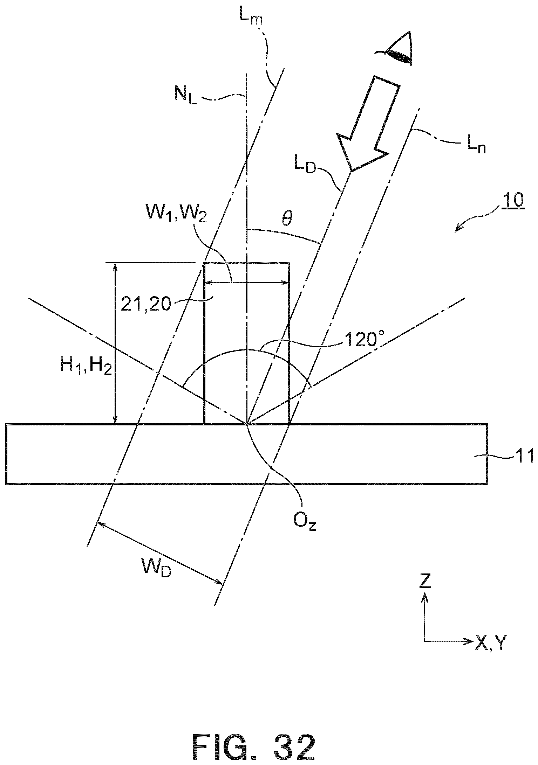

That is to say, as illustrated in Fig. 32, a width $W_D$, in a cross-section of the first-direction wiring line 21 (second-direction wiring line 22) that is perpendicular to the longitudinal direction thereof, in a case of viewing the first-direction wiring line 21 (second-direction wiring line 22) from a direction of a predetermined line of sight $L_D$, is defined. The width of the first-direction wiring line 21 (second-direction wiring line 22) that is the longest when moving this line of sight $L_D$ over a range of a 120° viewing angle may be 3 $\mu$m or less.

Now, the viewing angle is an angle that is $2 \times \theta$ in a case in which an angle between a normal line $N_L$ that is perpendicular to the front face of the substrate 11 and an angle of the line of sight $L_D$ directed toward an intersection $O_Z$ between the normal line $N_L$ and the front face of the substrate 11 is $\theta$. Also, the width $W_D$ in a case of viewing from the direction of the line of sight $L_D$ is the distance between a pair of straight lines $L_m$ and $L_n$ that are parallel to the line of sight $L_D$ when the pair of straight lines $L_m$ and $L_n$ come into contact with the first-direction wiring line 21 (second-direction wiring line 22) in cross-sectional view.

In a case in which the height $H_1$ ($H_2$) of the first-direction wiring line 21 (second-direction wiring line 22) is the same as the line width $W_1$ ($W_2$) of the first-direction wiring line 21 (second-direction wiring line 22) for example ($H_1 = W_1$ ($H_2 = W_2$)), the width $W_D$ when viewed from the 120° viewing angle is the longest in the case of $\theta = 45°$, and the value thereof is $1.41 \times W_1$. Also, In a case in which the height $H_1$ ($H_2$) of the first-direction wiring line 21 (second-direction wiring line 22) is 2 times the line width $W_1$ ($W_2$) of the first-direction wiring line 21 (second-direction wiring line 22) ($H_1 = 2 \times W_1$ ($H_2 = 2 \times W_2$)), the width $W_D$ when viewed from the 120° viewing angle is the longest in the case of $\theta = 60°$, and the value thereof is $2.23 \times W_1$.

Generally, it is conceivable that the greatest viewing angle in a case of the user viewing the wiring board 10 is around 120°. Also, the greatest width of the first-direction wiring line 21 (second-direction wiring line 22) that can be visually recognized by humans is around 3 $\mu$m . Accordingly, by setting the longest width of the first-direction wiring line 21 (second-direction wiring line 22) when viewed from the 120° viewing angle to be 3 $\mu$m or less, the first-direction wiring line 21 (second-direction wiring line 22) can be made to be difficult to be visually recognized by the bare eye of the user. Also, even in a case of moire occurring, the intensity of the moire can be reduced.

Referencing Fig. 29 and Fig. 30 again, the protective layer 17 is formed on the front face of the substrate 11, so as to cover the mesh wiring layer 20. The protective layer 17 is for protecting the mesh wiring layer 20, and is formed on generally the entire region of the surface of the substrate 11. Acrylic resins such as polymethyl (meth) acrylate, polyethyl (meth) acrylate, and so forth, and denatured resins and copolymers thereof, polyvinyl resins such as polyester, polyvinyl alcohol, polyvinyl acetate, polyvinyl acetal, polyvinyl butyral, and so forth, and copolymers thereof, polyurethane, epoxy resin, polyamide, chlorinated polyolefin, and so forth, and like insulating resins that are colorless and transparent, can be used as the material of the protective layer 17. Also, a thickness $T_5$ of the protective layer 17 can be selected from a range of 0.3 $\mu$m or more and 100 $\mu$m or less. Note that it is sufficient for the protective layer 17 to be formed so as to cover at least the mesh wiring layer 20 out of the substrate 11. Also, the protective layer 17 does not necessarily have to be formed.

[Method for Manufacturing Wiring Board]

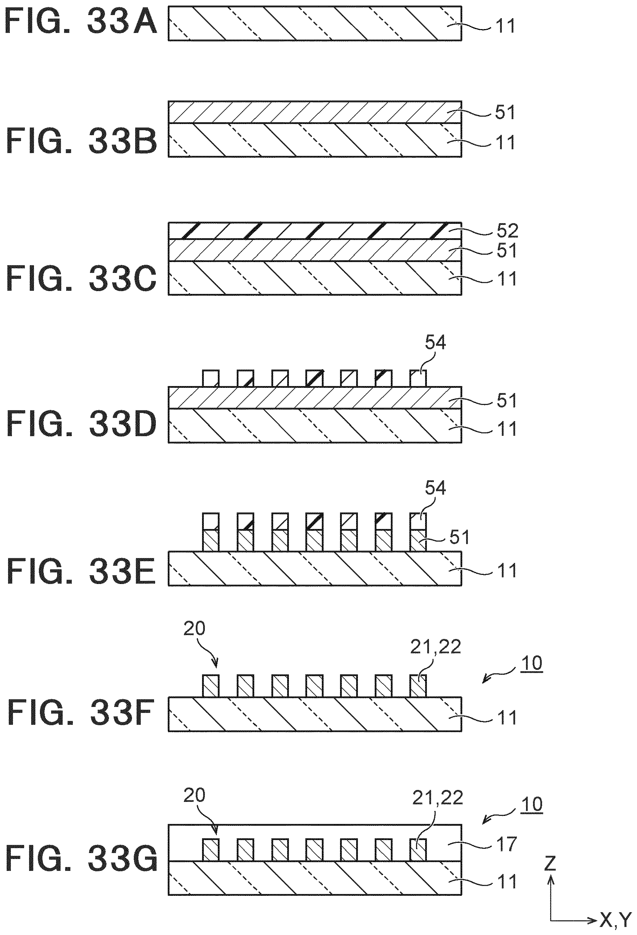

Next, a method for manufacturing the wiring board according to the present embodiment will be described with reference to Fig. 33A to Fig. 33G. Fig. 33A to Fig. 33G are cross-sectional views illustrating the method for manufacturing the wiring board according to the present embodiment.

First, the pitches $P_X$ and $P_Y$ of the pixels P of the display device 61 to be laminated onto the wiring board 10 are decided.

First, as illustrated in Fig. 33A, the substrate 11 that has transparency is prepared.

Next, the mesh wiring layer 20 is formed on the substrate 11, on the basis of the pitches $P_X$ and $P_Y$ of the pixels P.

At this time, first, as illustrated in Fig. 33B, first, the metal foil 51 is laminated on generally the entire region of the surface of the substrate 11. The thickness of the metal foil 51 in the present embodiment may be 0.1 $\mu$m or more and 5.0 $\mu$m or less. The metal foil 51 in the present embodiment may contain copper.

Next, as illustrated in Fig. 33C, the photo-curing insulating resist 52 is supplied to generally the entire region of the surface of the metal foil 51. Examples of this photo-curing insulating resist 52 include organic resins such as acrylic resins, epoxy-based resins, and so forth.

Next, as illustrated in Fig. 33D, an insulating layer 54 is formed by photolithography. In this case, the photo-curing insulating resist 52 is patterned by photolithography, thereby forming the insulating layer 54 (resist pattern). At this time, the insulating layer 54 is formed such that the metal foil 51 corresponding to the first-direction wiring lines 21 and the second-direction wiring lines 22 is exposed.

Next, as illustrated in Fig. 33E, the metal foil 51 situated at positions on the surface of the substrate 11 not covered by the insulating layer 54 is removed. At this time, the metal foil 51 is etched such that the surface of the substrate 11 is exposed, by performing wet processing using such as ferric chloride, cupric chloride, strong acids such as sulfuric acid, hydrochloric acid, and the like, persulfate, hydrogen peroxide, or aqueous solutions thereof, or combinations of the above, or the like.

Next, as illustrated in Fig. 33F, the insulating layer 54 is removed. At this time, the insulating layer 54 on the metal foil 51 is removed by performing wet processing using a permanganate solution, N-methyl-2-pyrrolidone, acid or alkali solutions, or the like, or dry processing using oxygen plasma.

Thus, the wiring board 10 that has the substrate 11, and the mesh wiring layer 20 provided on the substrate 11, is obtained. In this case, the mesh wiring layer 20 includes the first-direction wiring lines 21 and the second-direction wiring lines 22.

Thereafter, as illustrated in Fig. 33G, the protective layer 17 is formed so as to cover the mesh wiring layer 20 on the substrate 11. Roll coating, gravure coating, reverse gravure coating, micro-gravure coating, slot-die coating, die coating, knife coating, ink-jet coating, dispenser coating, kiss coating, spray coating, screen printing, offset printing, or flexo printing may be used as the method for forming the protective layer 17.

[Effects of Present Embodiment]

Next, the effects of the present embodiment having such a configuration will be described.

As illustrated in Fig. 23 to Fig. 25, the wiring board 10 is assembled into the image display device 60 that has the display device 61. The wiring board 10 is disposed on the display device 61. The mesh wiring layer 20 of the wiring board 10 is electrically connected to the communication module 63 of the image display device 60 via the power supply unit 40. In this way, radio waves of the predetermined frequency can be transmitted/received via the mesh wiring layer 20, and communication can be performed by using the image display device 60.

Now, in the image display device 60 described above, the mesh wiring layer 20 of the wiring board 10 is laid out so as to coincide with the pixels P of the display device 61 in the Z direction. Accordingly, moire can occur due to the regularity (cyclicity) of the mesh wiring layer 20 and the regularity (cyclicity) of the pixels P.

Conversely, in the present embodiment, the pitch $P_b$ of the unit pattern 20A in the Y direction (first direction) is (N - 0.05) times (where N is a natural number) the pitch $P_Y$ of the pixels P in the Y direction (first direction) or less, or is (N + 0.05) times the pitch $P_Y$ of the pixels P in the Y direction (first direction) or more. Accordingly, when viewed from the Z direction, the unit pattern 20A and the pixels P are laid out irregularly in the Y direction. Thus, the pitch of moire that is generated due to the regularity (cyclicity) of the mesh wiring layer 20 and the regularity (cyclicity) of the pixels P can be reduced to a level that is visually unrecognizable to the bare eye.

Also, the pitch $P_a$ of the unit pattern 20A in the X direction (second direction) is (M - 0.05) times (where M is a natural number) the pitch $P_x$ of the pixels P in the X direction (second direction) or less, or is (M + 0.05) times the pitch $P_X$ of the pixels P in the X direction (second direction) or more. Accordingly, when viewed from the Z direction, the unit pattern 20A and the pixels P are laid out irregularly in the X direction. Thus, the pitch of moire that is generated due to the regularity of the mesh wiring layer 20 and the regularity of the pixels P can be reduced to a level that is visually unrecognizable to the bare eye.

[Modifications]

Next, modifications of the image display device and the wiring board according to the present embodiment will be described.

(First Modification)

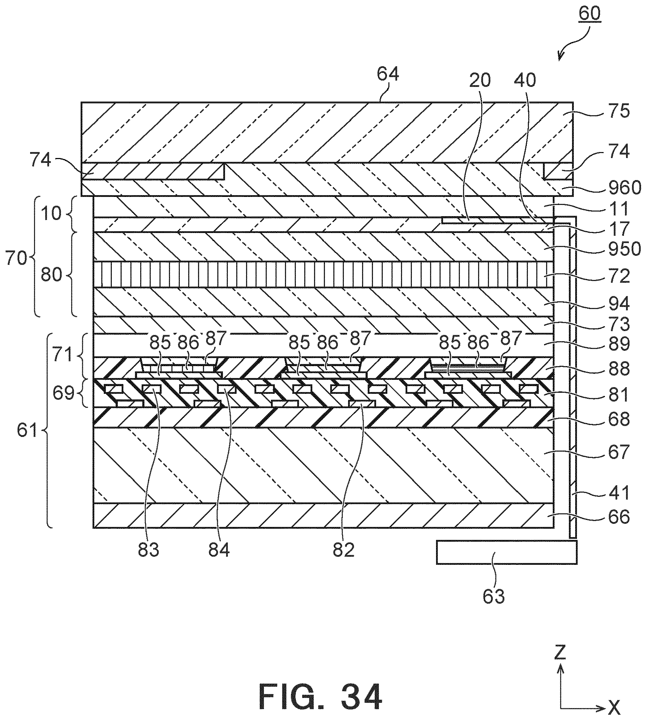

Fig. 34 illustrates a first modification of the image display device. The modification illustrated in Fig. 34 differs with respect to the point of the dielectric layer 80 being laminated on the mesh wiring layer 20 side of the wiring board 10, and other configurations are generally the same as the above-described embodiment illustrated in Fig. 23 to Fig. 33. In Fig. 34, portions that are the same as the form illustrated in Fig. 23 to Fig. 33 are denoted with the same signs, and detailed description will be omitted.

In the image display device 60 illustrated in Fig. 34, the substrate 11 of the wiring board 10 faces the cover glass 75 side (plus side in Z direction), and the mesh wiring layer 20 and the power supply unit 40 of the wiring board 10 face the dielectric layer 80 side. The dielectric layer 80 is a layer that substantially does not contain metal, and includes the first transparent adhesive layer 94, the polarizing plate 72, and the second transparent adhesive layer 950.

(Second Modification)

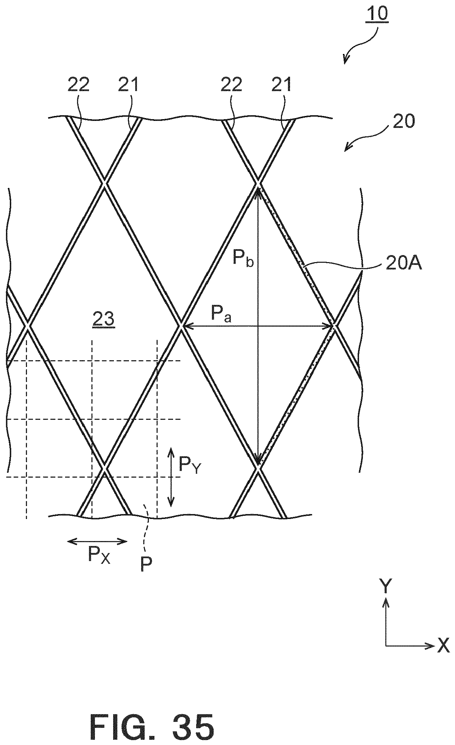

Fig. 35 illustrates a second modification of the wiring board. The modification example illustrated in Fig. 35 has a different planar form of the mesh wiring layer 20, and other configurations are generally the same as the above-described embodiment illustrated in Fig. 23 to Fig. 34. In Fig. 35, portions that are the same as the form illustrated in Fig. 23 to Fig. 34 are denoted with the same signs, and detailed description will be omitted.

In Fig. 35, the first-direction wiring lines 21 and the second-direction wiring lines 22 intersect obliquely (non-orthogonally), and each opening 23 is formed as a rhombus shape in plan view. The first-direction wiring lines 21 and the second-direction wiring lines 22 are each not parallel to either of the X direction or the Y direction, but one of the first-direction wiring lines 21 and the second-direction wiring lines 22 may be parallel to the X direction or the Y direction.

In the present modification as well, the pitch $P_b$ of the unit pattern 20A in the Y direction (first direction) is (N - 0.05) times (where N is a natural number) the pitch $P_Y$ of the pixels P in the Y direction (first direction) or less, or is (N + 0.05) times the pitch $P_Y$ of the pixels P in the Y direction (first direction) or more, whereby the pitch of the moire that is generated can be reduced to a level that is visually unrecognizable to the bare eye.

Also, the pitch $P_a$ of the unit pattern 20A in the X direction (second direction) is (M - 0.05) times (where M is a natural number) the pitch $P_X$ of the pixels P in the X direction (second direction) or less, or is (M + 0.05) times the pitch $P_X$ of the pixels P in the X direction (second direction) or more, whereby the pitch of the moire that is generated can be reduced to a level that is visually unrecognizable to the bare eye.

(Third Modification)

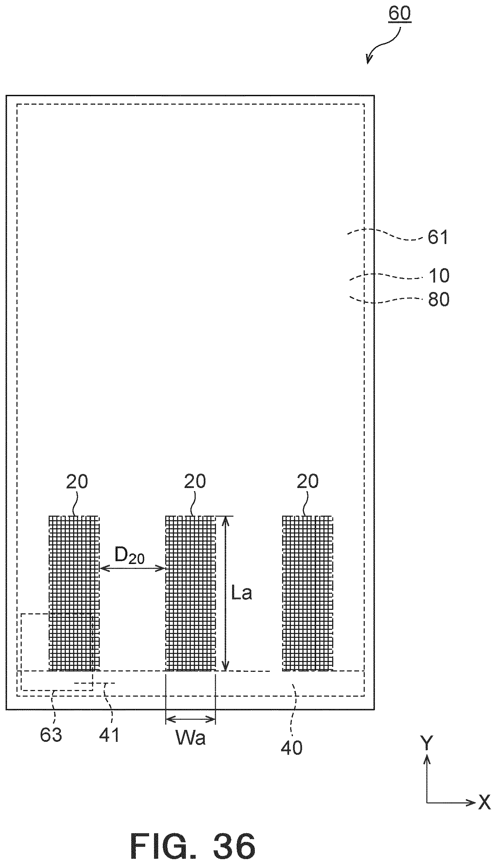

Fig. 36 illustrates a third modification of the wiring board. The modification example illustrated in Fig. 36 differs with respect to the point that the mesh wiring layer 20 is configured as an array antenna, and other configurations are generally the same as the above-described embodiment illustrated in Fig. 23 to Fig. 35. In Fig. 36, portions that are the same as the embodiment illustrated in Fig. 23 to Fig. 35 are denoted with the same signs, and detailed description will be omitted.

Fig. 36 is a plan view illustrating an image display device 60 according to a modification. In Fig. 36, the mesh wiring layer 20 is configured as an array antenna. Also, the wiring board 10 may have millimeter wave transmission/reception functions. In a case of configuring the mesh wiring layer 20 as an array antenna in this way, millimeter wave antenna performance of transmitting/receiving millimeter waves that have high straight-line propagation properties can be improved.

Two or more mesh wiring layers 20 are preferably formed on the substrate 11, and four or more thereof are preferably formed on the substrate 11. In the example that is illustrated, three mesh wiring layers 20 are formed on the substrate 11 (see Fig. 36).

The distance $D_{20}$ (see Fig. 36) between mesh wiring layers 20 preferably is 1 mm or more and 5 mm or less. Due to the distance $D_{20}$ between the mesh wiring layers 20 being 1 mm or more, unintentional interference of electromagnetic waves between the antenna elements can be suppressed. Due to the distance $D_{20}$ between the mesh wiring layers 20 being 5 mm or less, the size of the overall array antenna made up of the mesh wiring layers 20 can be reduced. For example, in a case in which the mesh wiring layers 20 are a millimeter wave antenna for 28 GHz, the distance $D_{20}$ between the mesh wiring layers 20 may be 3.5 mm. Also, in a case in which the mesh wiring layers 20 are a millimeter wave antenna for 60 GHz, the distance $D_{20}$ between the mesh wiring layers 20 may be 1.6 mm.

The plurality of components disclosed in the above embodiments and modifications can be appropriately combined as necessary. Alternatively, some of the components may be omitted from all components shown in the above embodiments and modifications.

**Claims**

1. A wiring board, comprising:

     a substrate that has transparency;
     a primer layer provided on the substrate; and
     a mesh wiring layer that is disposed on the primer layer and that includes a plurality of first-direction wiring lines and a plurality of second-direction wiring lines that interconnect the plurality of first-direction wiring lines, wherein
     the primer layer includes a polymer material, and
     at intersections of the first-direction wiring lines and the second-direction wiring lines, at least one corner portion of four corner portions formed between the first-direction wiring lines and the second-direction wiring lines is rounded in plan view.

2. The wiring board according to claim 1, wherein an angle formed between a center line of each of the first-direction wiring lines and a center line of each of the second-direction wiring lines that form the corner portion that is rounded in plan view is an acute angle in plan view.

3. The wiring board according to claim 1 or 2, wherein a thickness of the primer layer is 0.05 μm or more and 0.5 μm or less.

4. The wiring board according to any one of claims 1 to 3, wherein the primer layer includes an acrylic-based resin or a polyester-based resin.

5. The wiring board according to any one of claims 1 to 4, wherein the polymer material is crosslinked.

6. The wiring board according to any one of claims 1 to 5, further comprising:
a dummy wiring layer that is disposed around the mesh wiring layer and that includes a plurality of dummy wiring lines that are electrically independent from the first-direction wiring lines.

7. The wiring board according to any one of claims 1 to 6, wherein the wiring board has radio wave transmission/reception functions.

8. The wiring board according to any one of claims 1 to 7, wherein the wiring board has millimeter wave transmission/reception functions, and the mesh wiring layer is configured as an array antenna.

9. A method for manufacturing a wiring board, the method comprising:

a step of preparing a substrate that has transparency;
a step of forming a primer layer on the substrate; and
a step of forming, on the primer layer, a mesh wiring layer that includes a plurality of first-direction wiring lines and a plurality of second-direction wiring lines that interconnect the plurality of first-direction wiring lines, wherein the primer layer includes a polymer material, and
at least one corner portion of four corner portions formed between the first-direction wiring lines and the second-direction wiring lines is rounded in plan view.

10. The method of manufacturing the wiring board according to claim 9, wherein a dummy wiring layer that is disposed around the mesh wiring layer and that includes a plurality of dummy wiring lines that are electrically independent from the first-direction wiring lines, is formed on the primer layer in the step of forming the mesh wiring layer.

11. An image display device laminate, comprising:

a wiring board that includes a substrate that has transparency and a mesh wiring layer that is disposed on the substrate;
a first transparent adhesive layer that has an area that is broader than the substrate; and
a second transparent adhesive layer that has an area that is broader than the substrate, wherein
a partial region of the substrate is disposed in a partial region between the first transparent adhesive layer and the second transparent adhesive layer,
a difference in refractive index between the substrate and the first transparent adhesive layer is 0.1 or less,
a difference in refractive index between the second transparent adhesive layer and the substrate is 0.1 or less, and
a difference in refractive index between the first transparent adhesive layer and the second transparent adhesive layer is 0.1 or less.

12. The image display device laminate according to claim 11, wherein, at least one of a thickness of the first transparent adhesive layer and a thickness of the second transparent adhesive layer is 2 times a thickness of the substrate or more.

13. The image display device laminate according to claim 11 or 12, wherein a thickness of the first transparent adhesive layer and a thickness of the second transparent adhesive layer are same as each other, and the thickness of the first transparent adhesive layer and the thickness of the second transparent adhesive layer are 1.5 times the thickness of the substrate or more.

14. The image display device laminate according to any one of claims 11 to 13, wherein a material of the first transparent adhesive layer and a material of the second transparent adhesive layer are same as each other.

15. The image display device laminate according to any one of claims 11 to 14, wherein a material of the first transparent adhesive layer and a material of the second transparent adhesive layer are each an acrylic-based resin.

16. The image display device laminate according to any one of claims 11 to 15, wherein a thickness of the substrate is 50 μm or less.

17. The image display device laminate according to any one of claims 11 to 16, wherein a dummy wiring layer that is electrically independent from the mesh wiring layer is provided around the mesh wiring layer.

18. The image display device laminate according to any one of claims 11 to 17, wherein a plurality of dummy wiring layers that are electrically independent from the mesh wiring layer are provided around the mesh wiring layer, and the plurality of dummy wiring layers have different aperture ratios from each other.

19. An image display device laminate, comprising:

a wiring board that includes a substrate that has transparency, a mesh wiring layer that is disposed on the substrate, and a protective layer that covers the mesh wiring layer;
a first dielectric layer; and
a second dielectric layer, wherein
a partial region of the wiring board is disposed in a partial region between the first dielectric layer and the second dielectric layer, and
with a transmittance of visible light rays of the image display device laminate in a region in which the wiring board, the first dielectric layer, and the second dielectric layer are present as a first transmittance, and with a transmittance of visible light rays of the image display device laminate in a region in which the first dielectric layer and the second dielectric layer are present and the wiring board is not present as a second transmittance, the first transmittance is 83% or more and 90% or less, and
a difference between the first transmittance and the second transmittance is 1.5% or less.

20. An image display device laminate, comprising:

a wiring board that includes a substrate that has transparency, a mesh wiring layer that is disposed on the substrate, and a protective layer that covers the mesh wiring layer;
a first dielectric layer; and
a second dielectric layer, wherein
a partial region of the wiring board is disposed in a partial region between the first dielectric layer and the second dielectric layer, and
with a haze value of the image display device laminate in a region in which the wiring board, the first dielectric layer, and the second dielectric layer are present as a first haze value, and with a haze value of the image display device laminate in a region in which the first dielectric layer and the second dielectric layer are present and the wiring board is not present as a second haze value,
the first haze value is 0.5% or more and 2% or less, and
a difference between the first haze value and the second haze value is 0.5% or less.

21. An image display device laminate, comprising:

a wiring board that includes a substrate that has transparency, a mesh wiring layer that is disposed on the substrate, and a protective layer that covers the mesh wiring layer;
a first dielectric layer; and
a second dielectric layer, wherein
a partial region of the wiring board is disposed in a partial region between the first dielectric layer and the second dielectric layer, and
with a diffuse light reflectance of the image display device laminate measured in conformance with JIS Z 8722 in a region in which the wiring board, the first dielectric layer, and the second dielectric layer are present as a first diffuse light reflectance, and with a diffuse light reflectance of the image display device laminate measured in conformance with JIS Z 8722 in a region in which the first dielectric layer and the second dielectric layer are present and the wiring board is not present as a second diffuse light reflectance,
the first diffuse light reflectance is 0.05% or more and 1% or less, and
a difference between the first diffuse light reflectance and the second diffuse light reflectance is 1.5% or less.

**22.** The image display device laminate according to any one of claims 19 to 21, wherein a dielectric loss tangent of the substrate is 0.002 or less.

**23.** The image display device laminate according to any one of claims 19 to 22, wherein, following performing work of bending the image display device laminate 180° following a perimeter of a cylinder that is 1 mm in diameter and then straightening out, for 100 times, an amount of increase in resistance value of the mesh wiring layer is 20% or less.

**24.** The image display device laminate according to any one of claims 19 to 23, wherein the mesh wiring layer functions as a millimeter wave antenna.

**25.** The image display device laminate according to any one of claims 11 to 24, wherein the mesh wiring layer is configured as an array antenna.

**26.** An image display device, comprising:

the image display device laminate according to any one of claims 11 to 25; and
a display device that is laminated on the image display device laminate.

**27.** The image display device according to claim 26, wherein

the mesh wiring layer includes a plurality of wiring lines, and the mesh wiring layer is made up of a predetermined unit pattern that is repetitively arrayed in a first direction and in a second direction that is different from the first direction,
the display device has a plurality of pixels that are repetitively arrayed in the first direction and in the second direction,
a pitch of the unit pattern in the first direction is (N - 0.05) times (where N is a natural number) a pitch of the pixels in the first direction or less, or is (N + 0.05) times the pitch of the pixels in the first direction or more, and
a pitch of the unit pattern in the second direction is (M - 0.05) times (where M is a natural number) a pitch of the pixels in the second direction or less, or is (M + 0.05) times the pitch of the pixels in the second direction or more.

**28.** An image display device, comprising:

a wiring board that includes a substrate that has transparency and a mesh wiring layer that is disposed on the substrate and includes a plurality of wiring lines; and
a display device that is laminated on the wiring board, wherein
the mesh wiring layer is made up of a predetermined unit pattern that is repetitively arrayed in a first direction and in a second direction that is different from the first direction,
the display device has a plurality of pixels that are repetitively arrayed in the first direction and in the second direction,
a pitch of the unit pattern in the first direction is (N - 0.05) times (where N is a natural number) a pitch of the pixels in the first direction or less, or is (N + 0.05) times the pitch of the pixels in the first direction or more, and
a pitch of the unit pattern in the second direction is (M - 0.05) times (where M is a natural number) a pitch of the pixels in the second direction or less, or is (M + 0.05) times the pitch of the pixels in the second direction or more.

**29.** The image display device according to claim 27 or 28, wherein the pitch of the unit pattern in the first direction is (N - 0.2) times the pitch of the pixels in the first direction or more, or is (N + 0.2) times the pitch of the pixels in the first direction or less.

**30.** The image display device according to any one of claims 27 to 29, wherein the pitch of the unit pattern in the second direction is (M - 0.2) times the pitch of the pixels in the second direction or more, or is (M + 0.2) times the pitch of the pixels in the second direction or less.

**31.** The image display device according to any one of claims 27 to 30, wherein N and M are each a natural number of 1 or more and 6 or less.

**32.** The image display device according to any one of claims 27 to 31, wherein a line width of the wiring lines is 5 $\mu$m or less.

**33.** The image display device according to claim 32, wherein the line width of the wiring lines is 2 $\mu$m or less.

**34.** The image display device according to any one of claims 27 to 33, wherein an aperture ratio of the mesh wiring layer is 95% or more.

**35.** The image display device according to any one of claims 27 to 34, wherein a sheet resistance value of the mesh wiring layer is 4 ohms per square or less, and a longest width of each of the wiring lines as viewed from a 120° viewing angle is 3 $\mu$m or less.

**36.** The image display device according to any one of claims 27 to 35, wherein the unit pattern includes a first-direction wiring line and a second-direction wiring line that extend in different directions from each other, and an angle formed by the first-direction wiring line and the second-direction wiring line is 30° or more and 150° or less.

**37.** The image display device according to any one of claims 28 to 36, wherein the wiring board has millimeter wave transmission/reception functions, and the mesh wiring layer is configured as an array antenna.

**38.** A method for manufacturing a wiring board, the method comprising:

a step of deciding a pitch of pixels of a display device that is laminated on the wiring board;
a step of preparing a substrate that has transparency; and
a step of forming a mesh wiring layer on the substrate, on a basis of the pitch of the pixels, wherein
the mesh wiring layer is made up of a predetermined unit pattern that is repetitively arrayed in a first direction and in a second direction that is different from the first direction,
a pitch of the unit pattern in the first direction is (N - 0.05) times (where N is a natural number) a pitch of the pixels in the first direction or less, or is (N + 0.05) times the pitch of the pixels in the first direction or more, and
a pitch of the unit pattern in the second direction is (M - 0.05) times (where M is a natural number) a pitch of the pixels in the second direction or less, or is (M + 0.05) times the pitch of the pixels in the second direction or more.

FIG. 1

FIG. 2

FIG. 3

FIG. 4

FIG. 5A

FIG. 5B

FIG. 6A

FIG. 6B

FIG. 6C

FIG. 6D

FIG. 6E

FIG. 6F

Z

**FIG. 7**

FIG. 8

**FIG. 9**

FIG. 10

FIG. 11

FIG. 12

$W_1$

$H_1$

21

21 20

10

$T_1$

11

20

Z

X

# FIG. 13

$W_2$

$H_2$

22

22 20

10

11

20

Z

Y

# FIG. 14

FIG. 15A

FIG. 15B

FIG. 15C

FIG. 15D

FIG. 15E

FIG. 15F

FIG. 16

FIG. 17

FIG. 18

FIG. 19

FIG. 20

FIG. 21

FIG. 22

60

20

61
20
10
80

20

20

XXIV
XXIV

63   41

40

Y
X

# FIG. 23

FIG. 24

FIG. 25

FIG. 26

# FIG. 27

FIG. 28

FIG. 29

FIG. 30

FIG. 31

FIG. 32

FIG. 33A

FIG. 33B

FIG. 33C

FIG. 33D

FIG. 33E

FIG. 33F

FIG. 33G

FIG. 34

FIG. 35

# FIG. 36

## INTERNATIONAL SEARCH REPORT

International application No.

**PCT/JP2022/011956**

### A. CLASSIFICATION OF SUBJECT MATTER

*G09F 9/00*(2006.01)i; *G09F 9/30*(2006.01)i; *H01Q 1/22*(2006.01)i; *H01Q 1/38*(2006.01)i; *H05K 1/02*(2006.01)i; *H05K 3/38*(2006.01)i

FI: H05K3/38 E; H01Q1/38; H01Q1/22 Z; H05K1/02 J; G09F9/00 313; G09F9/30 330

According to International Patent Classification (IPC) or to both national classification and IPC

### B. FIELDS SEARCHED

Minimum documentation searched (classification system followed by classification symbols)

G09F9/00; G09F9/30; H01Q1/22; H01Q1/38; H05K1/02; H05K3/38

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | WO 2019/107476 A1 (DAI NIPPON PRINTING CO., LTD.) 06 June 2019 (2019-06-06) paragraphs [0061], [0108], [0162], fig. 7 | 1-10 |
| A | | 11-27 |
| Y | WO 2020/066817 A1 (DAI NIPPON PRINTING CO., LTD.) 02 April 2020 (2020-04-02) claim 1, paragraphs [0038], [0041], [0050] | 1-10, 34-35 |
| X | WO 2006/106982 A1 (NISSHA PRINTING CO., LTD.) 12 October 2006 (2006-10-12) paragraphs [0051]-[0056], [0094] | 28-33, 36-38 |
| Y | | 34-35 |
| A | JP 2011-066610 A (DAI NIPPON PRINTING CO., LTD.) 31 March 2011 (2011-03-31) paragraph [0038] | 1-38 |

☐ Further documents are listed in the continuation of Box C.  ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **03 June 2022** | **14 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| International application No. |
| --- |
| **PCT/JP2022/011956** |

---

**Box No. III    Observations where unity of invention is lacking (Continuation of item 3 of first sheet)**

This International Searching Authority found multiple inventions in this international application, as follows:

Document 1: WO 2019/107476 A1 (DAI NIPPON PRINTING CO., LTD.) 06 June 2019 (2019-06-06)
paragraphs [0061], [0108], [0162], fig. 7
& EP 3720256 A1, paragraphs [0061], [0108], [0162], fig. 7
& US 2020/0373653 A1
& CN 111373847 A
& KR 10-2020-0093583 A
& TW 201926368 A

The claims are classified into the three inventions below.

(Invention 1) Claims 1-10
     Claims 1-10 have the special technical feature of "a circuit board provided with: a substrate having transparency; a primer layer; and a mesh wiring layer"; thus these claims are classified as invention 1.

(Invention 2) Claims 11-27
     The invention of claims 11-27 has the common technical feature between this invention and claim 1 classified as invention 1 of "a circuit board provided with: a substrate having transparency; and a mesh wiring layer". However, this technical feature, which does not make a contribution over the prior art in light of the disclosure of document 1 (in particular, refer to paragraphs [0062] and [0137]), cannot be considered a special technical feature. Apart from this feature, there are not the same or corresponding special technical features between claims 11-27 and claim 1.
     Furthermore, claims 11-27 do not depend from claim 1. In addition, claims 11-27 are not substantially identical to or similarly closely related to any of the claims classified as invention 1.
     Accordingly claims 11-27 cannot be identified as invention 1.
     Meanwhile, claims 11-27 have the special technical feature wherein "the difference in index of refraction between the first and second transparent adhesive layers is 0.1 or less"; thus these claims are classified as invention 2.

(Invention 3) Claims 28-38
     Claims 28-38 have the common technical feature between these claims, and claim 1 classified as invention 1 and claim 11 classified as invention 2 of "a circuit board provided with: a substrate having transparency; and a mesh wiring layer". However, this technical feature, which does not make a contribution over the prior art in light of the disclosure of document 1 (in particular, refer to paragraphs [0062] and [0137]), cannot be considered a special technical feature. Apart from this feature, there are not the same or corresponding special technical features between claims 28-38 and claim 1 or 11.
     Furthermore, claims 28-38 do not depend from claim 1 or 11. In addition, claims 28-38 are not substantially identical to or similarly closely related to any of the claims classified as invention 1 or 2.
     Accordingly claims 28-38 cannot be identified as either of inventions 1 and 2.
     Meanwhile, claims 28-38 have the special technical feature wherein "the pitch of the unit pattern in the first direction is less than or equal to $(N - 0.05)$ times (N is a natural number) the pitch of the pixel in the first direction, or greater than or equal to $(N + 0.05)$ times the pitch of the pixel in the first direction, and the pitch of the unit pattern in the second direction is less than or equal to $(M - 0.05)$ times (M is a natural number) the pitch of the pixel in the second direction, or greater than or equal to $(M + 0.05)$ times the pitch of the pixel in the second direction"; thus these claims are classified as invention 3.

---

Form PCT/ISA/210 (continuation of first sheet) (January 2015)

# EP 4 310 819 A1

<table>
<tr><td><strong>INTERNATIONAL SEARCH REPORT</strong></td><td>International application No.<br><strong>PCT/JP2022/011956</strong></td></tr>
</table>

**Box No. III    Observations where unity of invention is lacking (Continuation of item 3 of first sheet)**

1. ☑ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**    ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☑ No protest accompanied the payment of additional search fees.

Form PCT/ISA/210 (continuation of first sheet) (January 2015)

INTERNATIONAL SEARCH REPORT
Information on patent family members

International application No.

**PCT/JP2022/011956**

| Patent document cited in search report | | | Publication date (day/month/year) | Patent family member(s) | | | Publication date (day/month/year) |
|---|---|---|---|---|---|---|---|
| WO | 2019/107476 | A1 | 06 June 2019 | EP | 3720256 | A1 | |
| | | | | paragraphs [0061], [0108], [0162], fig. 7 | | | |
| | | | | US | 2020/0373653 | A1 | |
| | | | | CN | 111373847 | A | |
| | | | | KR | 10-2020-0093583 | A | |
| | | | | TW | 201926368 | A | |
| WO | 2020/066817 | A1 | 02 April 2020 | EP | 3859887 | A1 | |
| | | | | claim 1, paragraphs [0038], [0041], [0049] | | | |
| | | | | CN | 112771722 | A | |
| | | | | KR | 10-2021-0065986 | A | |
| | | | | TW | 202023112 | A | |
| WO | 2006/106982 | A1 | 12 October 2006 | EP | 1868263 | A1 | |
| | | | | paragraphs [0049]-[0054], [0092] | | | |
| | | | | US | 2009/0051620 | A1 | |
| | | | | CN | 101180765 | A | |
| | | | | KR | 10-2008-0002909 | A | |
| JP | 2011-066610 | A | 31 March 2011 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011066610 A
- JP 5636735 B
- JP 5695947 B